# EUROPEAN PATENT SPECIFICATION

(11) **EP 3 159 350 B1**
(45) Date of publication and mention of the grant of the patent: **16.12.2020**
(21) Application number: 16186500.1
(22) Date of filing: 31.08.2016
(51) Int. Cl.: C07F 15/00, C09K 11/06, H01L 51/00

(54) **ORGANIC ELECTROLUMINESCENT MATERIALS AND DEVICES**
ORGANISCHE ELEKTROLUMINESZENTE MATERIALIEN UND VORRICHTUNGEN
MATÉRIAUX ET DISPOSITIFS ÉLECTROLUMINESCENTS ORGANIQUES

(30) Priority: 03.09.2015 US 201562213757 P; 24.09.2015 US 201562232194 P; 05.02.2016 US 201662291960 P; 14.04.2016 US 201662322510 P; 02.05.2016 US 201662330412 P; 18.08.2016 US 201615239961
(43) Date of publication of application: 26.04.2017
(60) Divisional application: 20192873.6
(73) Proprietor: Universal Display Corporation, Ewing, NJ 08618 (US)
(72) Inventor: MA, Bin, Ewing, NJ 08618 (US); ADAMOVICH, Vadim, Ewing, NJ 08618 (US); BARRON, Edward, Ewing, NJ 08618 (US); TSAI, Jui-Yi, Ewing, NJ 08618 (US); SU, Mingjuan, Ewing, NJ 08618 (US); MICHALSKI, Lech, Ewing, NJ 08618 (US); XIA, Chuanjun, Ewing, NJ 08618 (US); WEAVER, Michael S., Ewing, NJ 08618 (US); YEAGER, Walter, Ewing, NJ 08618 (US); ALLEYNE, Bert, Ewing, NJ 08618 (US)
(74) Representative: Maiwald Patent- und Rechtsanwaltsgesellschaft mbH

(56) References cited:
- EP-A1- 2 100 896
- EP-A1- 2 803 671
- EP-A1- 2 883 880
- EP-A2- 2 599 851
- WO-A1-2010/027583
- WO-A1-2015/039723
- WO-A1-2015/084114
- US-A1- 2012 116 110
- US-A1- 2012 299 468
- FRANCESCO NASTASI ET AL: "A luminescent multicomponent species made of fullerene and Ir(iii) cyclometallated subunits", CHEMICAL COMMUNICATIONS, no. 34, 1 January 2007 (2007-01-01), page 3556, XP55001542, ISSN: 1359-7345, DOI: 10.1039/b705296k

## Description

### FIELD

The present invention relates to compounds for use as emitters, and devices, such as organic light emitting diodes, including the same.

### BACKGROUND

Opto-electronic devices that make use of organic materials are becoming increasingly desirable for a number of reasons. Many of the materials used to make such devices are relatively inexpensive, so organic opto-electronic devices have the potential for cost advantages over inorganic devices. In addition, the inherent properties of organic materials, such as their flexibility, may make them well suited for particular applications such as fabrication on a flexible substrate. Examples of organic opto-electronic devices include organic light emitting diodes/devices (OLEDs), organic phototransistors, organic photovoltaic cells, and organic photodetectors. For OLEDs, the organic materials may have performance advantages over conventional materials. For example, the wavelength at which an organic emissive layer emits light may generally be readily tuned with appropriate dopants.

OLEDs make use of thin organic films that emit light when voltage is applied across the device. OLEDs are becoming an increasingly interesting technology for use in applications such as flat panel displays, illumination, and backlighting. Several OLED materials and configurations are described in U.S. Pat. Nos. 5,844,363, 6,303,238, and 5,707,745. US20120299468 discloses an iridium compound with shorter side chains attached to the phenyl ring of the (phenyl)pyridinylphenyl ligand.

One application for phosphorescent emissive molecules is a full color display. Industry standards for such a display call for pixels adapted to emit particular colors, referred to as "saturated" colors. In particular, these standards call for saturated red, green, and blue pixels. Alternatively the OLED can be designed to emit white light. In conventional liquid crystal displays emission from a white backlight is filtered using absorption filters to produce red, green and blue emission. The same technique can also be used with OLEDs. The white OLED can be either a single EML device or a stack structure. Color may be measured using CIE coordinates, which are well known to the art.

One example of a green emissive molecule is tris(2-phenylpyridine) iridium, denoted Ir(ppy)₃, which has the following structure:

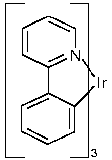

In this, and later figures herein, we depict the dative bond from nitrogen to metal (here, Ir) as a straight line.

As used herein, the term "organic" includes polymeric materials as well as small molecule organic materials that may be used to fabricate organic opto-electronic devices. "Small molecule" refers to any organic material that is not a polymer, and "small molecules" may actually be quite large. Small molecules may include repeat units in some circumstances. For example, using a long chain alkyl group as a substituent does not remove a molecule from the "small molecule" class. Small molecules may also be incorporated into polymers, for example as a pendent group on a polymer backbone or as a part of the backbone. Small molecules may also serve as the core moiety of a dendrimer, which consists of a series of chemical shells built on the core moiety. The core moiety of a dendrimer may be a fluorescent or phosphorescent small molecule emitter. A dendrimer may be a "small molecule," and it is believed that all dendrimers currently used in the field of OLEDs are small molecules.

Where a first layer is described as "disposed over" a second layer, the first layer is disposed further away from the substrate. There may be other layers between the first and second layer, unless it is specified that the first layer is "in contact with" the second layer. For example, a cathode may be described as "disposed over" an anode, even though there are various organic layers in between.

As used herein, "solution processible" means capable of being dissolved, dispersed, or transported in and/or deposited from a liquid medium, either in solution or suspension form.

A ligand may be referred to as "photoactive" when it is believed that the ligand directly contributes to the photoactive properties of an emissive material. A ligand may be referred to as "ancillary" when it is believed that the ligand does not contribute to the photoactive properties of an emissive material, although an ancillary ligand may alter the properties of a photoactive ligand.

As used herein, and as would be generally understood by one skilled in the art, a first "Highest Occupied Molecular Orbital" (HOMO) or "Lowest Unoccupied Molecular Orbital" (LUMO) energy level is "greater than" or "higher than" a second HOMO or LUMO energy level if the first energy level is closer to the vacuum energy level. Since ionization potentials (IP) are measured as a negative energy relative to a vacuum level, a higher HOMO energy level corresponds to an IP having a smaller absolute value (an IP that is less negative). Similarly, a higher LUMO energy level corresponds to an electron affinity (EA) having a smaller absolute value (an EA that is less negative). On a conventional energy level diagram, with the vacuum level at the top, the LUMO energy level of a material is higher than the HOMO energy level of the same material. A "higher" HOMO or LUMO energy level appears closer to the top of such a diagram than a "lower" HOMO or LUMO energy level.

As used herein, and as would be generally understood by one skilled in the art, a first work function is "greater than" or "higher than" a second work function if the first work function has a higher absolute value. Because work functions are generally measured as negative numbers relative to vacuum level, this means that a "higher" work function is more negative. On a conventional energy level diagram, with the vacuum level at the top, a "higher" work function is illustrated as further away from the vacuum level in the downward direction. Thus, the definitions of HOMO and LUMO energy levels follow a different convention than work functions.

More details on OLEDs, and the definitions described above, can be found in US Pat. No. 7,279,704.

WO 2015/039723 A1 describes metalc complexes for use in OLEDs having the formula M(L)ₙ(L')ₘ wherein the compound contains a substructure of Formel (2) or (3), where A is the same or different at each instance and is a group of Formel (A):

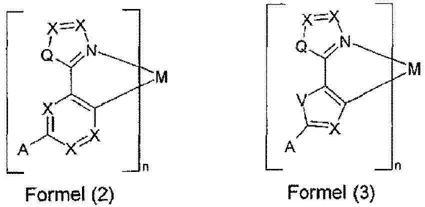

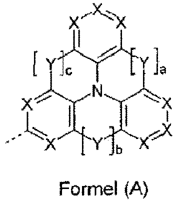

EP 2 803 671 A1 describes an iridium complex and an OLED comprising said complex. One ligand of said complex must contain a (hetero)arylalkyl substituent.

### SUMMARY

According to an embodiment, the present invention pertains to a compound having a formula (L_{A})ₘIr(L_{B})₃₋ₘ having a structure selected from the group consisting of: 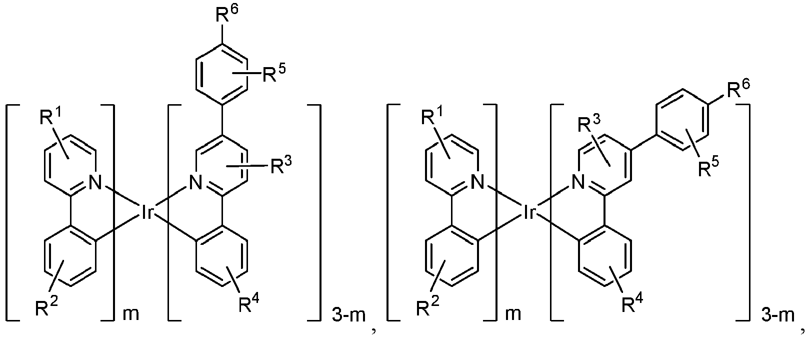 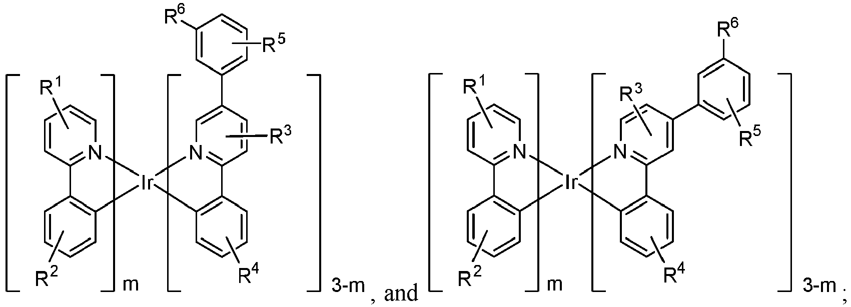
wherein m is 1 or 2;
wherein R¹, R², R⁴, and R⁵ each independently represent mono, di, tri, or tetra substitution, or no substitution;
wherein R³ represents mono, di, or tri substitution, or no substitution;
wherein R¹, R², R³, R⁴, and R⁵ are each independently selected from the group consisting of hydrogen, deuterium, C1 to C6 alkyl, C1 to C6 cycloalkyl, and partially or fully deuterated or fluorinated variants thereof; and
wherein R⁶ is selected from the group consisting of alkyl having at least seven carbon atoms, cycloalkyl having at least seven carbon atoms, alkyl-cycloalkyl having at least seven carbon atoms, and partially or fully deuterated or fluorinated variants thereof.

According to another embodiment, the present invention pertains to an organic light emitting diode/device (OLED). The OLED includes an anode, a cathode, and an organic layer, disposed between the anode and the cathode. The organic layer comprises a compound having a formula as defined in the preceding paragraph.

### BRIEF DESCRIPTION OF THE DRAWINGS

FIG. 1 shows an organic light emitting device.
FIG. 2 shows an inverted organic light emitting device that does not have a separate electron transport layer.
FIG. 3 shows spectra measured through a polarizer at angles from 0 to 60° for the emitter from device Example 2 with the device structure defined in Table 1.
FIG. 4 shows corresponding spectra generated by SETFOS-4.1.
FIG. 5 illustrates experimental angular dependence of integrated radiance normalized to 0° numbers. The integrated p/s radiance ratio at 40° angle is 1.67.
FIG. 6 illustrates dipole orientation calibration vs. p/s emission ratio simulated by SETFOS-4.1 program. For this specific example, the integrated p/s radiance ratio at 40° angle is 1.67 corresponding to dipole orientation (DO) of 0.15.
FIG. 7 illustrates radiance-p profiles vs. observation angle for different DOs.
FIG. 8 illustrates radiance-s profiles vs. observation angle for different DOs.
FIG. 9 shows a correlation of Maximum estimated EQE in the device with an emitter orientation factor.
FIG. 10 shows a correlation of PLQY with emitter concentration for some emitters. The steric bulk of emitters prevents self-quenching at high doping %.

### DETAILED DESCRIPTION

Generally, an OLED comprises at least one organic layer disposed between and electrically connected to an anode and a cathode. When a current is applied, the anode injects holes and the cathode injects electrons into the organic layer(s). The injected holes and electrons each migrate toward the oppositely charged electrode. When an electron and hole localize on the same molecule, an "exciton," which is a localized electron-hole pair having an excited energy state, is formed. Light is emitted when the exciton relaxes via a photoemissive mechanism. In some cases, the exciton may be localized on an excimer or an exciplex. Non-radiative mechanisms, such as thermal relaxation, may also occur, but are generally considered undesirable.

The initial OLEDs used emissive molecules that emitted light from their singlet states ("fluorescence") as disclosed, for example, in U.S. Pat. No. 4,769,292. Fluorescent emission generally occurs in a time frame of less than 10 nanoseconds.

More recently, OLEDs having emissive materials that emit light from triplet states ("phosphorescence") have been demonstrated. See Baldo et al., "Highly Efficient Phosphorescent Emission from Organic Electroluminescent Devices," Nature, vol. 395, 151-154, 1998; ("Baldo-I") and Baldo et al., "Very high-efficiency green organic light-emitting devices based on electrophosphorescence," Appl. Phys. Lett., vol. 75, No. 3, 4-6 (1999) ("Baldo-II"). Phosphorescence is described in more detail in US Pat. No. 7,279,704 at cols. 5-6, which are incorporated by reference.

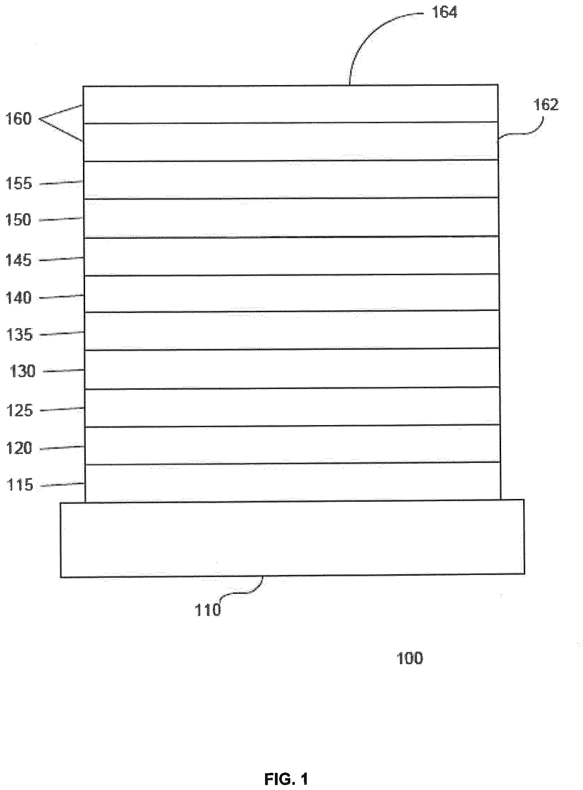

FIG. 1 shows an organic light emitting device 100. The figures are not necessarily drawn to scale. Device 100 may include a substrate 110, an anode 115, a hole injection layer 120, a hole transport layer 125, an electron blocking layer 130, an emissive layer 135, a hole blocking layer 140, an electron transport layer 145, an electron injection layer 150, a protective layer 155, a cathode 160, and a barrier layer 170. Cathode 160 is a compound cathode having a first conductive layer 162 and a second conductive layer 164. Device 100 may be fabricated by depositing the layers described, in order. The properties and functions of these various layers, as well as example materials, are described in more detail in US 7,279,704 at cols. 6-10, which are incorporated by reference.

More examples for each of these layers are available. For example, a flexible and transparent substrate-anode combination is disclosed in U.S. Pat. No. 5,844,363. An example of a p-doped hole transport layer is m-MTDATA doped with F₄-TCNQ at a molar ratio of 50:1, as disclosed in U.S. Patent Application Publication No. 2003/0230980. Examples of emissive and host materials are disclosed in U.S. Pat. No. 6,303,238 to Thompson et al.. An example of an n-doped electron transport layer is BPhen doped with Li at a molar ratio of 1:1, as disclosed in U.S. Patent Application Publication No. 2003/0230980. U.S. Pat. Nos. 5,703,436 and 5,707,745 disclose examples of cathodes including compound cathodes having a thin layer of metal such as Mg:Ag with an overlying transparent, electrically-conductive, sputter-deposited ITO layer. The theory and use of blocking layers is described in more detail in U.S. Pat. No. 6,097,147 and U.S. Patent Application Publication No. 2003/0230980. Examples of injection layers are provided in U.S. Patent Application Publication No. 2004/0174116. A description of protective layers may be found in U.S. Patent Application Publication No. 2004/0174116.

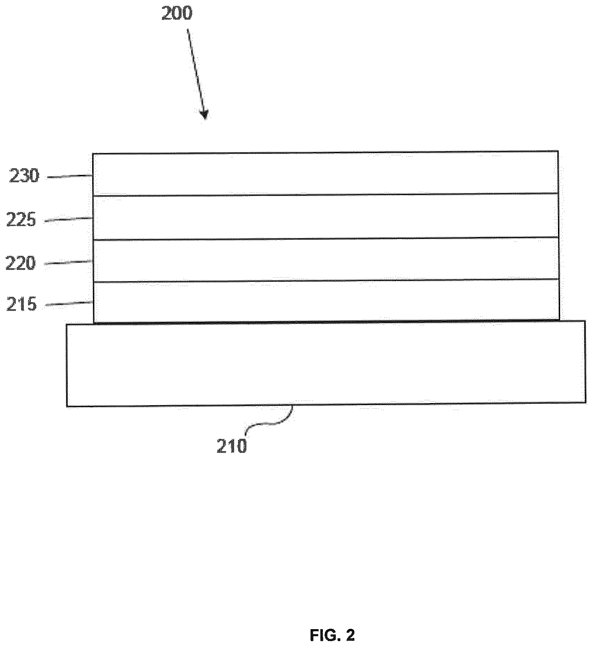

FIG. 2 shows an inverted OLED 200. The device includes a substrate 210, a cathode 215, an emissive layer 220, a hole transport layer 225, and an anode 230. Device 200 may be fabricated by depositing the layers described, in order. Because the most common OLED configuration has a cathode disposed over the anode, and device 200 has cathode 215 disposed under anode 230, device 200 may be referred to as an "inverted" OLED. Materials similar to those described with respect to device 100 may be used in the corresponding layers of device 200. FIG. 2 provides one example of how some layers may be omitted from the structure of device 100.

The simple layered structure illustrated in FIGS. 1 and 2 is provided by way of example, and it is understood that embodiments of the invention may be used in connection with a wide variety of other structures. The specific materials and structures described are exemplary in nature, and other materials and structures may be used. Functional OLEDs may be achieved by combining the various layers described in different ways, or layers may be omitted entirely, based on design, performance, and cost factors. Other layers not specifically described may also be included. Materials other than those specifically described may be used. Although many of the examples provided herein describe various layers as comprising a single material, it is understood that combinations of materials, such as a mixture of host and dopant, or more generally a mixture, may be used. Also, the layers may have various sublayers. The names given to the various layers herein are not intended to be strictly limiting. For example, in device 200, hole transport layer 225 transports holes and injects holes into emissive layer 220, and may be described as a hole transport layer or a hole injection layer. In one embodiment, an OLED may be described as having an "organic layer" disposed between a cathode and an anode. This organic layer may comprise a single layer, or may further comprise multiple layers of different organic materials as described, for example, with respect to FIGS. 1 and 2.

Structures and materials not specifically described may also be used, such as OLEDs comprised of polymeric materials (PLEDs) such as disclosed in U.S. Pat. No. 5,247,190 to Friend et al.. By way of further example, OLEDs having a single organic layer may be used. OLEDs may be stacked, for example as described in U.S. Pat. No. 5,707,745 to Forrest et al.. The OLED structure may deviate from the simple layered structure illustrated in FIGs. 1 and 2. For example, the substrate may include an angled reflective surface to improve out-coupling, such as a mesa structure as described in U.S. Pat. No. 6,091,195 to Forrest et al., and/or a pit structure as described in U.S. Pat. No. 5,834,893 to Bulovic et al..

Unless otherwise specified, any of the layers of the various embodiments may be deposited by any suitable method. For the organic layers, preferred methods include thermal evaporation, ink-jet, such as described in U.S. Pat. Nos. 6,013,982 and 6,087,196, organic vapor phase deposition (OVPD), such as described in U.S. Pat. No. 6,337,102 to Forrest et al., and deposition by organic vapor jet printing (OVJP), such as described in U.S. Pat. No. 7,431,968. Other suitable deposition methods include spin coating and other solution based processes. Solution based processes are preferably carried out in nitrogen or an inert atmosphere. For the other layers, preferred methods include thermal evaporation. Preferred patterning methods include deposition through a mask, cold welding such as described in U.S. Pat. Nos. 6,294,398 and 6,468,819, and patterning associated with some of the deposition methods such as ink-jet and OVJP. Other methods may also be used. The materials to be deposited may be modified to make them compatible with a particular deposition method. For example, substituents such as alkyl and aryl groups, branched or unbranched, and preferably containing at least 3 carbons, may be used in small molecules to enhance their ability to undergo solution processing. Substituents having 20 carbons or more may be used, and 3-20 carbons is a preferred range. Materials with asymmetric structures may have better solution processability than those having symmetric structures, because asymmetric materials may have a lower tendency to recrystallize. Dendrimer substituents may be used to enhance the ability of small molecules to undergo solution processing.

Devices fabricated in accordance with embodiments of the present invention may further optionally comprise a barrier layer. One purpose of the barrier layer is to protect the electrodes and organic layers from damaging exposure to harmful species in the environment including moisture, vapor and/or gases, etc. The barrier layer may be deposited over, under or next to a substrate, an electrode, or over any other parts of a device including an edge. The barrier layer may comprise a single layer, or multiple layers. The barrier layer may be formed by various known chemical vapor deposition techniques and may include compositions having a single phase as well as compositions having multiple phases. Any suitable material or combination of materials may be used for the barrier layer. The barrier layer may incorporate an inorganic or an organic compound or both. The preferred barrier layer comprises a mixture of a polymeric material and a non-polymeric material as described in U.S. Pat. No. 7,968,146, PCT Pat. Application Nos. PCT/US2007/023098 and PCT/US2009/042829. To be considered a "mixture", the aforesaid polymeric and non-polymeric materials comprising the barrier layer should be deposited under the same reaction conditions and/or at the same time. The weight ratio of polymeric to non-polymeric material may be in the range of 95:5 to 5:95. The polymeric material and the non-polymeric material may be created from the same precursor material. In one example, the mixture of a polymeric material and a non-polymeric material consists essentially of polymeric silicon and inorganic silicon.

Devices fabricated in accordance with embodiments of the invention can be incorporated into a wide variety of electronic component modules (or units) that can be incorporated into a variety of electronic products or intermediate components. Examples of such electronic products or intermediate components include display screens, lighting devices such as discrete light source devices or lighting panels, etc. that can be utilized by the end-user product manufacturers. Such electronic component modules can optionally include the driving electronics and/or power source(s). Devices fabricated in accordance with embodiments of the invention can be incorporated into a wide variety of consumer products that have one or more of the electronic component modules (or units) incorporated therein. Such consumer products would include any kind of products that include one or more light source(s) and/or one or more of some type of visual displays. Some examples of such consumer products include flat panel displays, computer monitors, medical monitors, televisions, billboards, lights for interior or exterior illumination and/or signaling, heads-up displays, fully or partially transparent displays, flexible displays, laser printers, telephones, cell phones, tablets, phablets, personal digital assistants (PDAs), wearable device, laptop computers, digital cameras, camcorders, viewfinders, micro-displays, 3-D displays, vehicles, a large area wall, theater or stadium screen, or a sign. Various control mechanisms may be used to control devices fabricated in accordance with the present invention, including passive matrix and active matrix. Many of the devices are intended for use in a temperature range comfortable to humans, such as 18 degrees C. to 30 degrees C., and more preferably at room temperature (20-25 degrees C), but could be used outside this temperature range, for example, from -40 degree C to + 80 degree C.

The materials and structures described herein may have applications in devices other than OLEDs. For example, other optoelectronic devices such as organic solar cells and organic photodetectors may employ the materials and structures. More generally, organic devices, such as organic transistors, may employ the materials and structures.

The term "halo," "halogen," or "halide" as used herein includes fluorine, chlorine, bromine, and iodine.

The term "alkyl" as used herein contemplates both straight and branched chain alkyl radicals. Preferred alkyl groups are those containing from one to fifteen carbon atoms and include methyl, ethyl, propyl, 1-methylethyl, butyl, 1-methylpropyl, 2-methylpropyl, pentyl, 1-methylbutyl, 2-methylbutyl, 3-methylbutyl, 1,1-dimethylpropyl, 1,2-dimethylpropyl, 2,2-dimethylpropyl. Additionally, the alkyl group may be optionally substituted.

The term "cycloalkyl" as used herein contemplates cyclic alkyl radicals. Preferred cycloalkyl groups are those containing 3 to 10 ring carbon atoms and include cyclopropyl, cyclopentyl, cyclohexyl, adamantyl. Additionally, the cycloalkyl group may be optionally substituted.

The term "alkenyl" as used herein contemplates both straight and branched chain alkene radicals. Preferred alkenyl groups are those containing two to fifteen carbon atoms. Additionally, the alkenyl group may be optionally substituted.

The term "alkynyl" as used herein contemplates both straight and branched chain alkyne radicals. Preferred alkynyl groups are those containing two to fifteen carbon atoms. Additionally, the alkynyl group may be optionally substituted.

The terms "aralkyl" or "arylalkyl" as used herein are used interchangeably and contemplate an alkyl group that has as a substituent an aromatic group. Additionally, the aralkyl group may be optionally substituted.

The term "heterocyclic group" as used herein contemplates aromatic and non-aromatic cyclic radicals. Hetero-aromatic cyclic radicals also means heteroaryl. Preferred hetero-non-aromatic cyclic groups are those containing 3 to 7 ring atoms which includes at least one hetero atom, and includes cyclic amines such as morpholino, piperidino, pyrrolidino, and cyclic ethers, such as tetrahydrofuran, tetrahydropyran. Additionally, the heterocyclic group may be optionally substituted.

The term "aryl" or "aromatic group" as used herein contemplates single-ring groups and polycyclic ring systems. The polycyclic rings may have two or more rings in which two carbons are common to two adjoining rings (the rings are "fused") wherein at least one of the rings is aromatic, e.g., the other rings can be cycloalkyls, cycloalkenyls, aryl, heterocycles, and/or heteroaryls. Preferred aryl groups are those containing six to thirty carbon atoms, preferably six to twenty carbon atoms, more preferably six to twelve carbon atoms. Especially preferred is an aryl group having six carbons, ten carbons or twelve carbons. Suitable aryl groups include phenyl, biphenyl, triphenyl, triphenylene, tetraphenylene, naphthalene, anthracene, phenalene, phenanthrene, fluorene, pyrene, chrysene, perylene, and azulene, preferably phenyl, biphenyl, triphenyl, triphenylene, fluorene, and naphthalene. Additionally, the aryl group may be optionally substituted.

The term "heteroaryl" as used herein contemplates single-ring hetero-aromatic groups that may include from one to five heteroatoms. The term heteroaryl also includes polycyclic hetero-aromatic systems having two or more rings in which two atoms are common to two adjoining rings (the rings are "fused") wherein at least one of the rings is a heteroaryl, e.g., the other rings can be cycloalkyls, cycloalkenyls, aryl, heterocycles, and/or heteroaryls. Preferred heteroaryl groups are those containing three to thirty carbon atoms, preferably three to twenty carbon atoms, more preferably three to twelve carbon atoms. Suitable heteroaryl groups include dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine, preferably dibenzothiophene, dibenzofuran, dibenzoselenophene, carbazole, indolocarbazole, imidazole, pyridine, triazine, benzimidazole, 1,2-azaborine, 1,3-azaborine, 1,4-azaborine, borazine, and aza-analogs thereof. Additionally, the heteroaryl group may be optionally substituted.

The alkyl, cycloalkyl, alkenyl, alkynyl, aralkyl, heterocyclic group, aryl, and heteroaryl may be unsubstituted or may be substituted with one or more substituents selected from the group consisting of deuterium, halogen, alkyl, cycloalkyl, heteroalkyl, arylalkyl, alkoxy, aryloxy, amino, cyclic amino, silyl, alkenyl, cycloalkenyl, heteroalkenyl, alkynyl, aryl, heteroaryl, acyl, carbonyl, carboxylic acid, ether, ester, nitrile, isonitrile, sulfanyl, sulfinyl, sulfonyl, phosphino, and combinations thereof.

As used herein, "substituted" indicates that a substituent other than H is bonded to the relevant position, such as carbon. Thus, for example, where R¹ is monosubstituted, then one R¹ must be other than H. Similarly, where R¹ is di-substituted, then two of R¹ must be other than H. Similarly, where R¹ is unsubstituted, R¹ is hydrogen for all available positions.

The "aza" designation in the fragments described herein, i.e. aza-dibenzofuran, aza-dibenzothiophene, etc. means that one or more of the C-H groups in the respective fragment can be replaced by a nitrogen atom, for example azatriphenylene encompasses both dibenzo[*f*,*h*]quinoxaline and dibenzo[*f*,*h*]quinoline.

It is to be understood that when a molecular fragment is described as being a substituent or otherwise attached to another moiety, its name may be written as if it were a fragment (e.g. phenyl, phenylene, naphthyl, dibenzofuryl) or as if it were the whole molecule (e.g. benzene, naphthalene, dibenzofuran). As used herein, these different ways of designating a substituent or attached fragment are considered to be equivalent.

Iridium complexes containing simple alkyl substituted phenylpyridine ligands have been widely used as emitters in phosphorescent OLEDs. In some embodiments, the present disclosure discloses iridium complexes comprising a substituted phenylpyridine ligand with specific substitution patterns or specific novel substitutions that form bulky groups on the Ir complex. Bulky groups on Pt complex ligands also have shown higher EQE and less excimer formation. These substitutions unexpectedly improve the device efficiency and lifetime. These substitutions also orient the metal complexes so that their transition dipole moments are parallel to the OLED substrate that enhances the external quantum efficiency of emitters. The parallel orientation of the transition dipole moments of the emitter metal complexes enhances the amount of light extracted from the OLED because the light emission is perpendicular to the transition dipole of the emitter compounds.

**Determination of Emitter Transition Dipole Moment Orientation** - The orientation of transition dipole moments of the emitters in OLEDs has received much attention as one of the significant factors limiting external quantum efficiency. A number of different methods of measuring the orientation has been used and reported in recent literature. The reported methods include: angular photoluminescence profile measurements followed by optical simulation; integrating sphere EQE measurements of EL devices with and without outcoupling lenses using devices with a range of ETL thicknesses; and monochromatic electroluminescence far-field angular patterns measurements. All of these methods use the commercial optical simulation software for data calculations and interpretation.

The method described below was designed for evaluating the orientation factor of a large number of OLED emitters used in devices with standard material sets. Normally, the subject materials are used in devices with structures optimized for maximum efficiency. The method requires modified structures with changed thicknesses of the layers in order to enhance the sensitivity of the measured emission to the emitter's dipole orientation.

**Device structure selection** - The key element in studying the dipole orientation of OLED emitters is the tuning of the sample device's structure to enhance the optical characteristics of the emission which are the most sensitive to the dipole orientation. In a bottom-emitting device, the distance of the location of the emitters from the reflecting cathode becomes the dominating parameter if it is tuned to the maximum wavelength of the emission spectrum to create the cavity effect. The cavity effects activated this way are best visible in angular measurements of polarized emission.

The structure has to provide the matrix to hold the emitters in a well-defined location and the way to activate the emitter's electroluminescence. Even though the structure constitutes a complex optical system with many interfaces and includes materials with different optical properties, it can be designed to make the distance between the emitting sites and the reflecting cathode the primary element defining the far field pattern in air.

**Table 1: An example of a proposed device structure for determining the orientation factor of a yellow emitter.**

| **Layer** | **Thickness [nm]** |
|---|---|
| Substrate | ITO 750Å_5mm² |
| HIL | 100 |
| HTL | 700 |
| EBL* | 50 |
| EML doped with Emitter 12%*** | 100 |
| HBL* | 50 |
| ETL** | 1550 |
| EIL | 10 |
| Al cathode | 1000 |

**Table 2: An example of a proposed device structure for determining the orientation factor of a green emitter.**

| **Layer** | **Thickness [nm]** |
|---|---|
| Substrate | ITO 750Å_5mm² |
| HIL | 100 |
| HTL | 650 |
| EBL* | 50 |
| EML doped with Emitter 12%*** | 100 |
| HBL* | 50 |
| ETL** | 1350 |
| EIL | 10 |
| Al cathode | 1000 |

| | |
|---|---|
| * Carrier blocking layers to confine the emission sources in a thin EML. ** Thick ETL which along with HBL and part of EML resonates with yellow or green emission. *** Thin 100Å EML to confine the recombination zone (RZ) in the narrow region. | |

The example of the device structure that can be used for determining the orientation factor of a yellow emitter compound is shown in Table 1. The layer thicknesses provided in Table 1 are designed for yellow emitter orientation factor measurements. The example of the device structure for determining the orientation factor of a green emitter is shown in Table 2. The layer thicknesses can be adjusted for red, green, or blue emitters according to their emission wavelength. The general rule is to tune the distances between RZ in the EML, the reflective electrode and the transparent electrode, by adjusting the thickness of the appropriate layers, to maximize light output by means of constructive interference of outgoing light from the RZ and reflected light from the reflective electrode. Distance is tuned by device layer thicknesses, is proportional to the emission wavelength. The organic emitters are placed in the 100Å-thick EML. The emission of the organic emitters is usually not strictly monochromatic. Different parts of the spectrum will interact differently with light reflected by the cathode, modifying the original spectrum. Because of that the spectrum seen by the far field instruments may be different from the original PL spectrum of the emitter.

Examples of the materials for the different components in the example device structures for the yellow and green emitter orientation factor determination are as follows:
- Anode : ITO;
- HIL: HATCN;
- HTL: 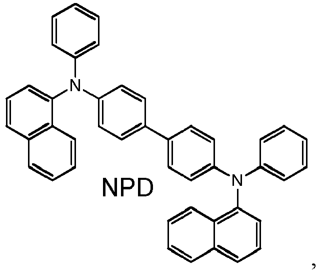 or 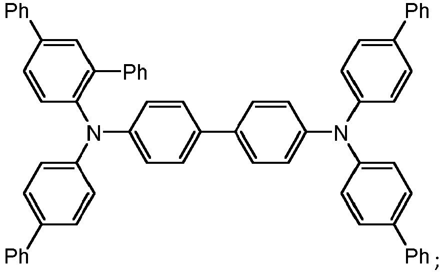
- EBL: 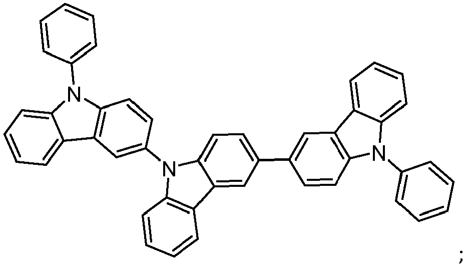
- EML consists of the following two hosts: 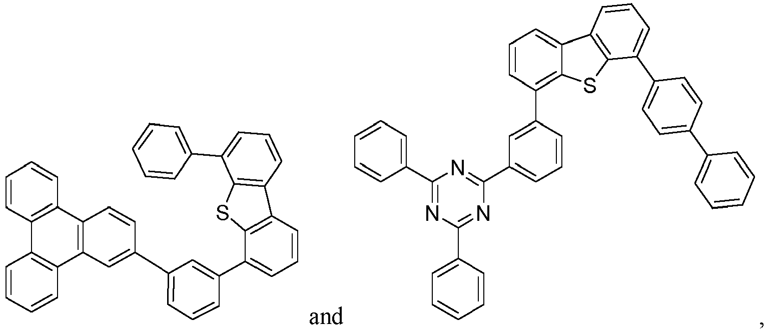 and an emitter;
- HBL: 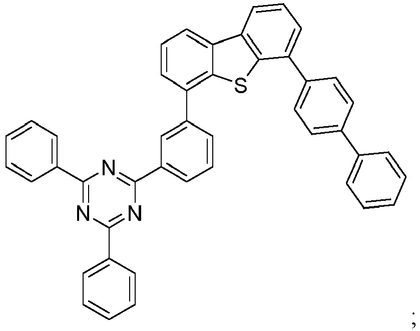
- ETL: Mixed ETL consisting of Liq and 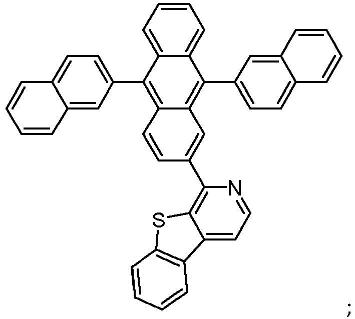
- EIL: LiF or Liq; and
- Cathode : Al.
This material set should be adjusted accordingly for red, green, or blue emitters. One of ordinary skill in the art would know how to adjust the material set for red, green, or blue emitters. The relatively large device pixel area of 5mm² was selected for the convenience of angular spectra measurements.

**The testing:** The procedure for determining the orientation factor for the emitter Comparative Example 2, Comp (L_{A147})₂Ir(L_{B184}), in Table 3 is now described. The spectral measurements of the device structure in Table 1 are performed using a calibrated spectrophotometer model PR740. Since the instrument uses the image of a dot projected on the shutter with the small aperture, a small parallax effect is expected as the object is viewed at an angle. This needs to be corrected by using a simple geometry. At the angles over 50° there is an additional effect of the instrument looking at reflections of light from the back glass cover of the device. For that reason, the data taken at angles wider than 50° is only used to show the trends, but the calculations are only based on data taken at angles between 30-50°. For most of the samples the effects analyzed at 40° angle are strong enough to provide reliable data, so there is no need to quantify the data obtained at wider angles.

Comparing measured and simulated spectral data is the most sensitive measure of the quality of the match between the simulated data and the real emission. Since the simulation software methodology is based on optical properties of the light source, the agreement between observed and simulated data confirms the validity of using the simulation to calibrate the performance of an emitter in terms of calculated dipole orientation. The ratio of *p*- to *s*-emission measured at 30-50° range strongly correlates with the orientation factor. Using the ratio ofp to s radiance eliminates potential problems with absolute calibration of the radiance measurements coming from imperfections of the optical system.

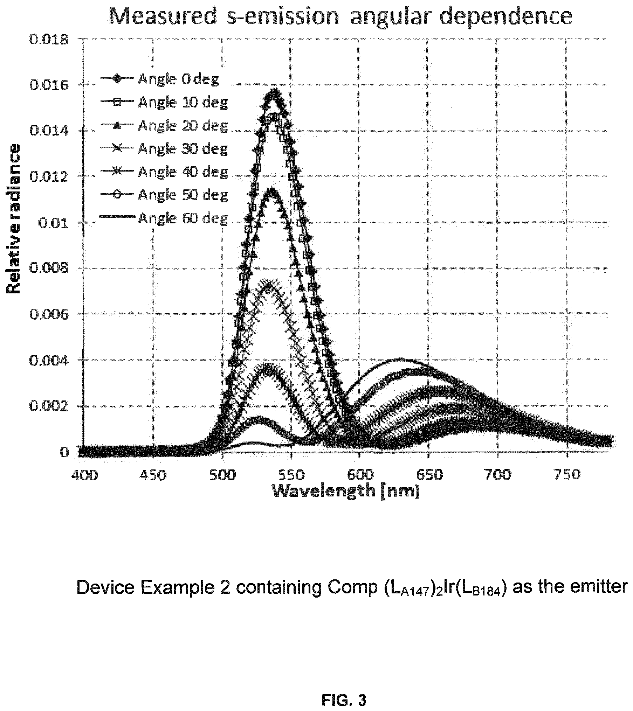

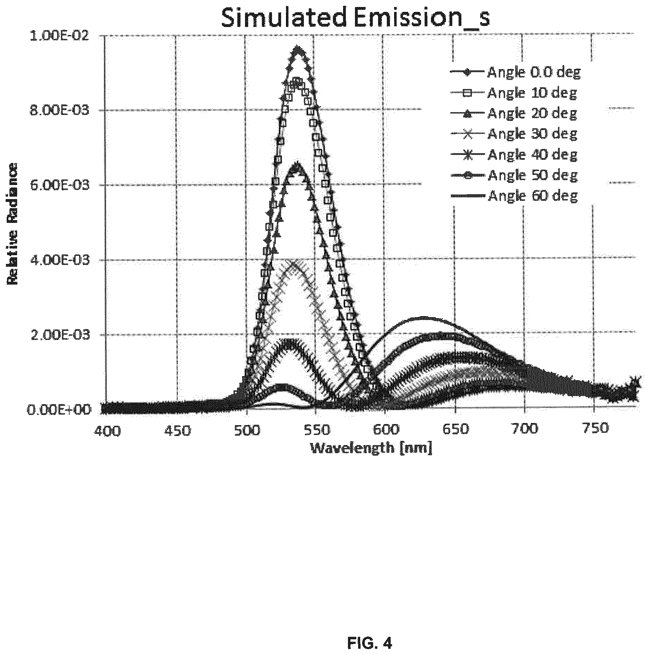

**The spectra:** FIG. 3 shows the EL spectra of the device for emitter Comparative Example 2 in the structure shown in Table 1 taken at various angles from 0 to 60° through an *s*-polarizer. FIG. 4 is simulated angular dependent s-EL spectra of the same device structure using the program SETFOS-4.1 by Fluxim. The experimental and simulated spectra should match.

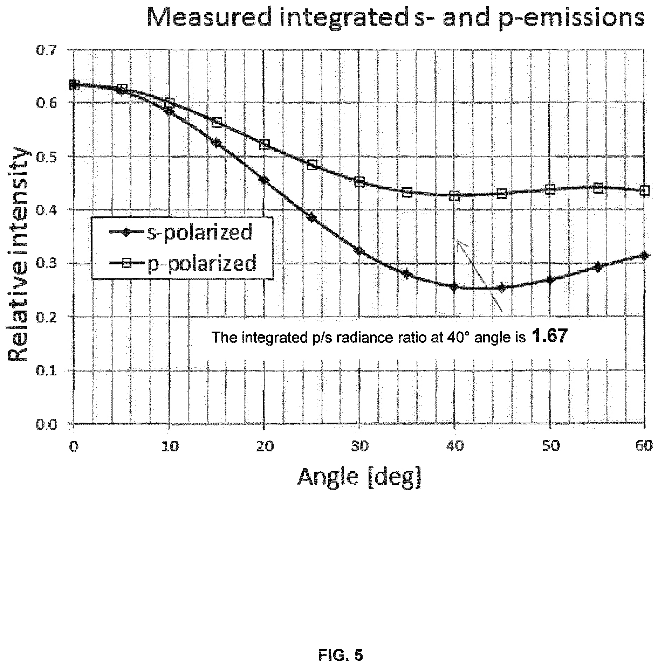

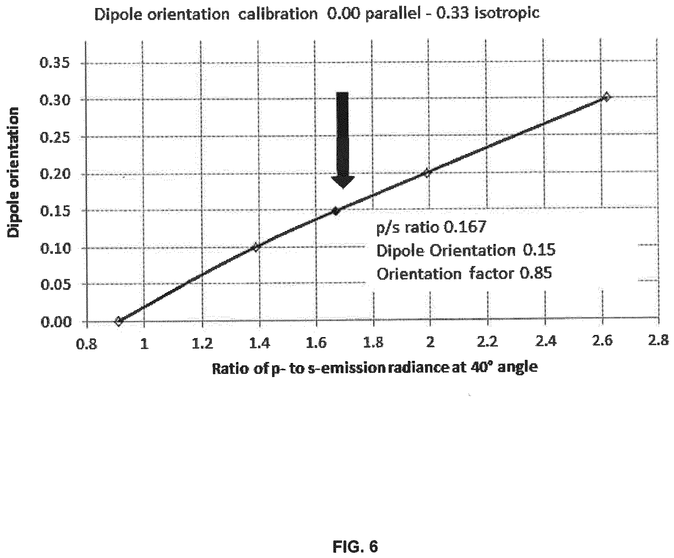

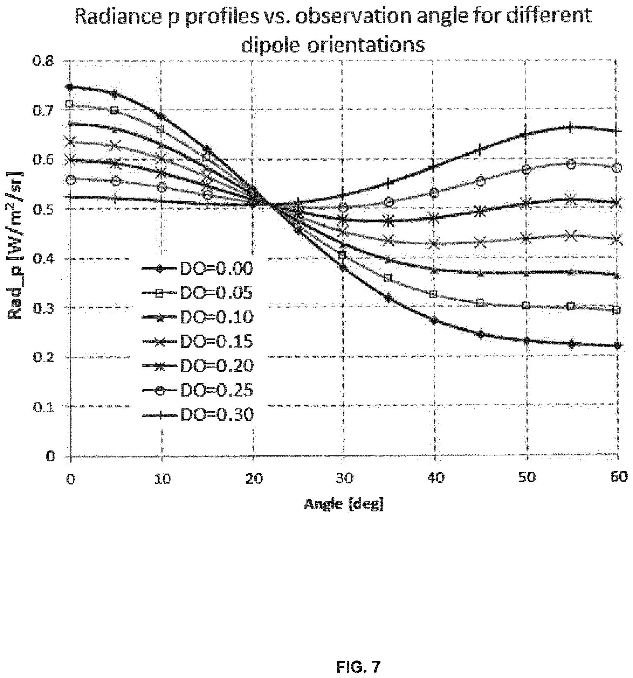

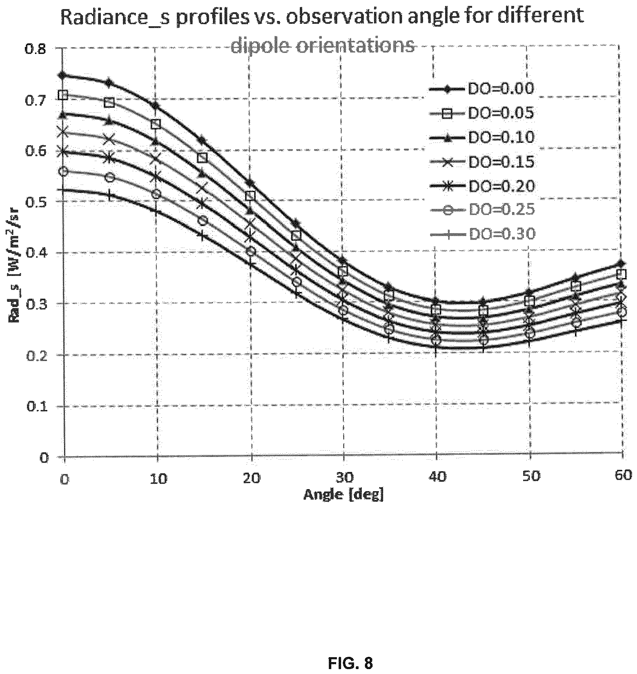

**Results and interpretation:** The details of the dependence of the estimated dipole orientation number on the angular data for a given spectrum and device structure is explained below. The graph in FIG. 5 is based on data generated by the simulation software for the sample with the structure shown in Table 1 and the spectra matched as shown in FIGS. 3-4. For this specific example, the integrated p/s radiance ratio at 40° angle is 1.67 and corresponding dipole orientation (DO) is 0.15 (FIG. 6). The DO numbers generated by the simulation software represent the statistical distribution of vertical versus horizontal orientations. The vertical and horizontal directions are with respect to the substrate and vertical refers to the direction orthogonal to the substrate surface and horizontal refers to the direction parallel to the substrate surface. With one vertical and two horizontal directions, the DO number scale is 0 (parallel or horizontal) to 0.33 (isotropic). The corresponding scale of 1 to 0.67 represents the percentage of the original EQE after losses due to dipole orientation This value defined as Θ =1-DO is called emitter orientation factor (in our example Θ=1-0.15=0.85, or 85% of max EQE) is used further in the experimental data. It represents the % of emitter dipoles aligned parallel to the substrate. The graphs in FIGs. 7 and 8 show the angular response to dipole orientation at angles 30 - 50° to be much stronger for *p*-emission than that of *s*-emission. Also the *p*-radiance value goes up while the *s*-radiance gets smaller as the dipole orientation number increases. The resulting p/s ratio shows very high sensitivity to the dipole orientation starting from 30° observation angles. 40° in current measurements gives the biggest difference between s and p emission and the highest sensitivity and thus 40° angle is selected.

Material has a preferred orientation ('orientation factor') meaning that in a thin solid state film it has an anisotropic horizontal to vertical dipole ratio, *i.e.* the horizontal to vertical dipole ratio is greater than 0.67:0.33 (isotropic case) e.g. of 0.77:0.23. To describe this another way, the orientation factor Θ, the ratio of the horizontal dipoles to total dipoles, is greater than 0.67.

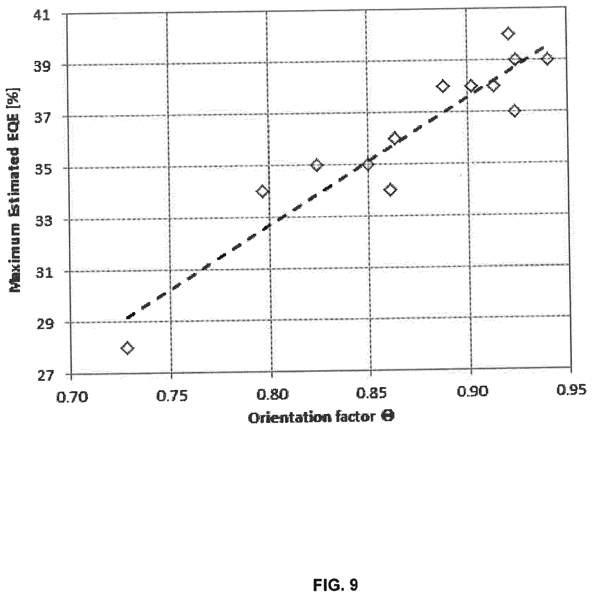

FIG. 9 shows the obtained correlation between estimated maximum EQE vs. orientation factor. Obvious EQE increase with increasing orientation factor is observed. The closer the orientation factor is to 1 the more emitter molecules are aligned parallel to the substrate which is favorable for improved device efficiency.

Procedure for emitter photoluminescence quantum yield (PLQY) measurement in PMMA is described here. General preparation and experimental for solid state samples: PMMA and emitter (various wt%) are weighed out and dissolved in toluene. The solution is filtered through a 2 micron filter and drop cast onto a precleaned quartz substrate. PL quantum efficiency measurements were carried out on a Hamamatsu C9920 system equipped with a xenon lamp, integrating sphere and a model C10027 photonic multi-channel analyzer.

**Table 3. Correlation of Estimated EQE in the device with Emitter PLQY and orientation factor.**

| Example | # | Emitter | Estimated Max EQE [%] | PLQY [%] 5% in PMMA | Emitter Orientation factor Θ |
|---|---|---|---|---|---|
| CE | 1 | **Comp Ir(L_{B184})₃** | 28 | 90 | 0.73 |
| CE | 2 | **Comp (L_{A1})₂Ir(L_{B182})** | 34 | 91 | 0.80 |
| Comparative Example | 1 | **Comp (L_{A1})₂Ir(L_{B196})** | 35 | 98 | 0.82 |
| Comparative Example | 2 | **Comp (L_{A147})₂Ir(L_{B184})** | 36 | 95 | 0.85 |
| Comparative Example | 3 | **Comp (L_{A163})₂Ir(L_{B184})** | 34 | 89 | 0.86 |
| Comparative Example | 4 | **Comp (L_{A153})₂Ir(L_{B227})** | 38 | 96 | 0.89 |
| Comparative Example | 5 | **Comp (L_{A147})₂Ir(L_{B225})** | 38 | 95 | 0.90 |
| Example | 6 | **Comp (L_{A147})₂Ir(L_{B112})** | 38 | 89 | 0.91 |
| Example | 7 | **Comp (L_{A147})₂Ir(L_{B86})** | 40 | 98 | 0.92 |
| Example | 8 | **Comp (L_{A153})₂Ir(L_{B86})** | 37 | 89 | 0.92 |
| Example | 9 | **Comp (L_{A147})₂Ir(L_{B109})** | 39 | 94 | 0.92 |
| Example | 10 | **Comp (L_{A147})₂Ir(L_{B88})** | 39 | 92 | 0.94 |

As seen by the emitter orientation factor, emitter orientation is more parallel with increasing bulkiness of group on 4-phenyl ring of 2,4-diphenylpyridine ligand. It has been reported that estimated EQE is in direct correlation with emitter orientation.

**Table 4. Correlation of PLQY with emitter concentration for some emitters**

| Example | Emitter | Emitter % in PMMA | PLQY [%] |
|---|---|---|---|
| CE2 | **Comp (L_{A1})₂Ir(L_{B182})** | 1 | 93 |
| CE2 | **Comp (L_{A1})₂Ir(L_{B182})** | 5 | 91 |
| CE2 | **Comp (L_{A1})₂Ir(L_{B182})** | 10 | 90 |
| CE2 | **Comp (L_{A1})₂Ir(L_{B182})** | 15 | 80 |
| CE2 | **Comp (L_{A1})₂Ir(L_{B182})** | 20 | 72 |
| Comparative Example 2 | **Comp (L_{A147})₂Ir(L_{B184})** | 1 | 96 |
| Comparative Example 2 | **Comp (L_{A147})₂Ir(L_{B184})** | 5 | 95 |
| Comparative Example 2 | **Comp (L_{A147})₂Ir(L_{B184})** | 10 | 89 |
| Comparative Example 2 | **Comp (L_{A147})₂Ir(L_{B184})** | 15 | 87 |
| Comparative Example 2 | **Comp (L_{A147})₂Ir(L_{B184})** | 20 | 84 |
| Example 9 | **Comp (L_{A147})₂Ir(L_{B109})** | 1 | 96 |
| Example 9 | **Comp (L_{A147})₂Ir(L_{B109})** | 5 | 94 |
| Example 9 | **Comp (L_{A147})₂Ir(L_{B109})** | 10 | 91 |
| Example 9 | **Comp (L_{A147})₂Ir(L_{B109})** | 15 | 90 |
| Example 9 | **Comp (L_{A147})₂Ir(L_{B109})** | 20 | 87 |

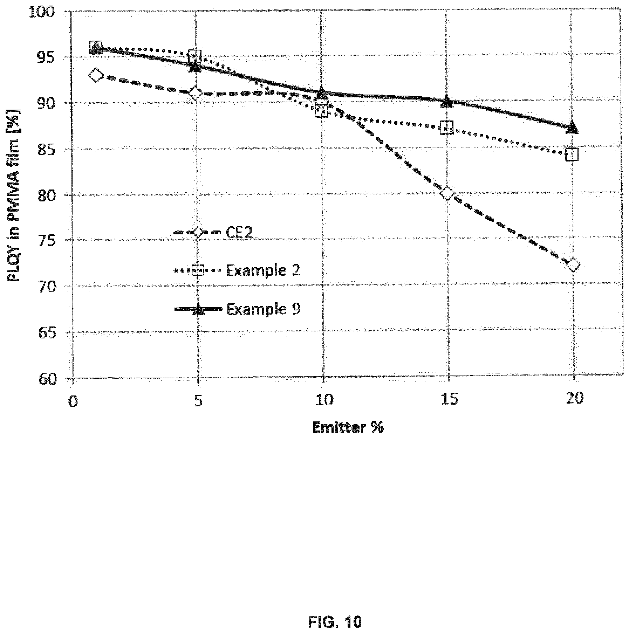

FIG. 10 shows the correlation of Emitter PLQY in the thin film as a function of emitter concentration. For non-bulky emitters like Comp (L_{A1})₂Ir(L_{B182}) used in device CE2, PLQY drops significantly with increasing emitter concentration over 10%. However for more bulky emitters (e.g., the emitters used in devices Example 2 and Example 9) PLQY does not decrease quickly with emitter concentration increase. Hence, steric bulk of emitter molecules prevents self-quenching at high emitter %.

From the above-determined emitter orientation and PLQY measurements, it follows that emitters with more steric bulk in certain direction on the molecule will provide more parallel (to the substrate of the OLED) orientation and therefore exhibit higher EQE in the device. The structures of the compounds listed in Tables 3 and 4 are shown here:

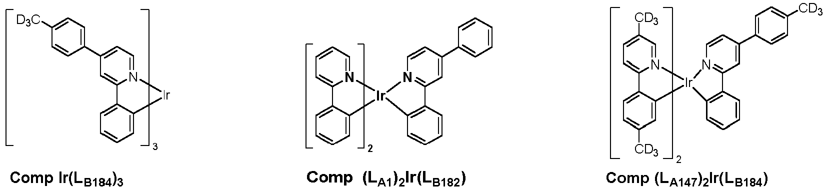

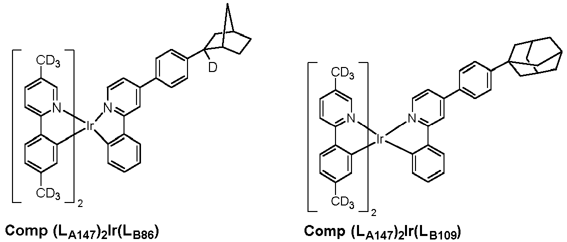

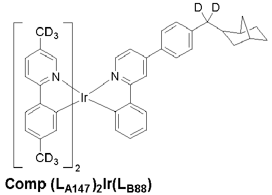

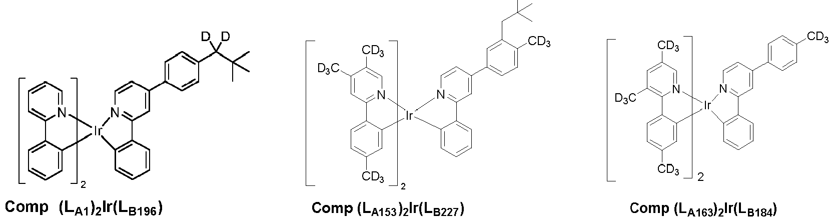

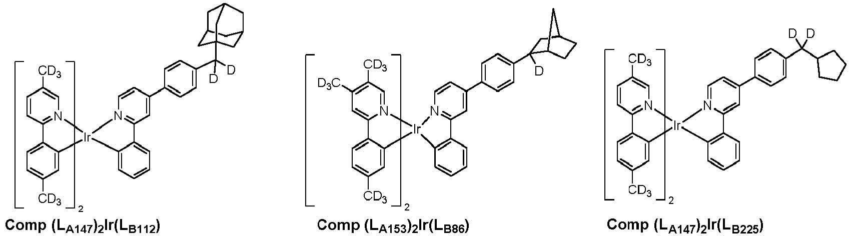

In some embodiments, the molecule of the compound according to the present invention has an orientation factor Θ value of at least 0.75. In other embodiments, the molecule has an orientation factor value of at least 0.80. In other embodiments, the molecule has an orientation factor value of at least 0.85. In other embodiments, the molecule has an orientation factor value of at least 0.91. In other embodiments, the molecule has an orientation factor value of at least 0.92. In other embodiments, the molecule has an orientation factor value of at least 0.93. In some embodiments, the molecule has an orientation factor value of at least 0.94.

The compound according to the present invention has a formula (L_{A})ₘIr(L_{B})₃₋ₘ selected from the group consisting of 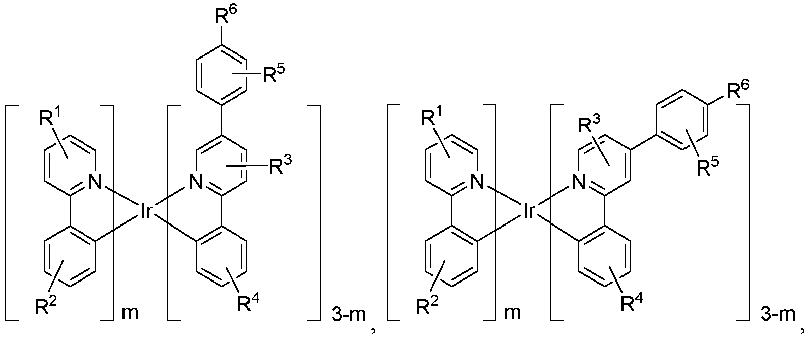 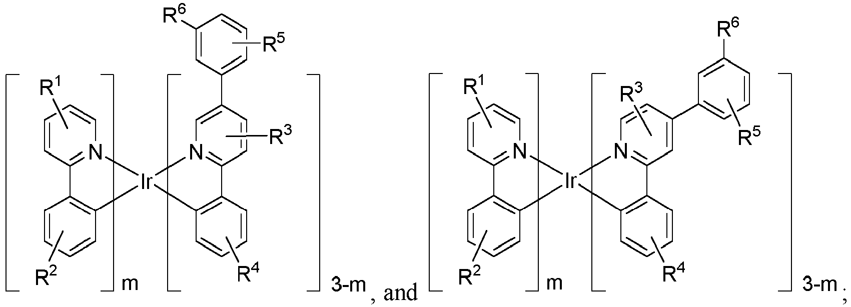 wherein m is 1 or 2; wherein R¹, R², R⁴, and R⁵ each independently represent mono, di, tri, or tetra substitution, or no substitution; wherein R³ represents mono, di, or tri substitution, or no substitution; wherein R¹, R², R³, R⁴, and R⁵ are each independently selected from the group consisting of hydrogen, deuterium, C1 to C6 alkyl, C1 to C6 cycloalkyl, and partially or fully deuterated or fluorinated variants thereof; wherein R⁶ is selected from the group consisting of alkyl having at least seven carbon atoms, cycloalkyl having at least seven carbon atoms, alkyl-cycloalkyl having at least seven carbon atoms, and partially or fully deuterated or fluorinated variants thereof. In some embodiments of the compound m is 2.

The compound according to the present invention may have a structure selected from the group consisting of: 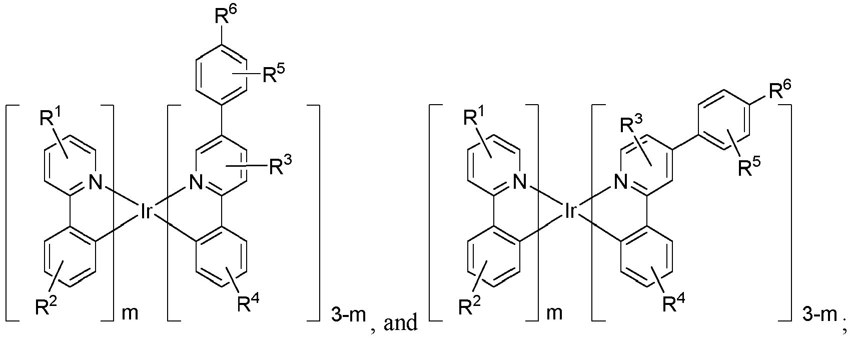 wherein m is 1 or 2 and R¹, R², R³, R⁴, R⁵ and R⁶ are defined as above..

R², R³, R⁴, and R⁵ may each independently be selected from the group consisting of hydrogen, deuterium, methyl, ethyl, propyl, isopropyl, and combinations thereof.

R⁶ may be selected from the group consisting of alkyl having at least eight carbon atoms, cycloalkyl having at least eight carbon atoms, alkyl-cycloalkyl having at least eight carbon atoms, and partially or fully deuterated or fluorinated variants thereof.

In some embodiments R³, R⁴, and R⁵ are each a hydrogen.

In some embodiments, L_{A} is selected from the group consisting of: 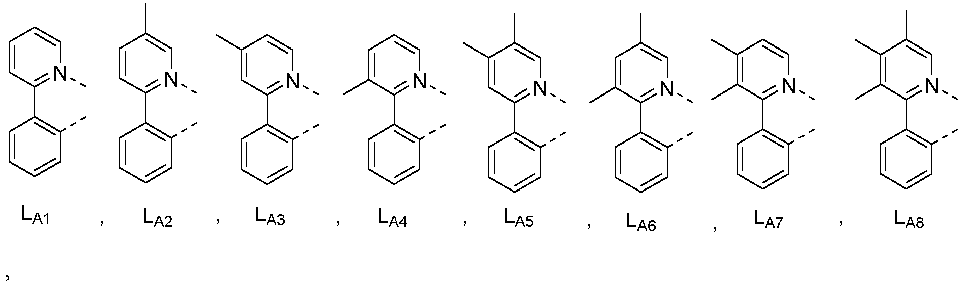 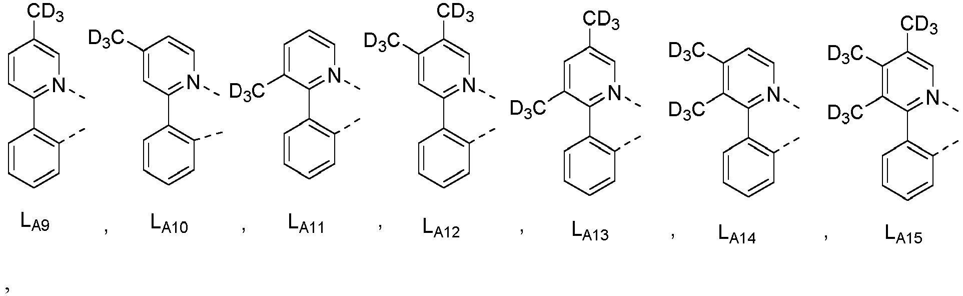 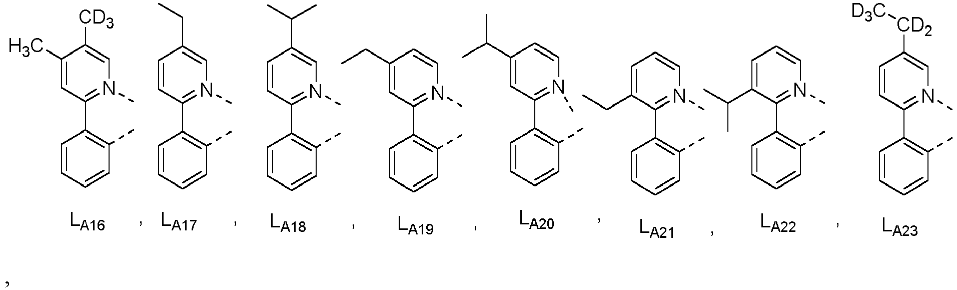 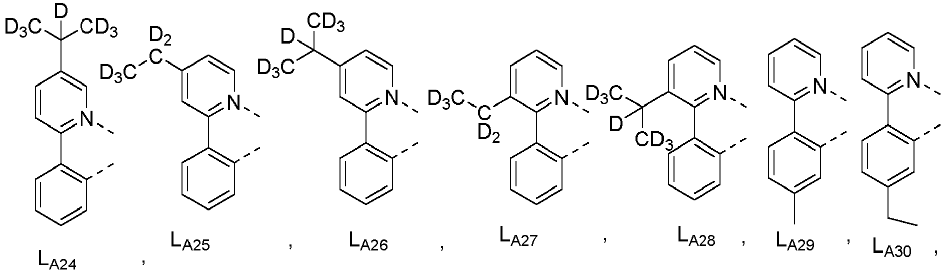 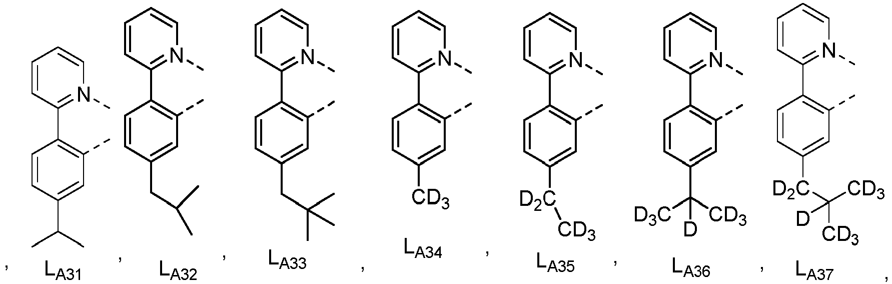 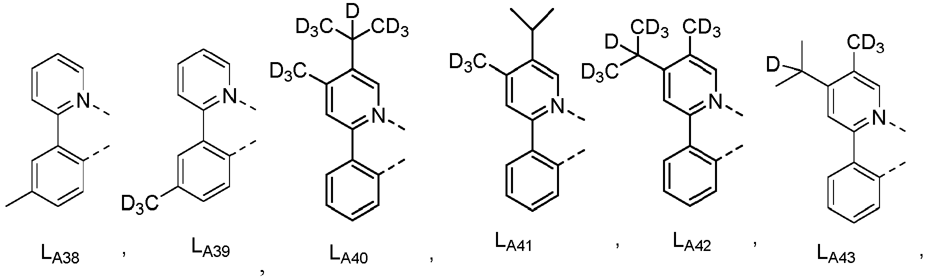 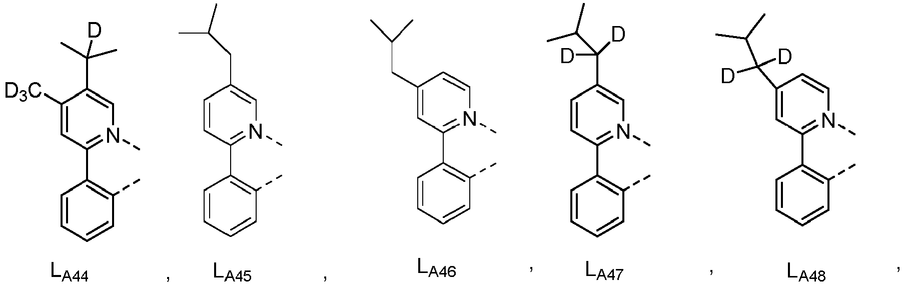 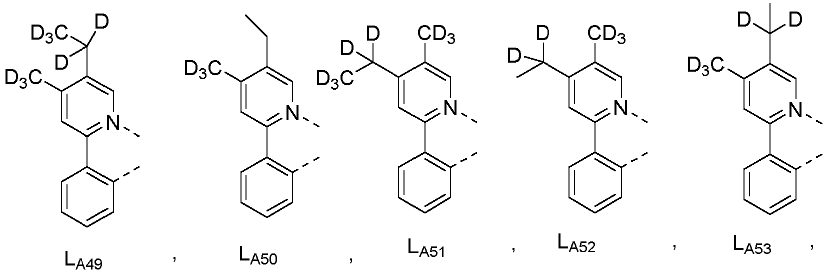 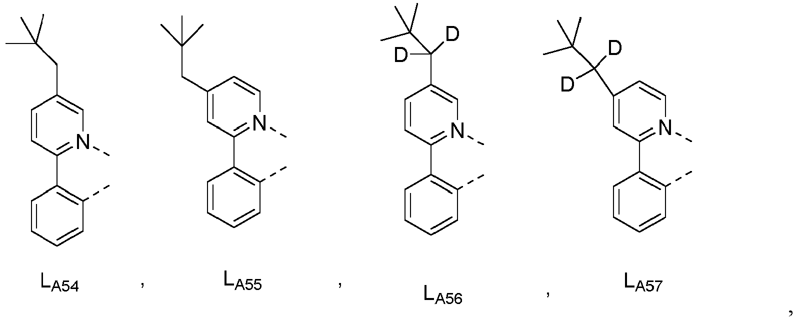 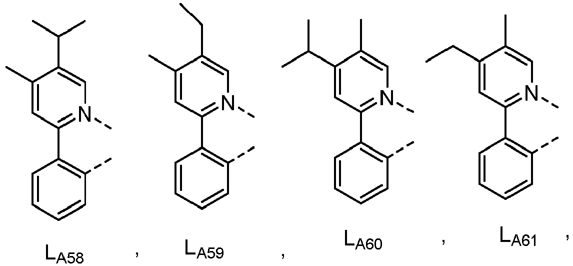 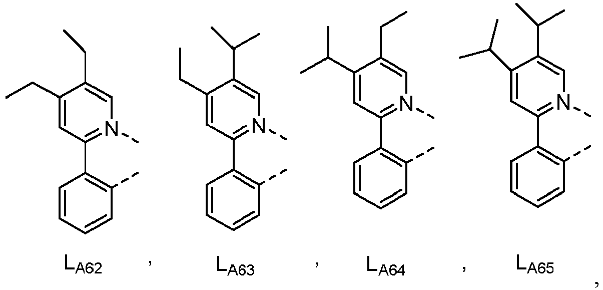 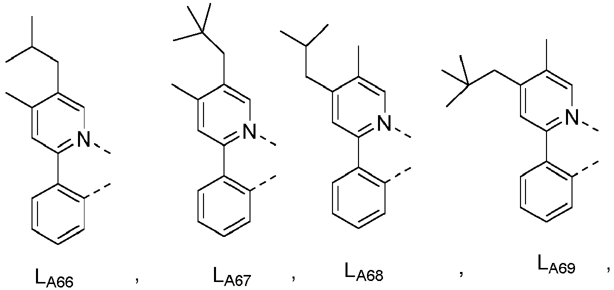 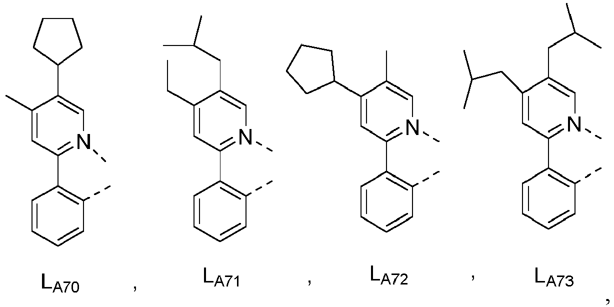 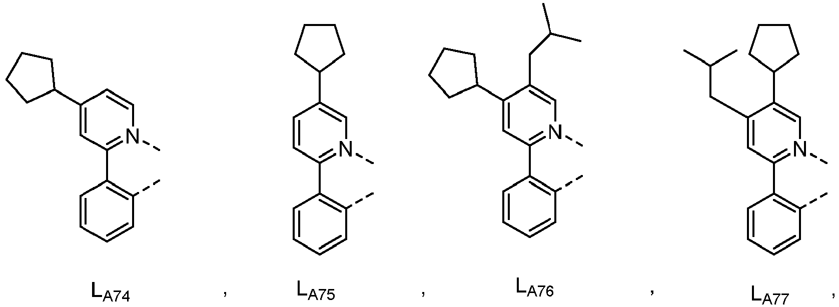 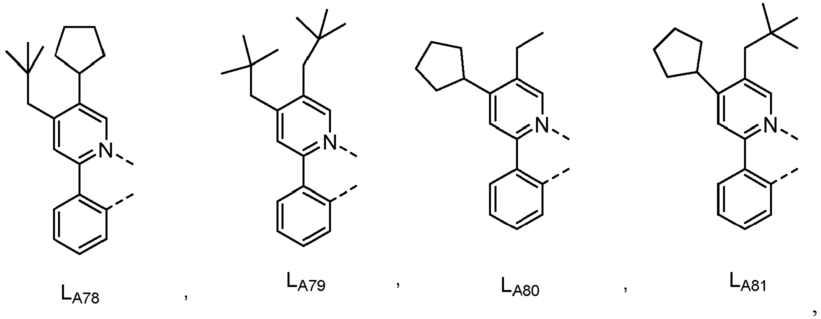 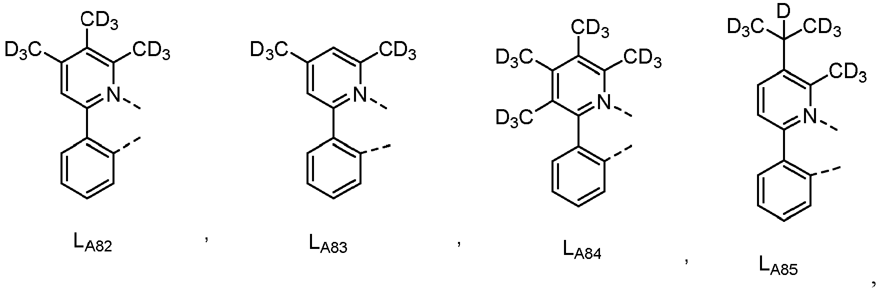 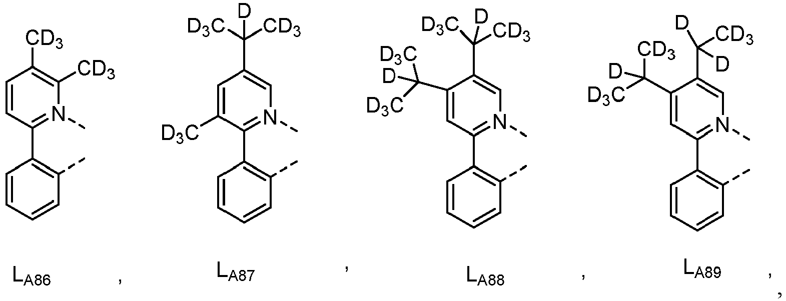 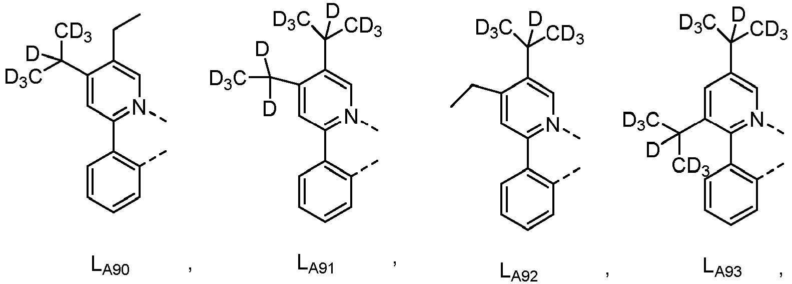 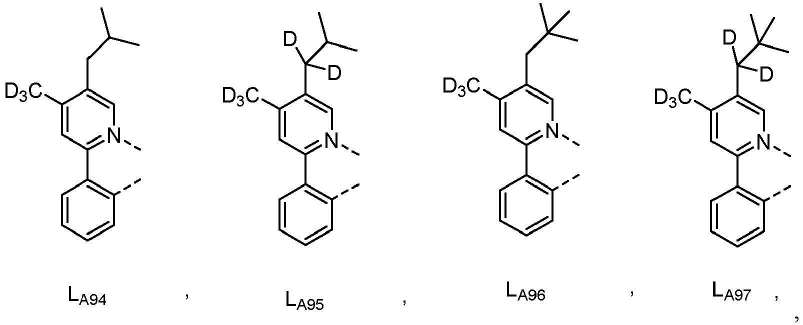 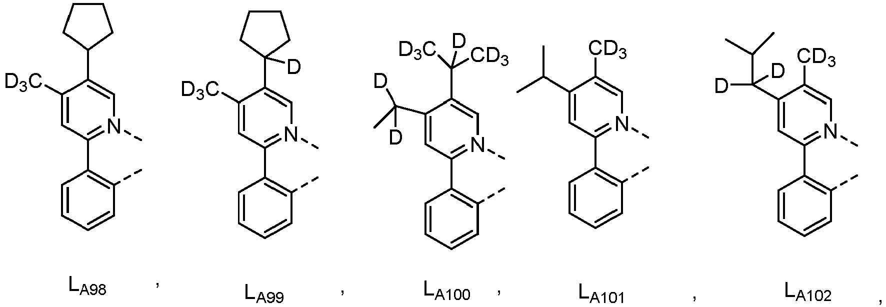 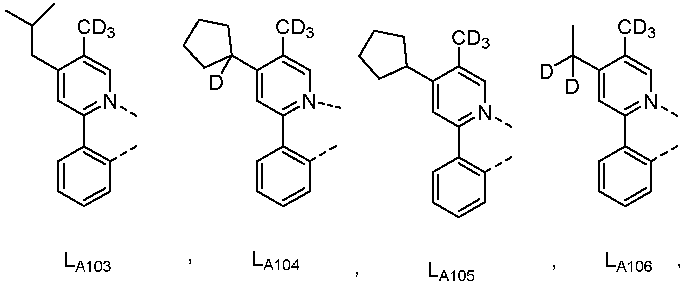 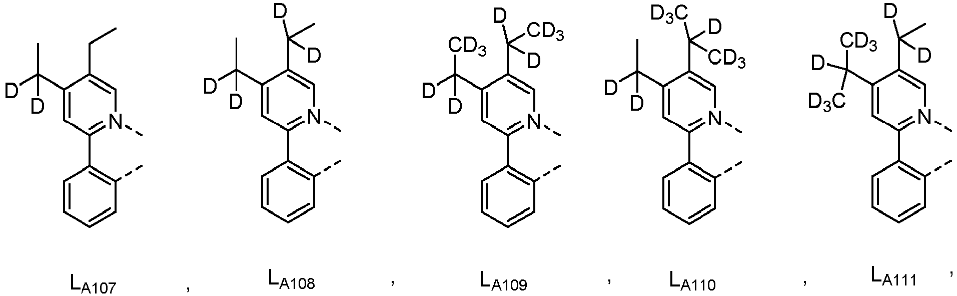 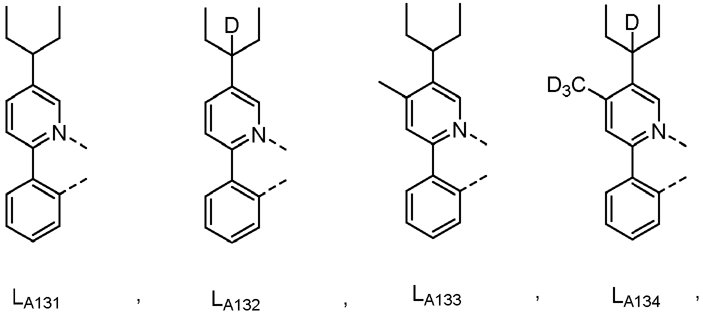 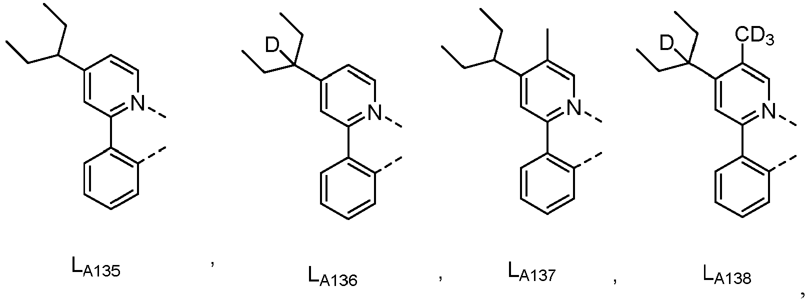 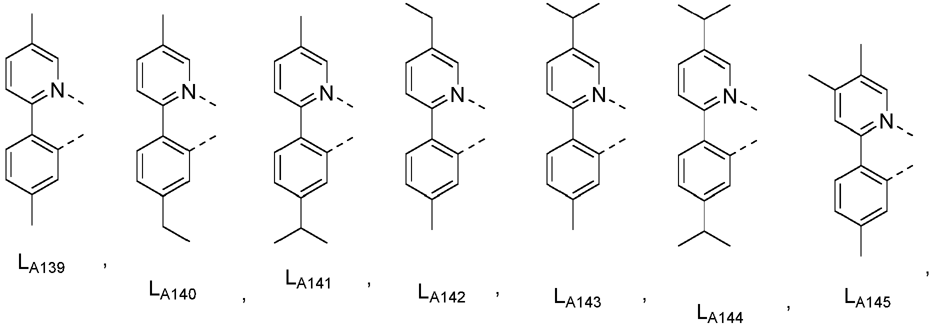 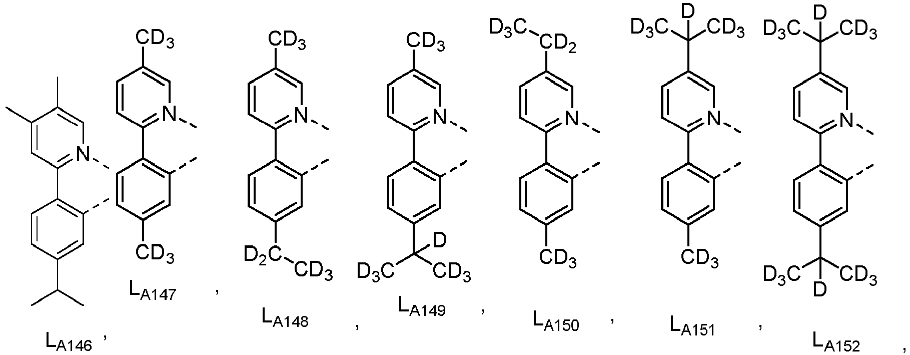 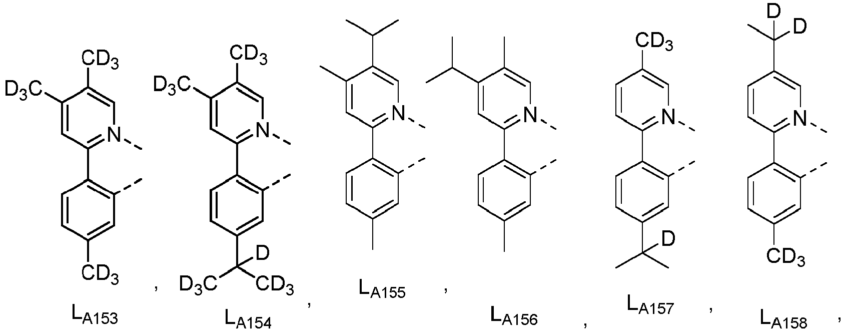 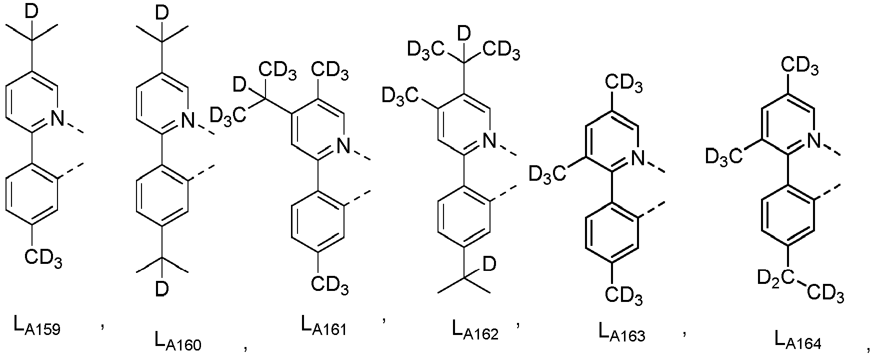 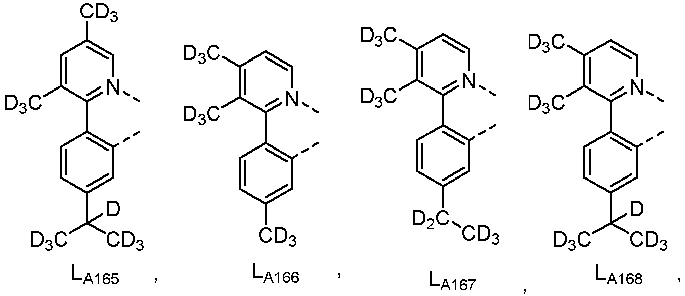 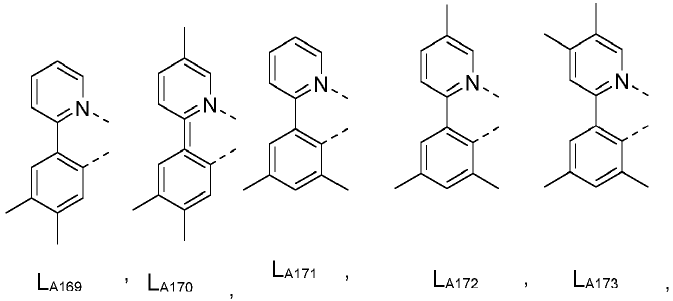 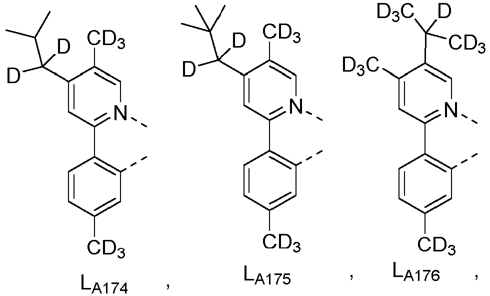 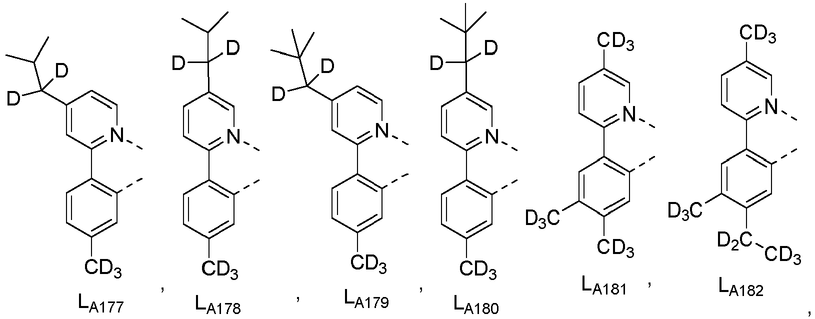 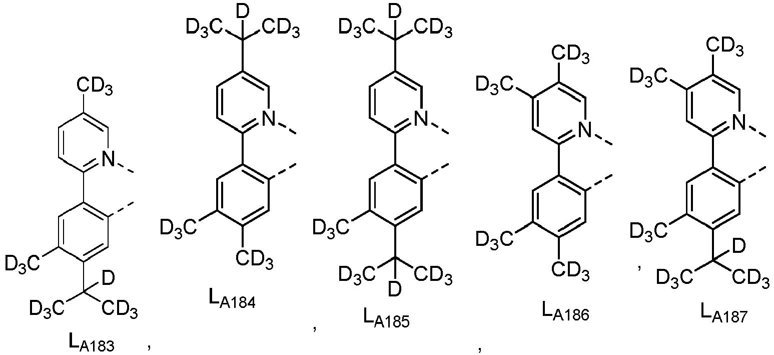 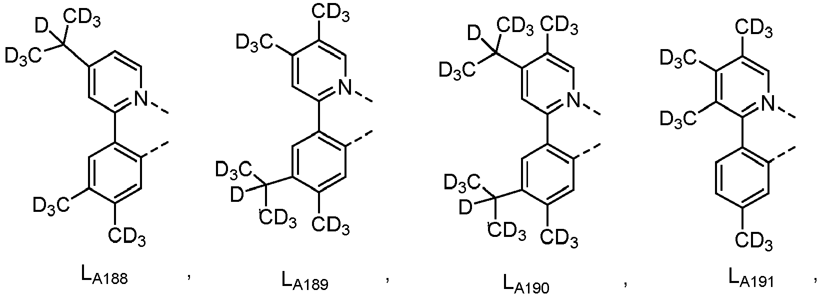 and

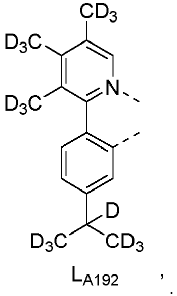

In some embodiments, L_{B} is selected from the group shown below: 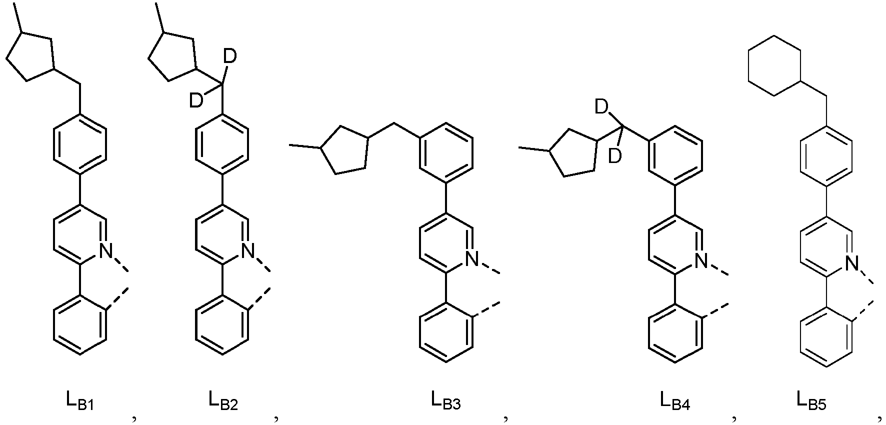 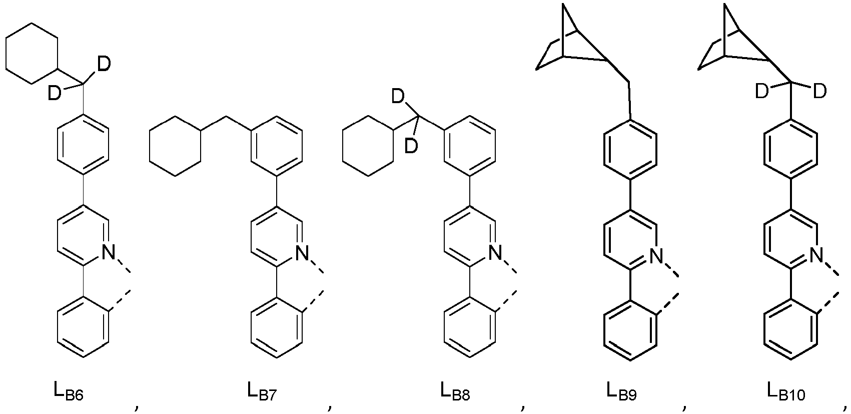 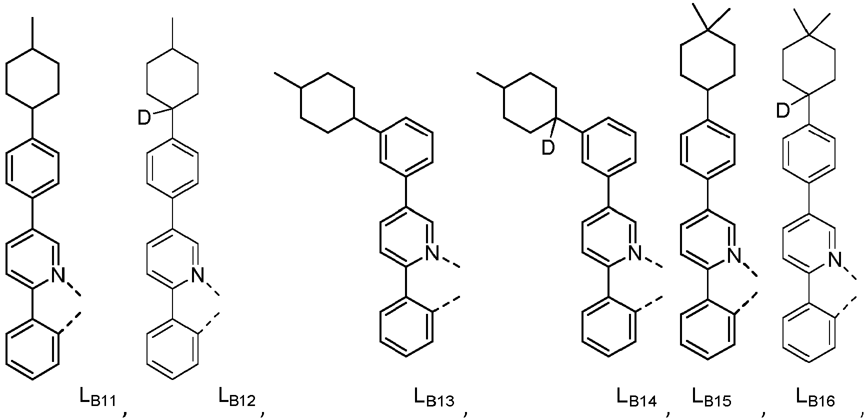 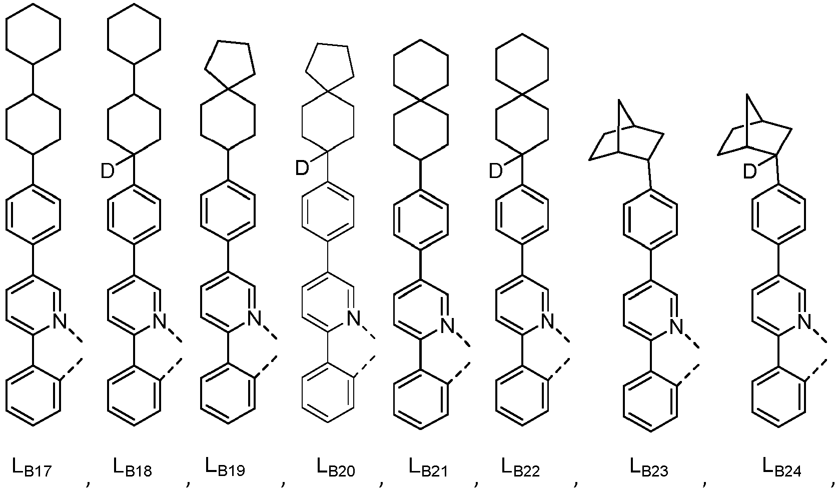 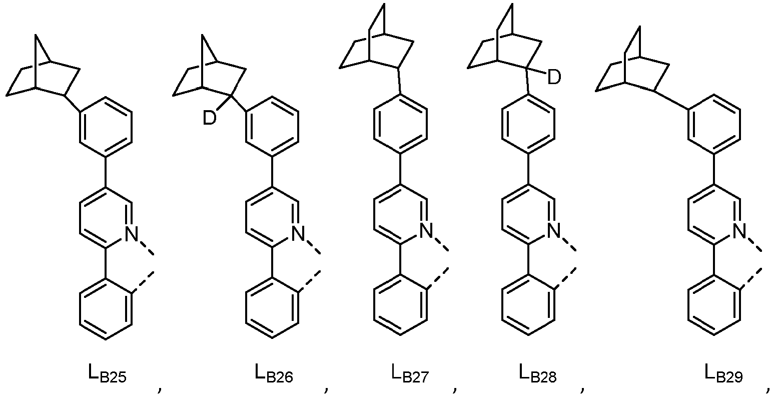 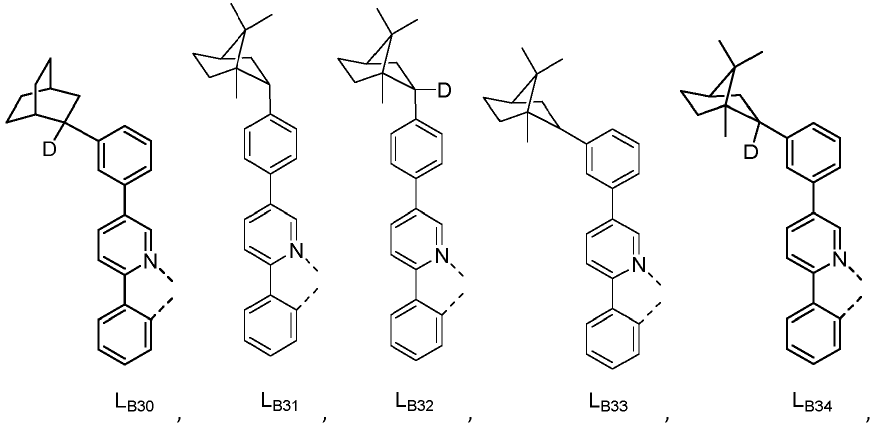 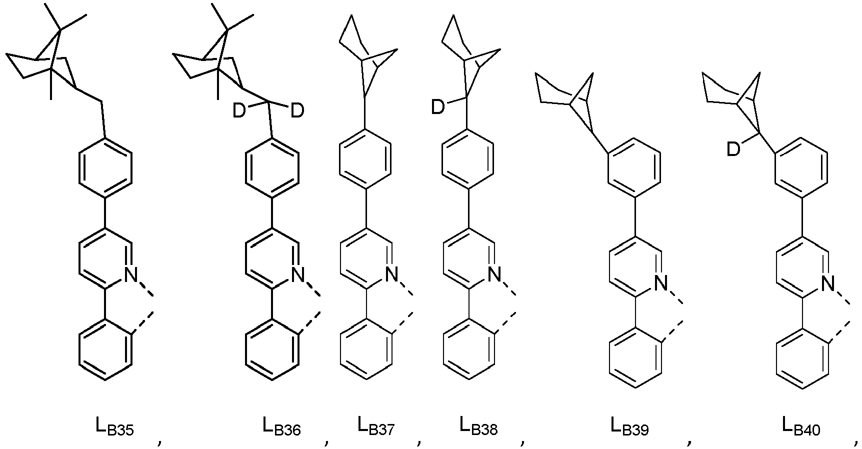 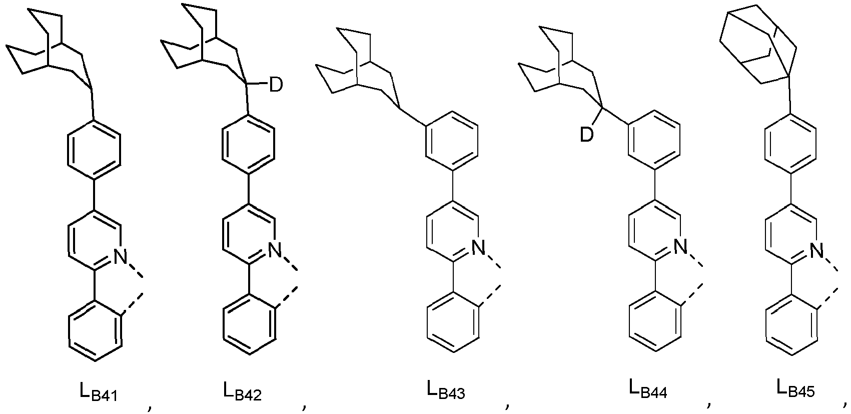 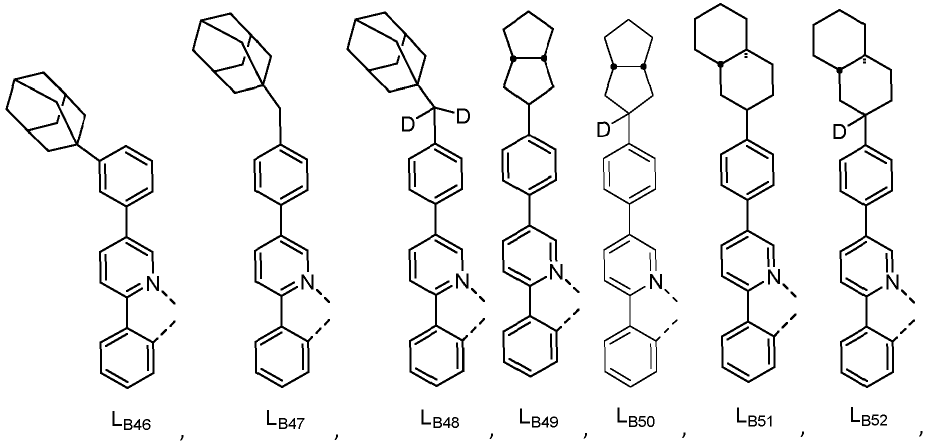 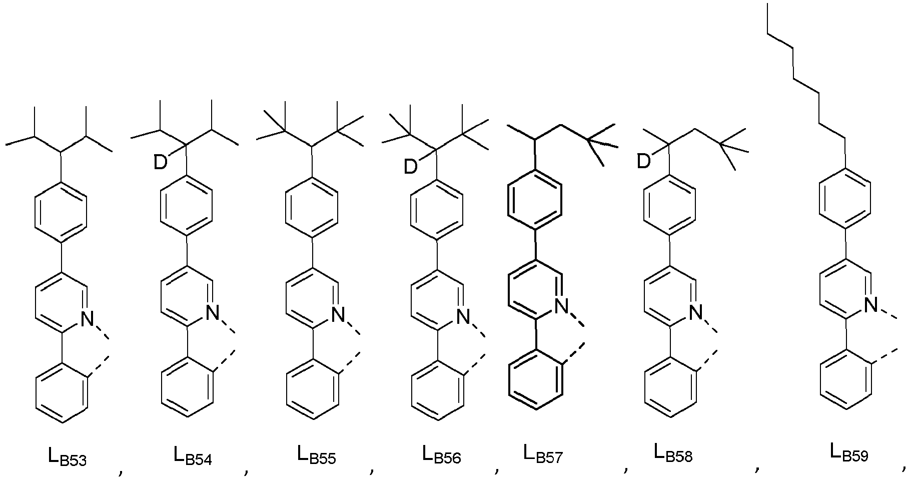 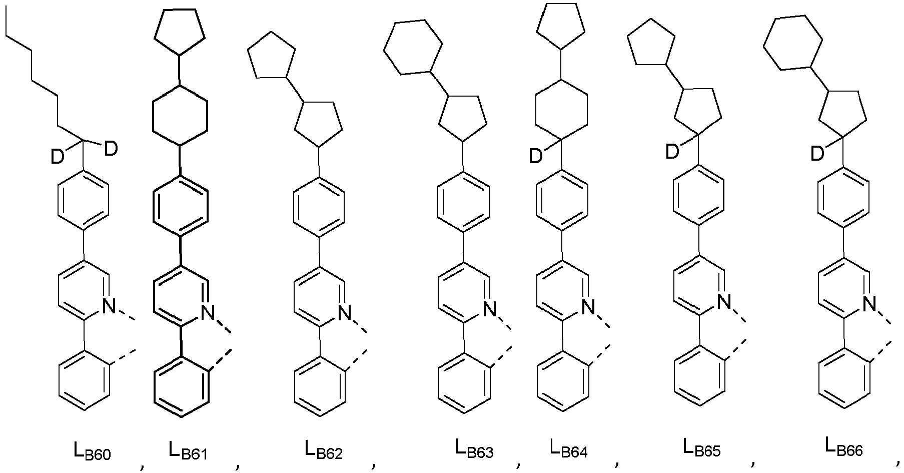 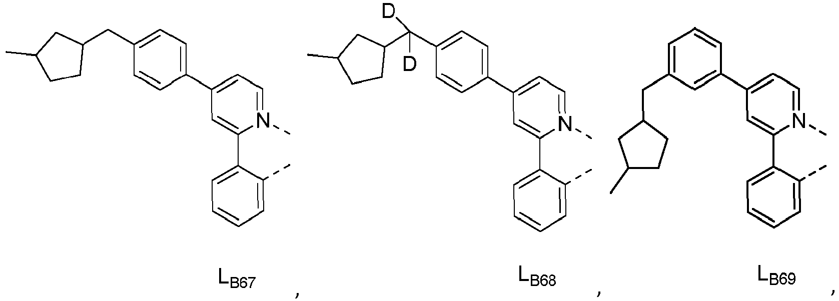 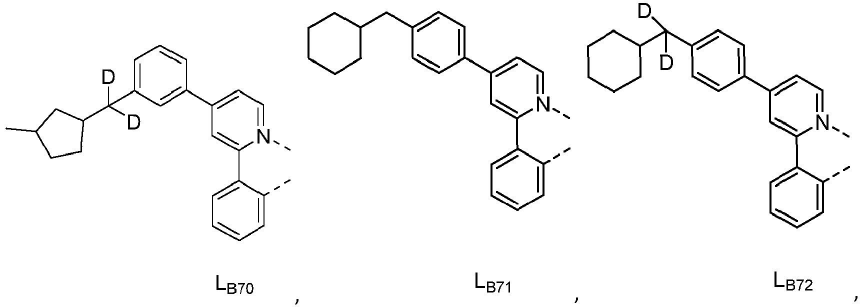 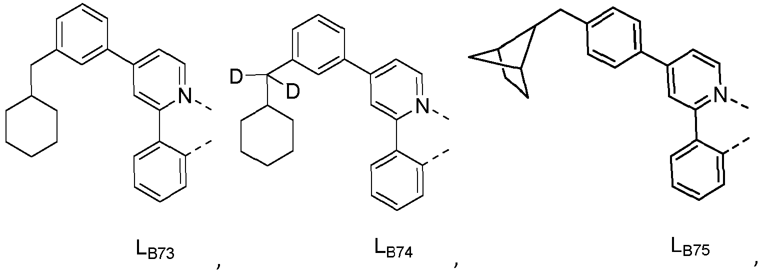 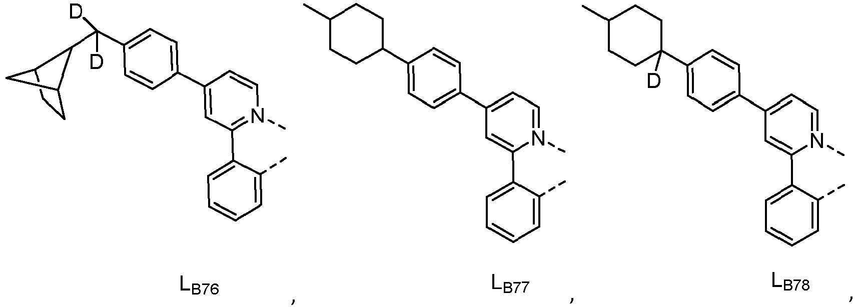 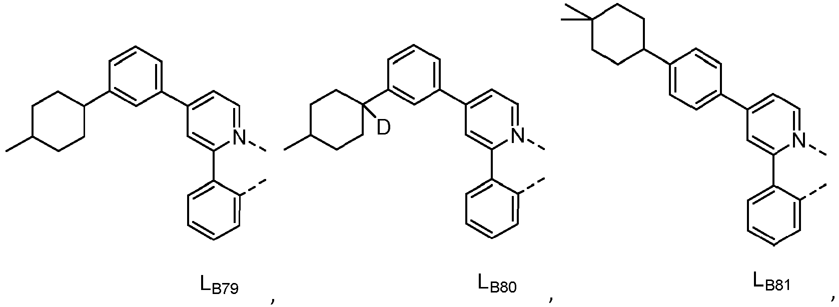 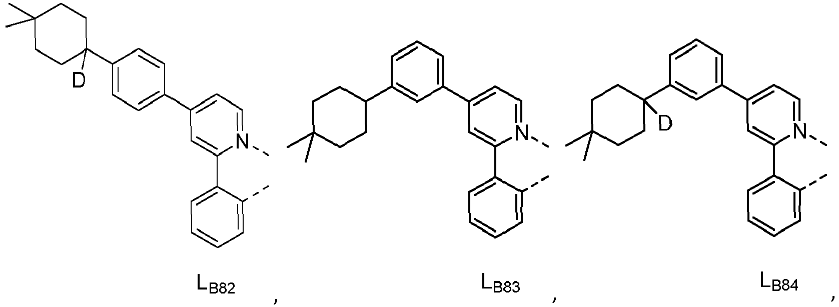 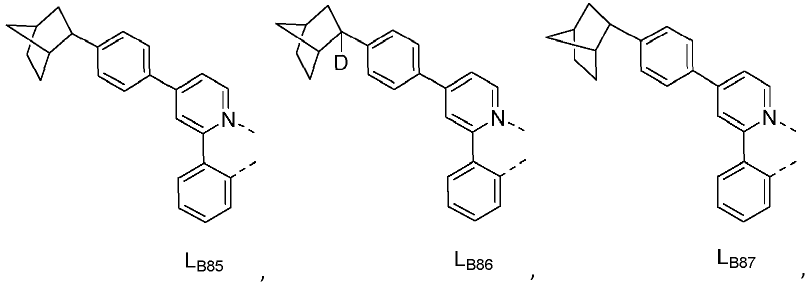 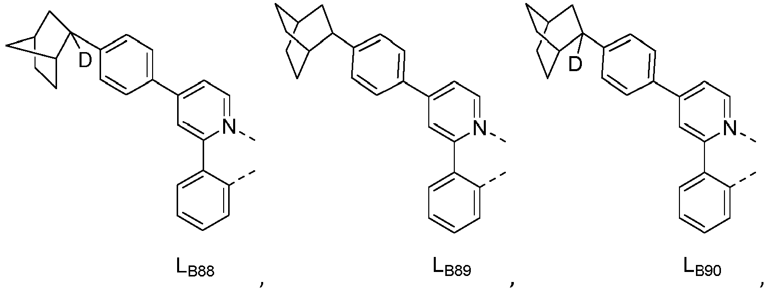 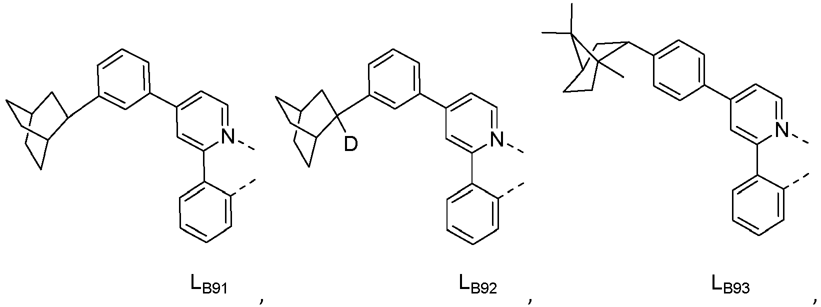 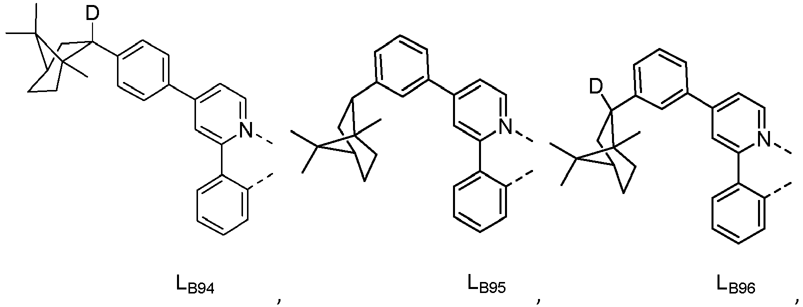 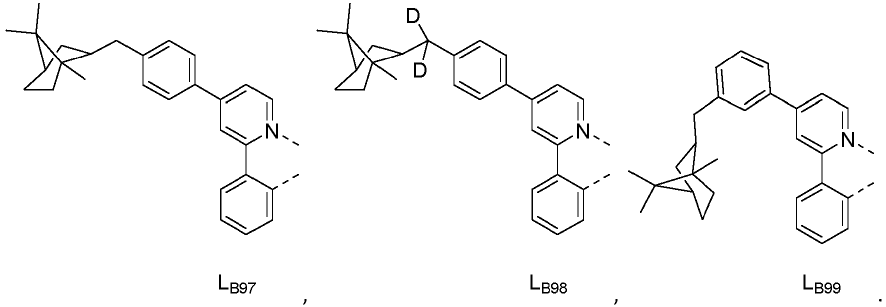 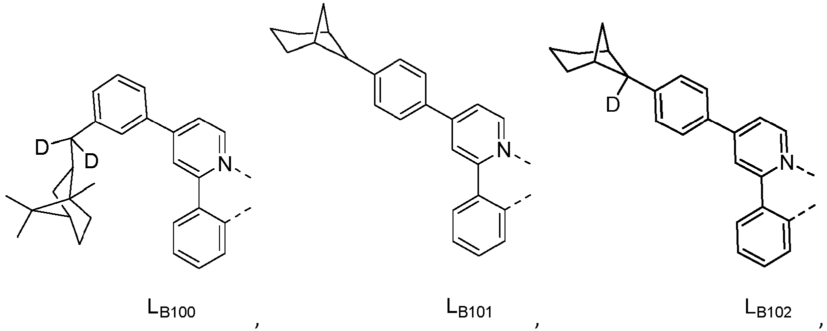 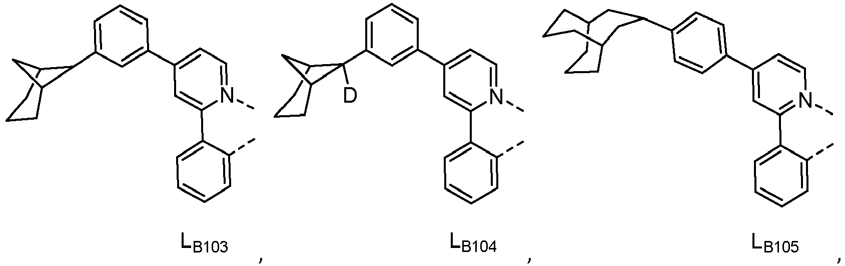 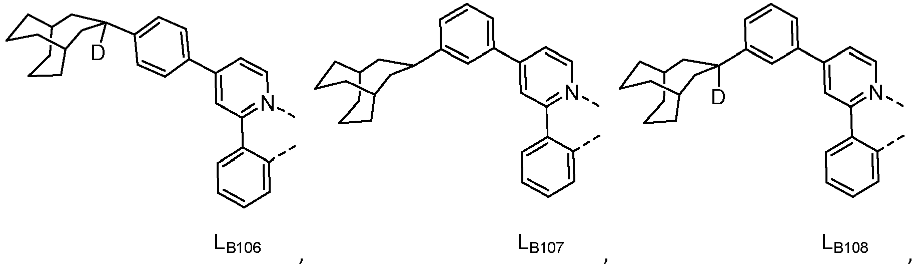 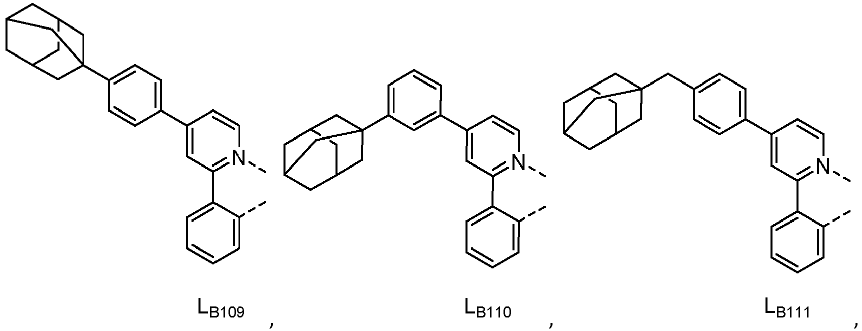 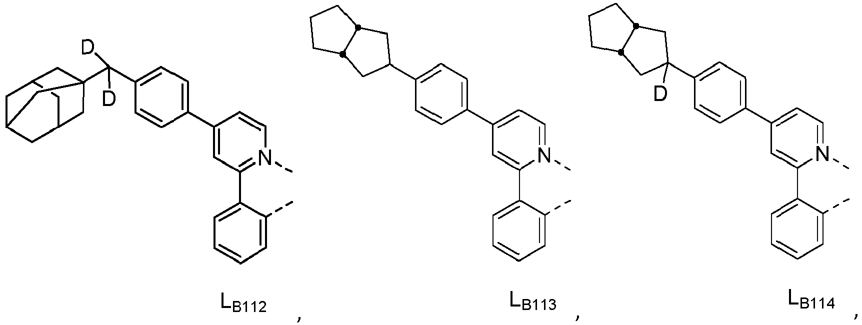 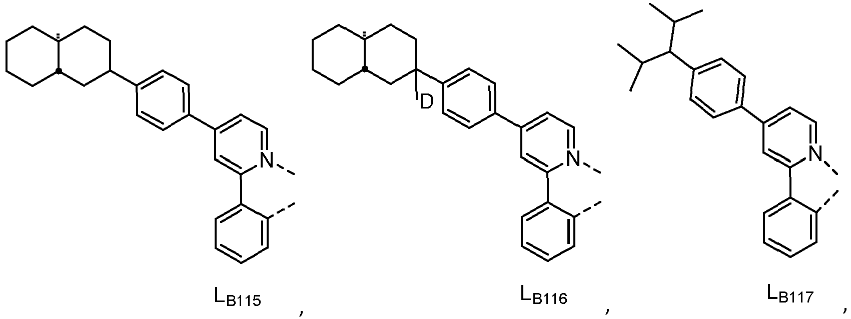 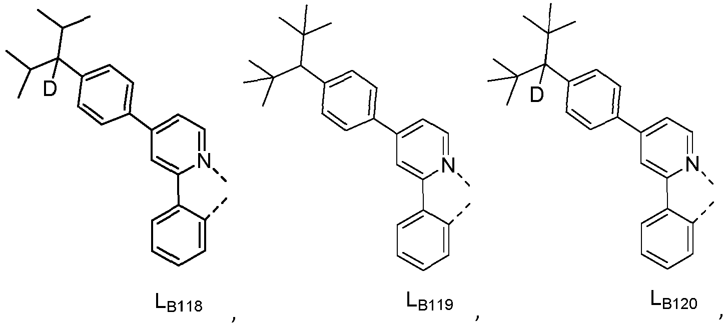 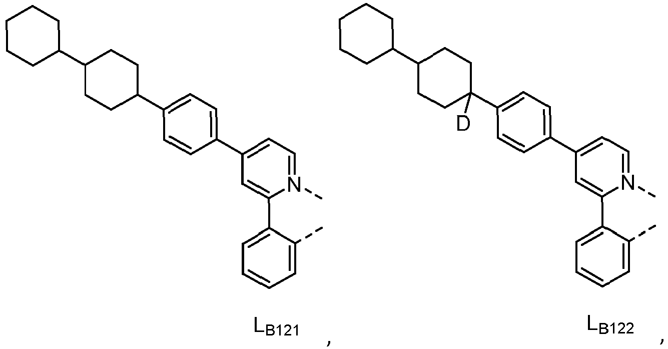 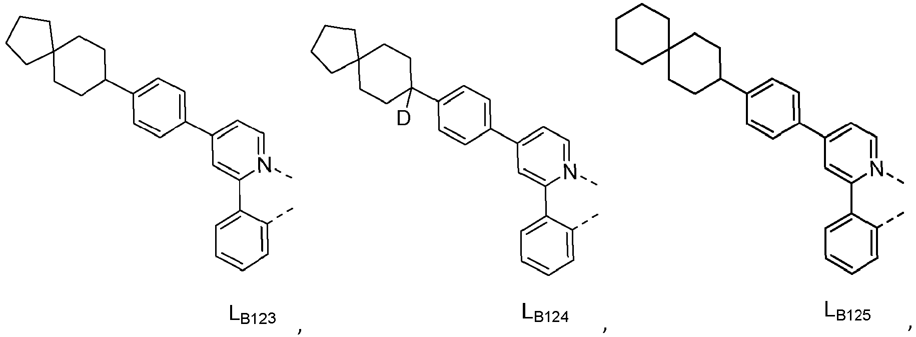 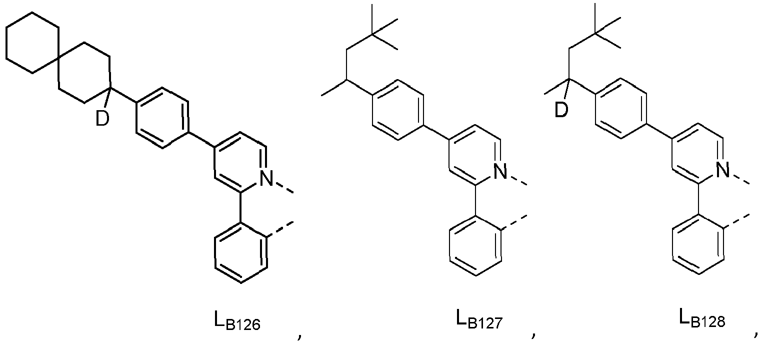 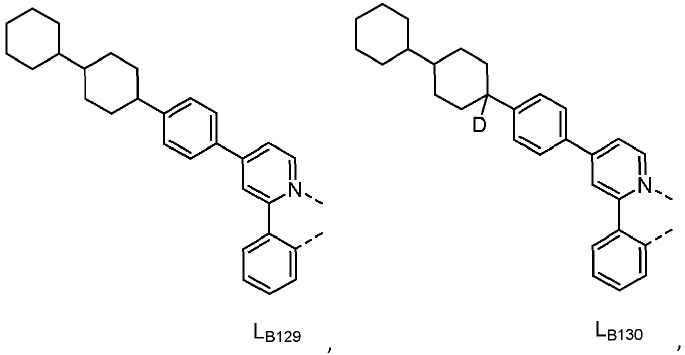 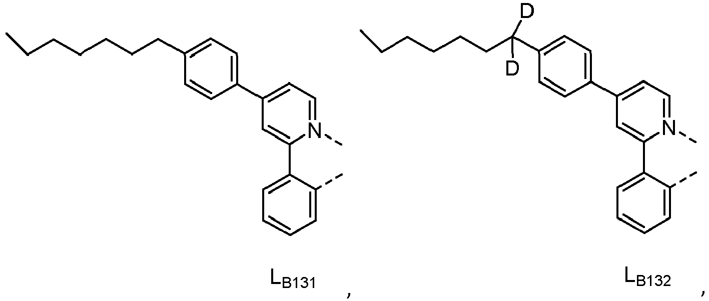 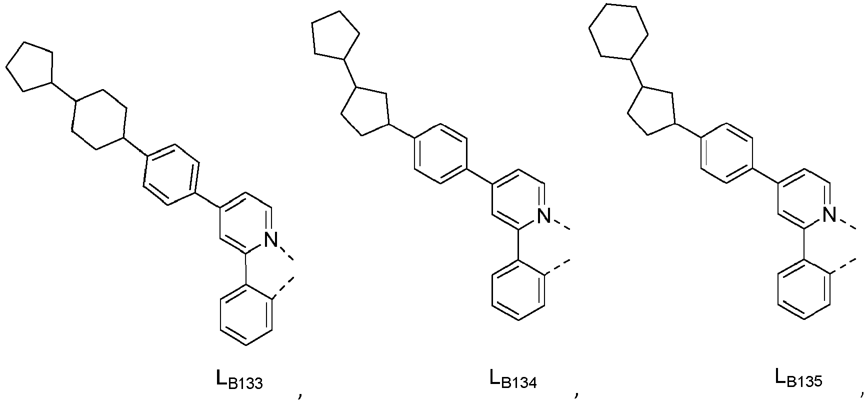 and

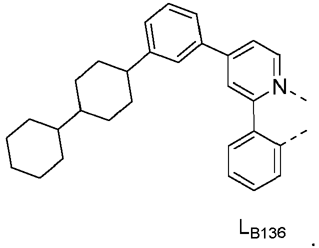

According to the present invention a compound having a formula (L_{A})ₘIr(L_{B})₃₋ₘ is disclosed wherein the compound has a structure selected from the group consisting of: 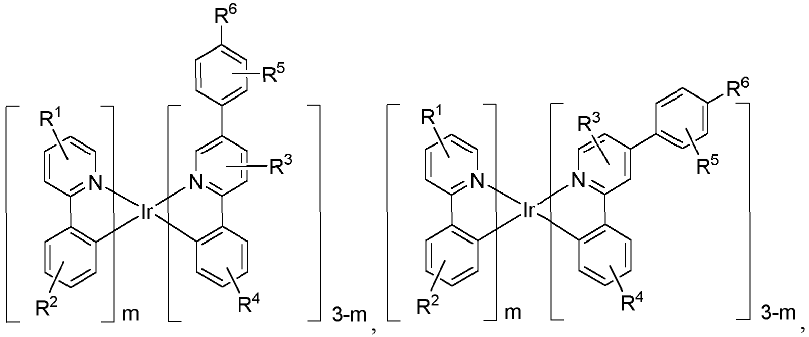 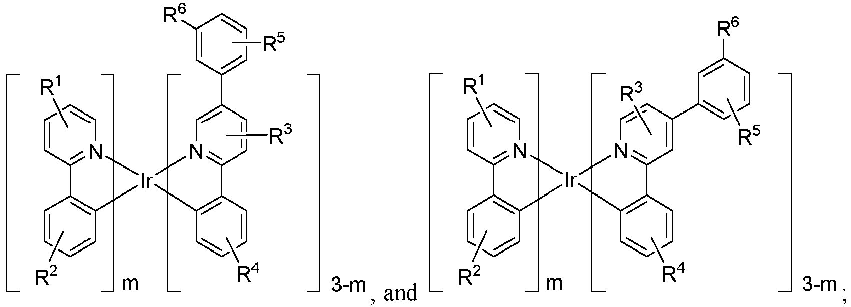
wherein m is 1 or 2;
wherein R¹, R², R⁴, and R⁵ each independently represent mono, di, tri, or tetra substitution, or no substitution;
wherein R³ represents mono, di, or tri substitution, or no substitution.

R¹, R², R³, R⁴, and R⁵ are each independently selected from the group consisting of hydrogen, deuterium, C1 to C6 alkyl, C1 to C6 cycloalkyl, and partially or fully deuterated or fluorinated variants thereof; and R⁶ is selected from the group consisting of alkyl having at least seven carbon atoms, cycloalkyl having at least seven carbon atoms, alkyl-cycloalkyl having at least seven carbon atoms, and partially or fully deuterated or fluorinated variants thereof.

In some embodiments of the compound, m is 2.

In some embodiments of the compound, R¹, R², R³, R⁴, and R⁵ are each independently selected from the group consisting of hydrogen, deuterium, methyl, ethyl, propyl, isopropyl, and combinations thereof.

In some embodiments of the compound, R³, R⁴, and R⁵ are each a hydrogen.

In some embodiments of the compound, L_{A} is selected from the group listed above.

In some embodiments of the compound, L_{B} is selected from the group listed above.

According to another aspect of the present disclosure, an OLED is disclosed that comprises: an anode; a cathode; and an organic layer, disposed between the anode and the cathode, wherein the organic layer comprises a compound having a formula (L_{A})ₘIr(L_{B})₃ₘ as defined above..

In some embodiments, the OLED is incorporated into a device selected from the group consisting of a consumer product, an electronic component module, and a lighting panel.

In some embodiments of the OLED, the organic layer is an emissive layer and the compound can be an emissive dopant or a non-emissive dopant.

As discussed in conjunction with the device structure shown in FIG. 1, there can be other functional layers of the OLED provided between the organic layer and the anode and/or the organic layer and the cathode. Therefore depending on the particular embodiment, the organic layer containing the novel compound of the present disclosure can be directly deposited directly on the electrode substrate or on an intervening layer..

In some embodiments of the OLED, the organic layer further comprises a host, wherein the host comprises a triphenylene containing benzo-fused thiophene or benzo-fused furan; wherein any substituent in the host is an unfused substituent independently selected from the group consisting of CₙH₂ₙ₊₁, OCₙH₂ₙ₊₁, OAr₁, N(CₙH₂ₙ₊₁)₂, N(Ar₁)(Ar₂), CH=CH-CₙH₂ₙ₊₁, C≡CCₙH₂ₙ₊₁, Ar₁, Ar₁-Ar₂, CₙH₂ₙ-Ar₁, or no substitution; wherein n is from 1 to 10; and wherein Ar₁ and Ar₂ are independently selected from the group consisting of benzene, biphenyl, naphthalene, triphenylene, carbazole, and heteroaromatic analogs thereof.

In some embodiments of the OLED, the organic layer further comprises a host, wherein the host comprises at least one chemical group selected from the group consisting of triphenylene, carbazole, dibenzothiophene, dibenzofuran, dibenzoselenophene, azatriphenylene, azacarbazole, aza-dibenzothiophene, aza-dibenzofuran, and aza-dibenzoselenophene.

In some embodiments of the OLED, the organic layer further comprises a host, wherein the host is selected from the group consisting of: 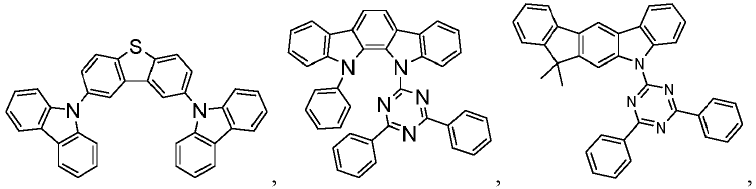 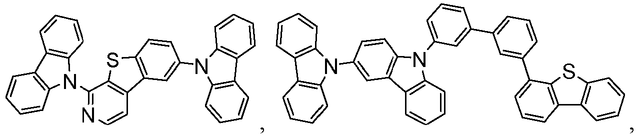 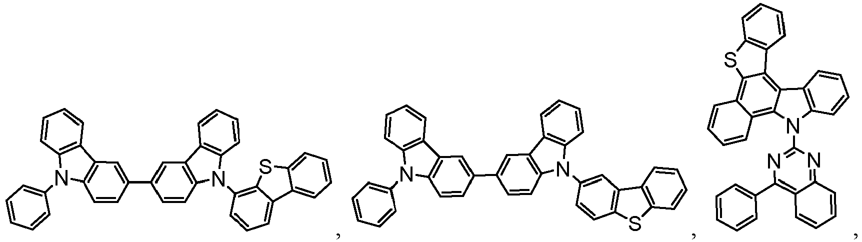 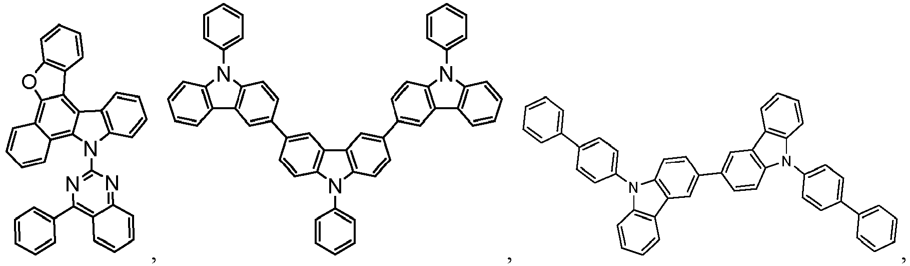 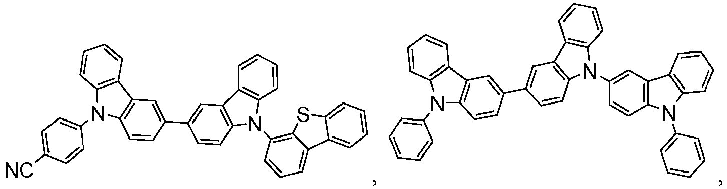 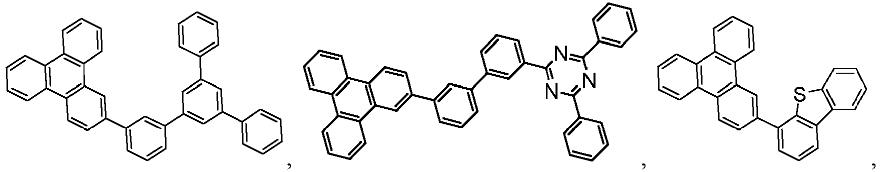 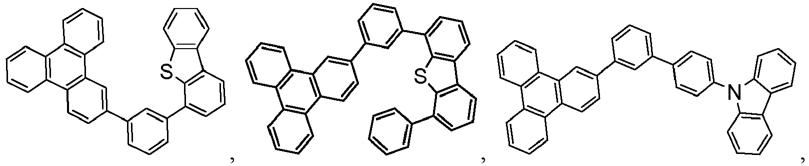 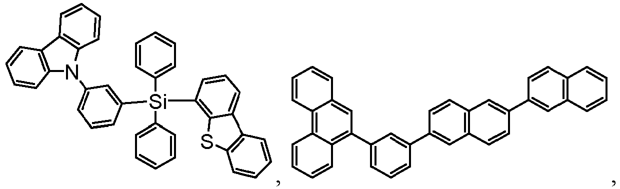 and combinations thereof.

In some embodiments of the OLED, the organic layer further comprises a host, wherein the host comprises a metal complex.

In some embodiments, two or more hosts are preferred. In some embodiments, the hosts used maybe a) bipolar, b) electron transporting, c) hole transporting or d) wide band gap materials that play little role in charge transport. Additional information on possible hosts is provided below.

In some embodiments, the compound can be an emissive dopant. In some embodiments, the compound can produce emissions via phosphorescence, fluorescence, thermally activated delayed fluorescence, i.e., TADF (also referred to as E-type delayed fluorescence), triplet-triplet annihilation, or combinations of these processes.

The organic layer can be an emissive layer and the compound can be an emissive dopant in some embodiments, while the compound can be a non-emissive dopant in other embodiments.

### COMBINATION WITH OTHER MATERIALS

The materials described herein as useful for a particular layer in an organic light emitting device may be used in combination with a wide variety of other materials present in the device. For example, emissive dopants disclosed herein may be used in conjunction with a wide variety of hosts, transport layers, blocking layers, injection layers, electrodes and other layers that may be present. The materials described or referred to below are examples of materials that may be useful in combination with the compounds disclosed herein, and one of skill in the art can readily consult the literature to identify other materials that may be useful in combination.

### Conductivity Dopants:

A charge transport layer can be doped with conductivity dopants to substantially alter its density of charge carriers, which will in turn alter its conductivity. The conductivity is increased by generating charge carriers in the matrix material, and depending on the type of dopant, a change in the Fermi level of the semiconductor may also be achieved. Hole-transporting layer can be doped by p-type conductivity dopants and n-type conductivity dopants are used in the electron-transporting layer.

Examples of the conductivity dopants that may be used in an OLED in combination with materials disclosed herein are exemplified below together with references that disclose those materials: EP01617493, EP01968131, EP2020694, EP2684932, US20050139810, US20070160905, US20090167167, US2010288362, WO06081780, WO2009003455, WO2009008277, WO2009011327, WO2014009310, US2007252140, US2015060804 and US2012146012.

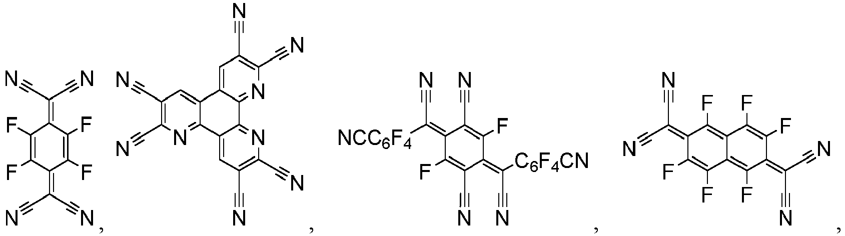

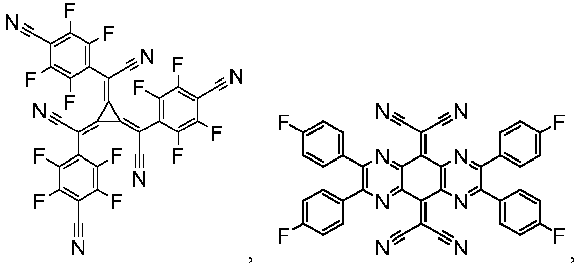

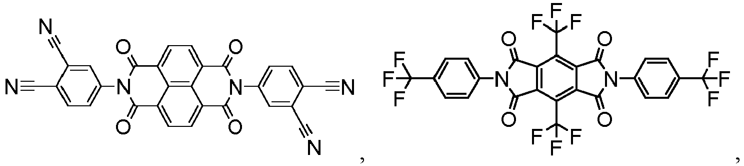

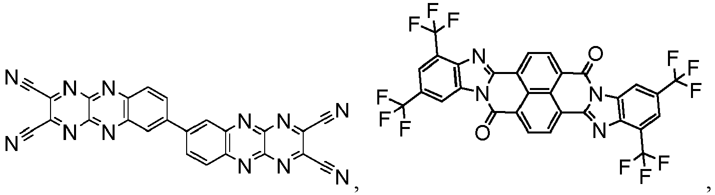

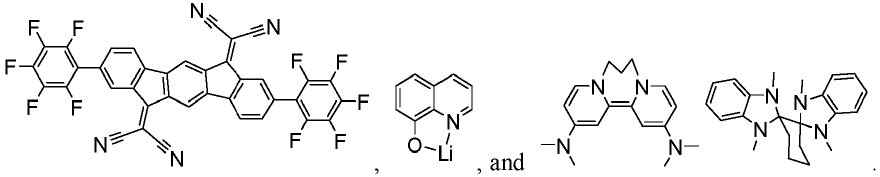

### HIL/HTL:

A hole injecting/transporting material to be used in the present invention is not particularly limited, and any compound may be used as long as the compound is typically used as a hole injecting/transporting material. Examples of the material include: a phthalocyanine or porphyrin derivative; an aromatic amine derivative; an indolocarbazole derivative; a polymer containing fluorohydrocarbon; a polymer with conductivity dopants; a conducting polymer, such as PEDOT/PSS; a self-assembly monomer derived from compounds such as phosphonic acid and silane derivatives; a metal oxide derivative, such as MoOₓ; a p-type semiconducting organic compound, such as 1,4,5,8,9,12-Hexaazatriphenylenehexacarbonitrile; a metal complex, and a cross-linkable compounds.

Examples of aromatic amine derivatives used in HIL or HTL include, but not limit to the following general structures:

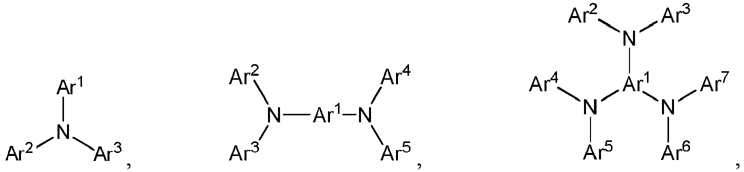

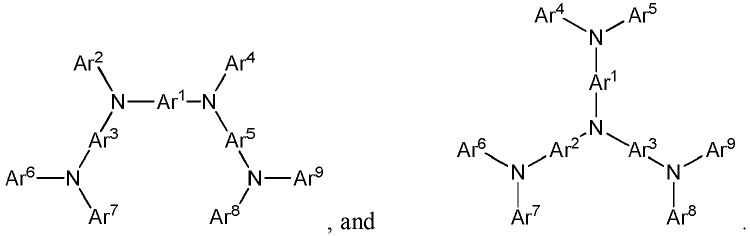

Each of Ar¹ to Ar⁹ is selected from the group consisting of aromatic hydrocarbon cyclic compounds such as benzene, biphenyl, triphenyl, triphenylene, naphthalene, anthracene, phenalene, phenanthrene, fluorene, pyrene, chrysene, perylene, and azulene; the group consisting of aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine; and the group consisting of 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Each Ar may be unsubstituted or may be substituted by a substituent selected from the group consisting of deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof.

In one aspect, Ar¹ to Ar⁹ is independently selected from the group consisting of: 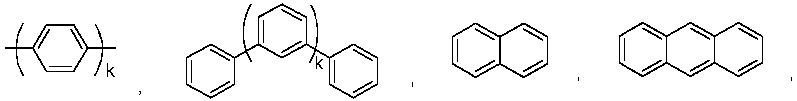 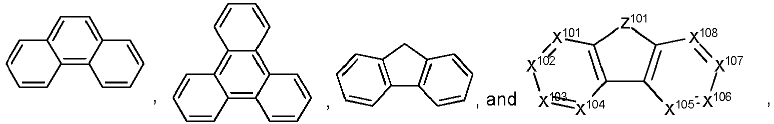 wherein k is an integer from 1 to 20; X¹⁰¹ to X¹⁰⁸ is C (including CH) or N; Z¹⁰¹ is NAr¹, O, or S; Ar¹ has the same group defined above.

Examples of metal complexes used in HIL or HTL include the following general formula: 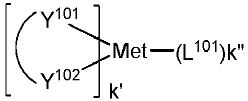 wherein Met is a metal, which can have an atomic weight greater than 40; (Y¹⁰¹-Y¹⁰²) is a bidentate ligand, Y¹⁰¹ and Y¹⁰² are independently selected from C, N, O, P, and S; L¹⁰¹ is an ancillary ligand; k' is an integer value from 1 to the maximum number of ligands that may be attached to the metal; and k'+k" is the maximum number of ligands that may be attached to the metal.

In one aspect, (Y¹⁰¹-Y¹⁰²) is a 2-phenylpyridine derivative. In another aspect, (Y¹⁰¹-Y¹⁰²) is a carbene ligand. In another aspect, Met is selected from Ir, Pt, Os, and Zn. In a further aspect, the metal complex has a smallest oxidation potential in solution vs. Fc⁺/Fc couple less than about 0.6 V.

Examples of the HIL and HTL materials that may be used in an OLED in combination with materials disclosed herein are exemplified below together with references that disclose those materials: CN102702075, DE102012005215, EP01624500, EP01698613, EP01806334, EP01930964, EP01972613, EP01997799, EP02011790, EP02055700, EP02055701, EP1725079, EP2085382, EP2660300, EP650955, JP07-073529, JP2005112765, JP2007091719, JP2008021687, JP2014-009196, KR20110088898, KR20130077473, TW201139402, US06517957, US20020158242, US20030162053, US20050123751, US20060182993, US20060240279, US20070145888, US20070181874, US20070278938, US20080014464, US20080091025, US20080106190, US20080124572, US20080145707, US20080220265, US20080233434, US20080303417, US2008107919, US20090115320, US20090167161, US2009066235, US2011007385, US20110163302, US2011240968, US2011278551, US2012205642, US2013241401, US20140117329, US2014183517, US5061569, US5639914, WO05075451, WO07125714, WO08023550, WO08023759, WO2009145016, WO2010061824, WO2011075644, WO2012177006, WO2013018530, WO2013039073, WO2013087142, WO2013118812, WO2013120577, WO2013157367, WO2013175747, WO2014002873, WO2014015935, WO2014015937, WO2014030872, WO2014030921, WO2014034791, WO2014104514, WO2014157018. 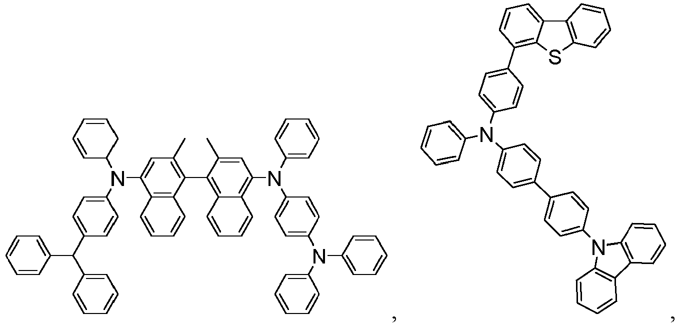 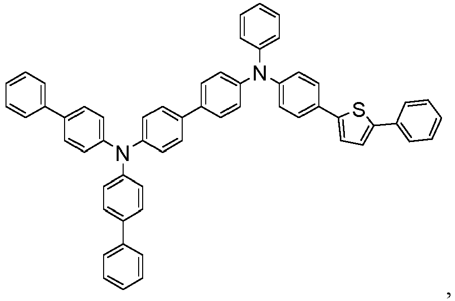 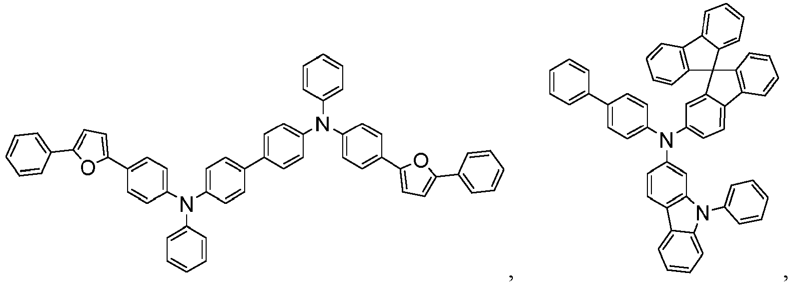 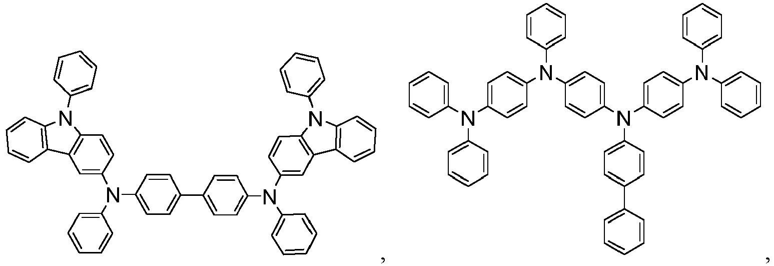 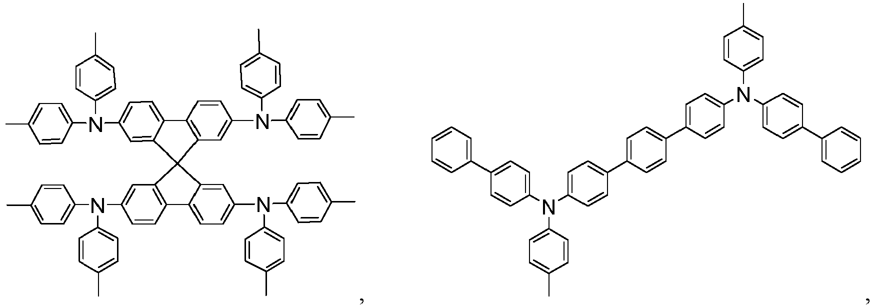 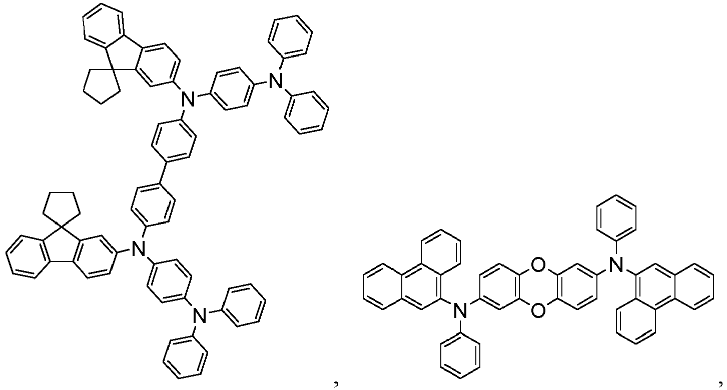 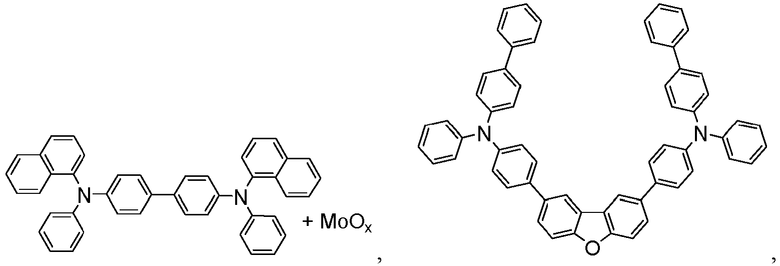 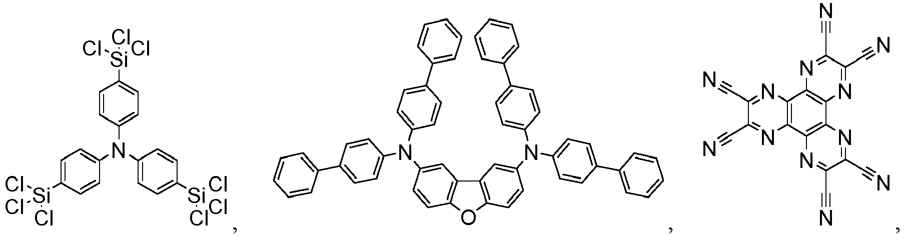 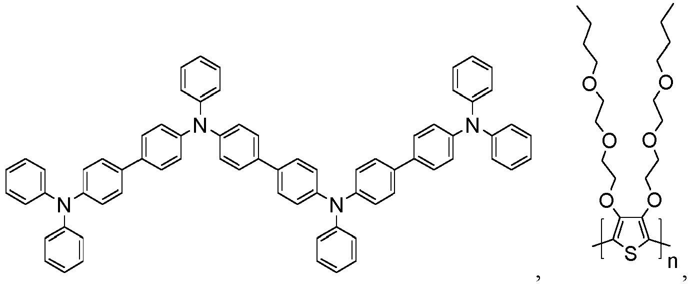 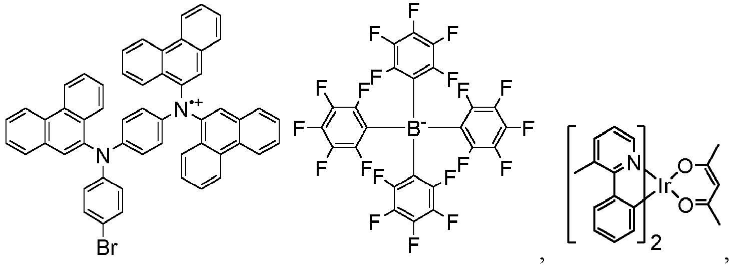 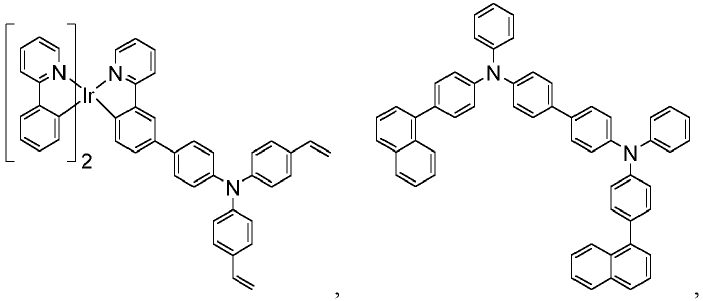 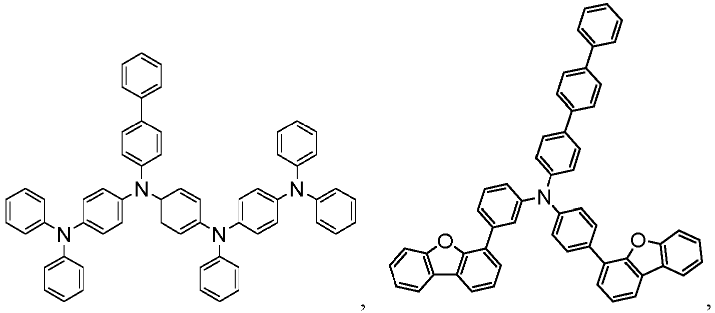 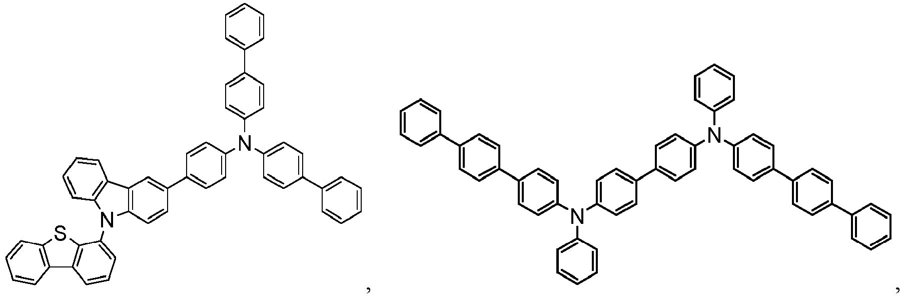 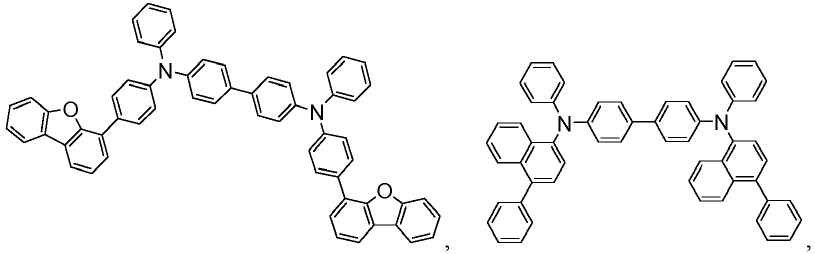 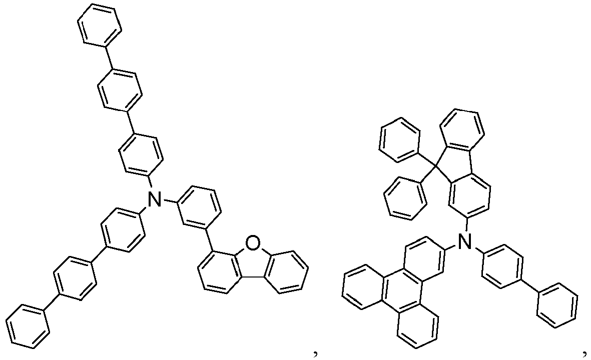 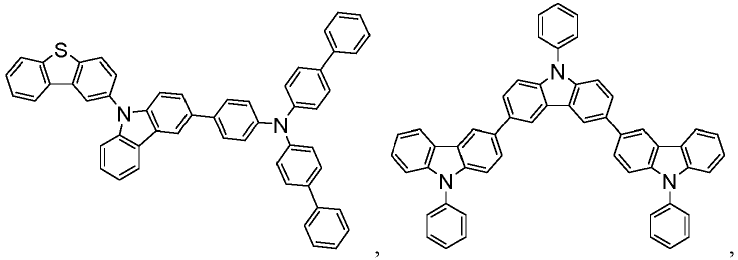 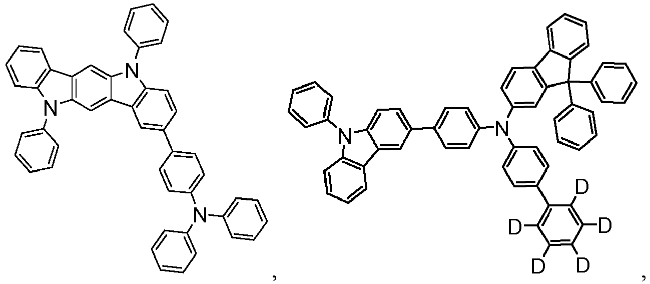 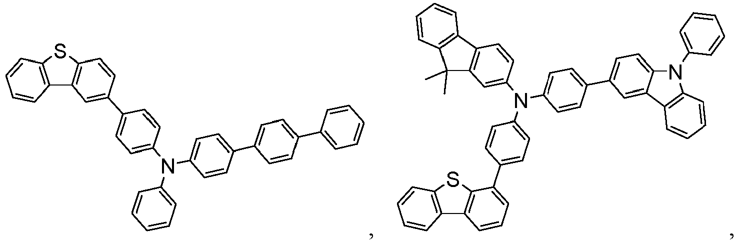 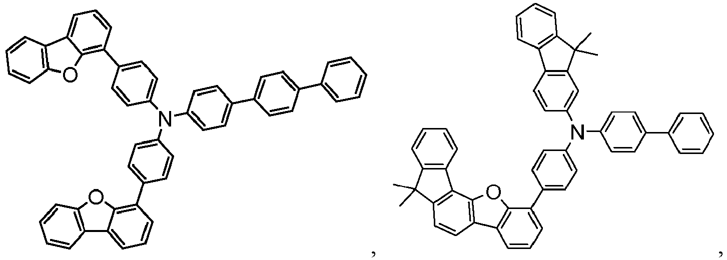 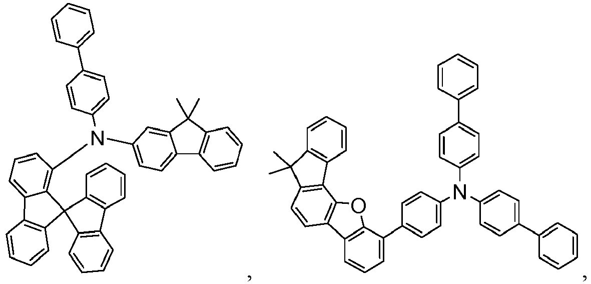 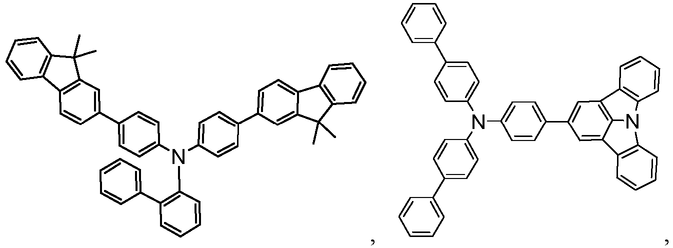 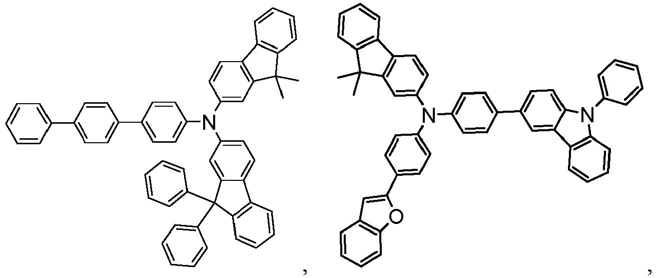 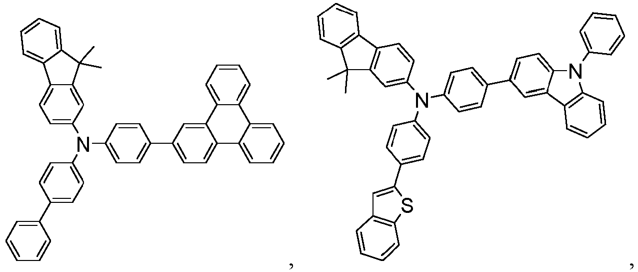 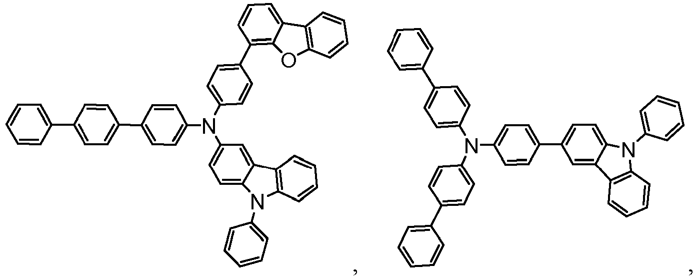 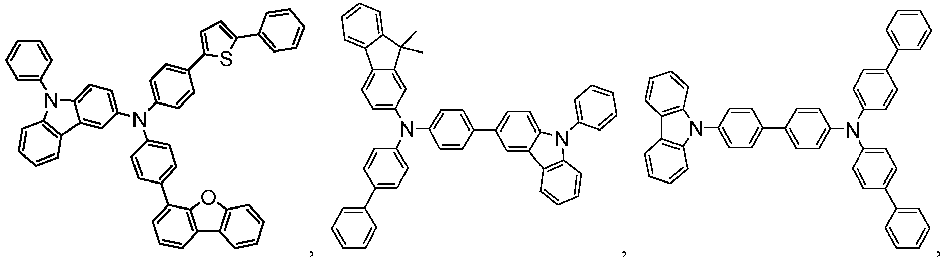 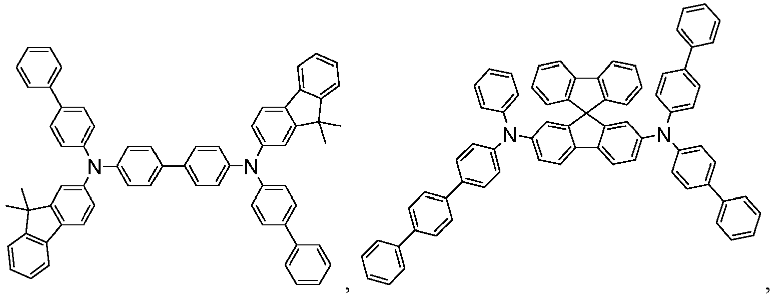 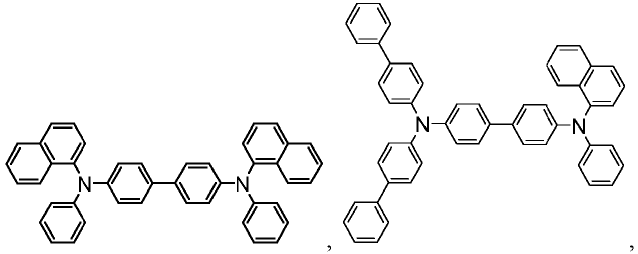 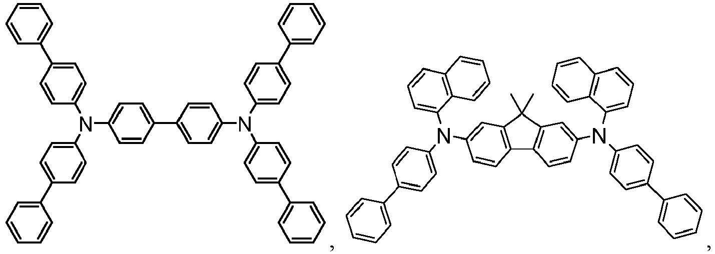 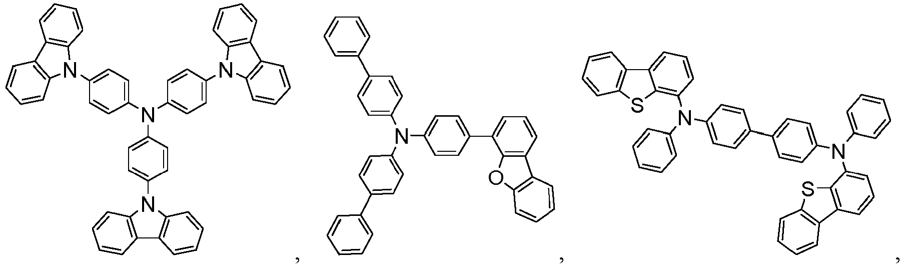 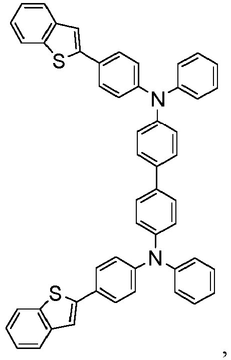 and

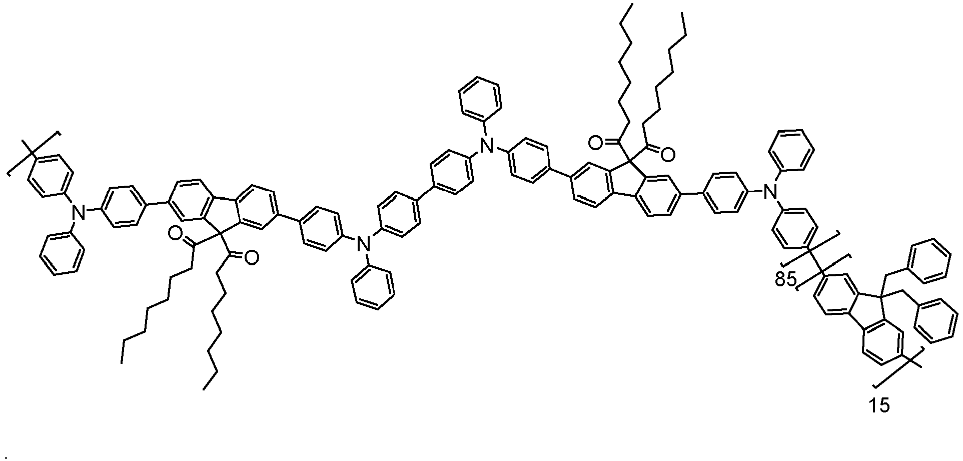

### EBL:

An electron blocking layer (EBL) may be used to reduce the number of electrons and/or excitons that leave the emissive layer. The presence of such a blocking layer in a device may result in substantially higher efficiencies, and/or longer lifetime, as compared to a similar device lacking a blocking layer. Also, a blocking layer may be used to confine emission to a desired region of an OLED. In some embodiments, the EBL material has a higher LUMO (closer to the vacuum level) and/or higher triplet energy than the emitter closest to the EBL interface. In some embodiments, the EBL material has a higher LUMO (closer to the vacuum level) and or higher triplet energy than one or more of the hosts closest to the EBL interface. In one aspect, the compound used in EBL contains the same molecule or the same functional groups used as one of the hosts described below.

### Host:

The light emitting layer of the organic EL device of the present invention preferably contains at least a metal complex as light emitting material, and may contain a host material using the metal complex as a dopant material. Examples of the host material are not particularly limited, and any metal complexes or organic compounds may be used as long as the triplet energy of the host is larger than that of the dopant. Any host material may be used with any dopant so long as the triplet criteria is satisfied.

Examples of metal complexes used as host are preferred to have the following general formula: 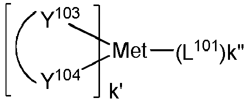 wherein Met is a metal; (Y¹⁰³-Y¹⁰⁴) is a bidentate ligand, Y¹⁰³ and Y¹⁰⁴ are independently selected from C, N, O, P, and S; L¹⁰¹ is an another ligand; k' is an integer value from 1 to the maximum number of ligands that may be attached to the metal; and k'+k" is the maximum number of ligands that may be attached to the metal.

In one aspect, the metal complexes are: 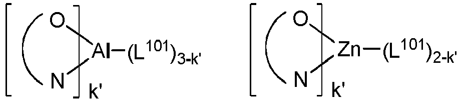 wherein (O-N) is a bidentate ligand, having metal coordinated to atoms O and N.

In another aspect, Met is selected from Ir and Pt. In a further aspect, (Y¹⁰³-Y¹⁰⁴) is a carbene ligand.

Examples of other organic compounds used as host are selected from the group consisting of aromatic hydrocarbon cyclic compounds such as benzene, biphenyl, triphenyl, triphenylene, tetraphenylene, naphthalene, anthracene, phenalene, phenanthrene, fluorene, pyrene, chrysene, perylene, and azulene; the group consisting of aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine; and the group consisting of 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Each option within each group may be unsubstituted or may be substituted by a substituent selected from the group consisting of deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof.

In one aspect, the host compound contains at least one of the following groups in the molecule: 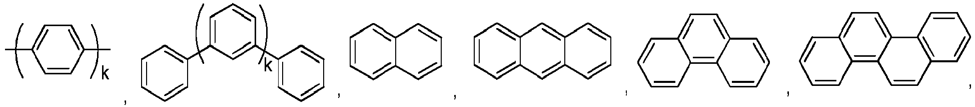 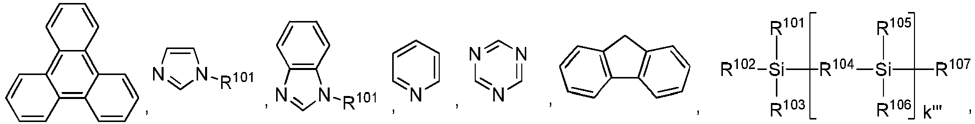 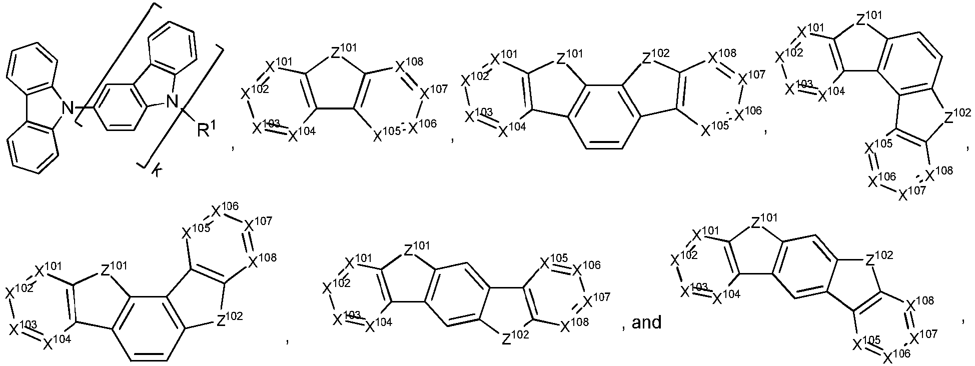 wherein each of R¹⁰¹ to R¹⁰⁷ is independently selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof, and when it is aryl or heteroaryl, it has the similar definition as Ar's mentioned above. k is an integer from 0 to 20 or 1 to 20; k'" is an integer from 0 to 20. X¹⁰¹ to X¹⁰⁸ is selected from C (including CH) or N.

Z¹⁰¹ and Z¹⁰² is selected from NR¹⁰¹, O, or S.

Examples of the host materials that may be used in an OLED in combination with materials disclosed herein are exemplified below together with references that disclose those materials: EP2034538, EP2034538A, EP2757608, JP2007254297, KR20100079458, KR20120088644, KR20120129733, KR20130115564, TW201329200, US20030175553, US20050238919, US20060280965, US20090017330, US20090030202, US20090167162, US20090302743, US20090309488, US20100012931, US20100084966, US20100187984, US2010187984, US2012075273, US2012126221, US2013009543, US2013105787, US2013175519, US2014001446, US20140183503, US20140225088, US2014034914, US7154114, WO2001039234, WO2004093207, WO2005014551, WO2005089025, WO2006072002, WO2006114966, WO2007063754, WO2008056746, WO2009003898, WO2009021126, WO2009063833, WO2009066778, WO2009066779, WO2009086028, WO2010056066, WO2010107244, WO2011081423, WO2011081431, WO2011086863, WO2012128298, WO2012133644, WO2012133649, WO2013024872, WO2013035275, WO2013081315, WO2013191404, WO2014142472,

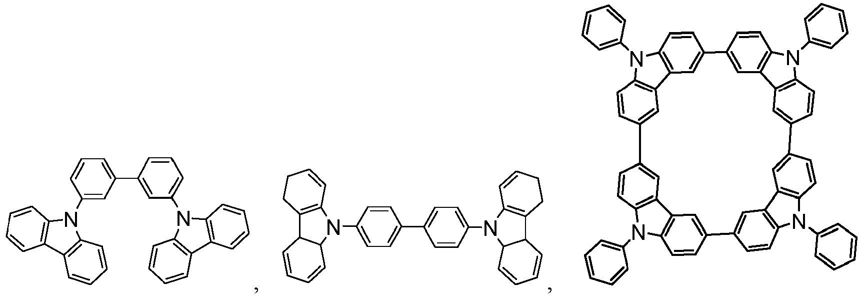

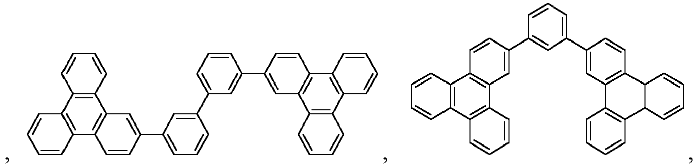

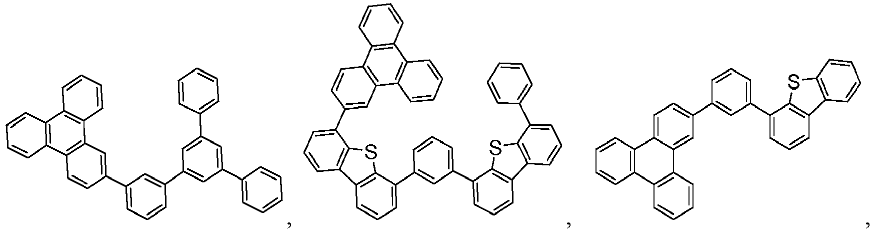

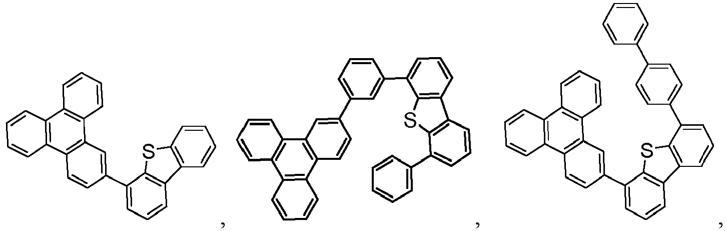

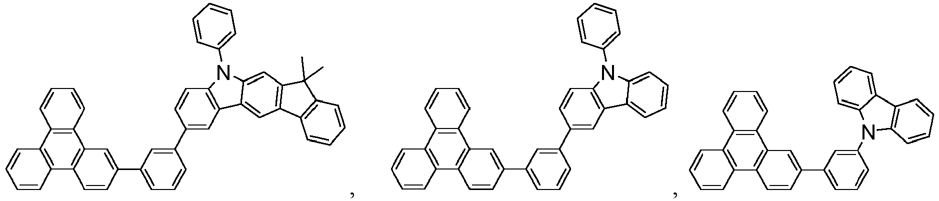

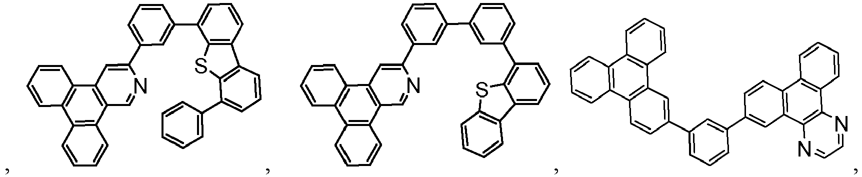

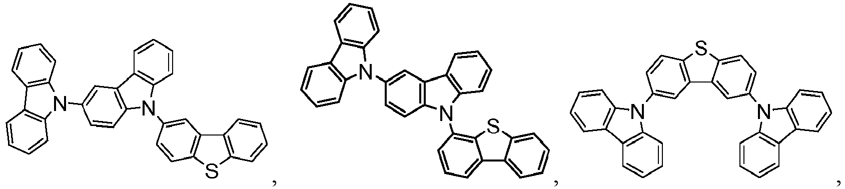

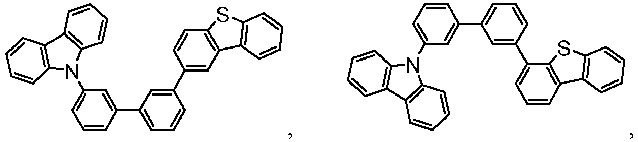

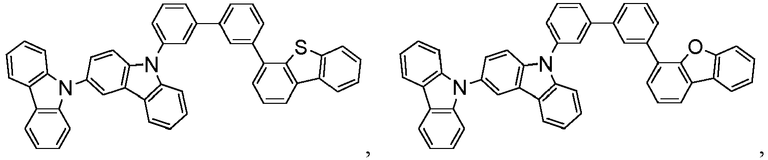

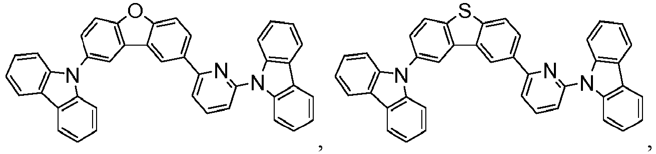

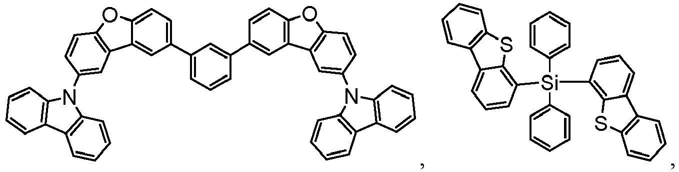

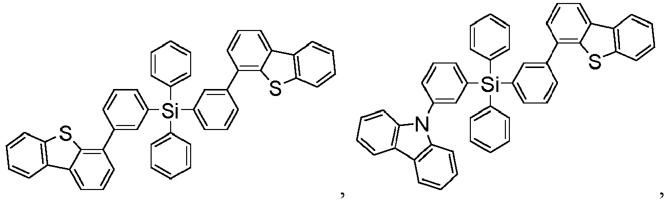

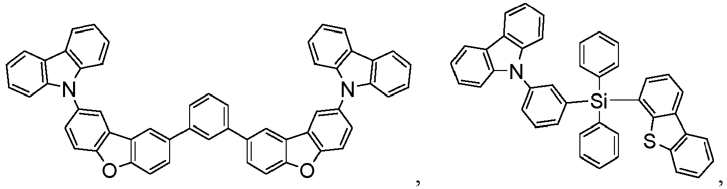

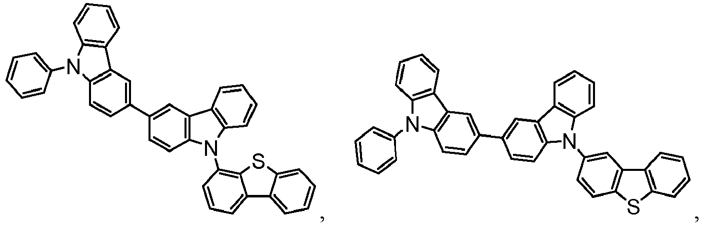

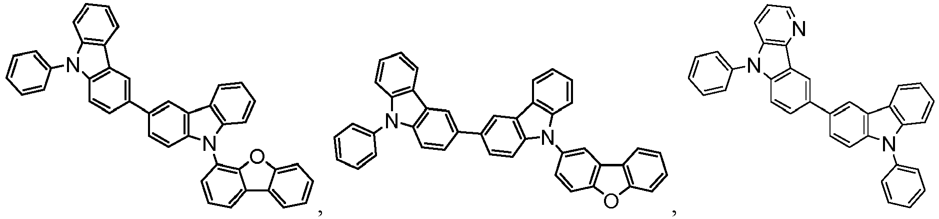

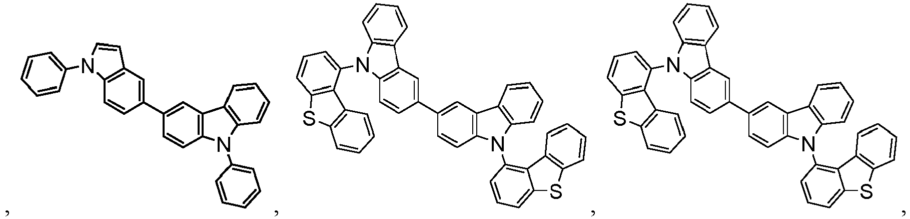

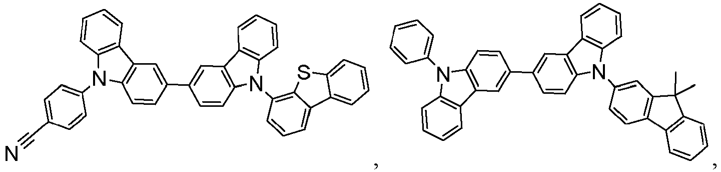

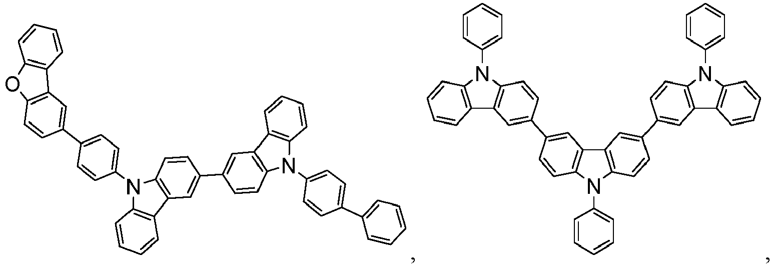

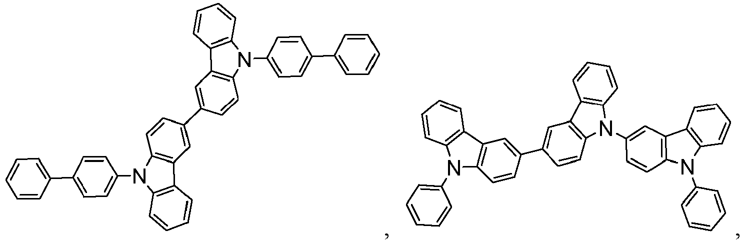

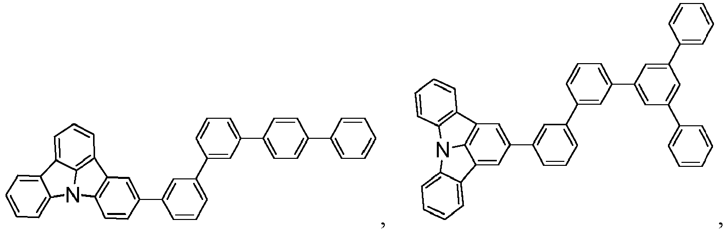

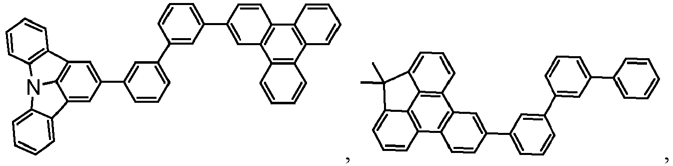

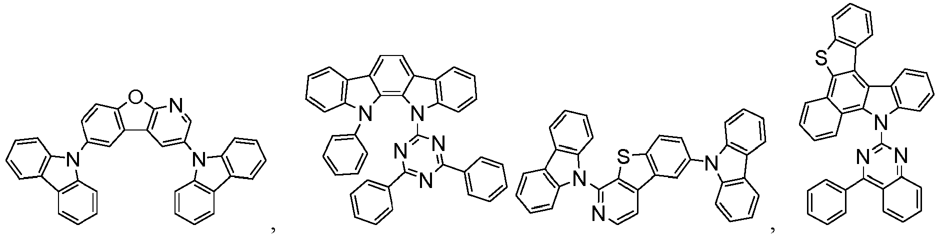

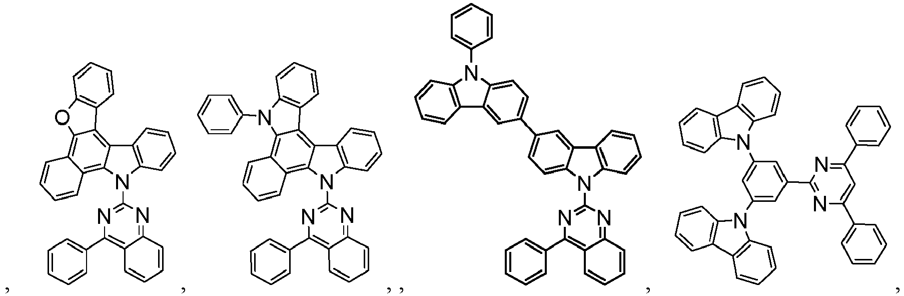

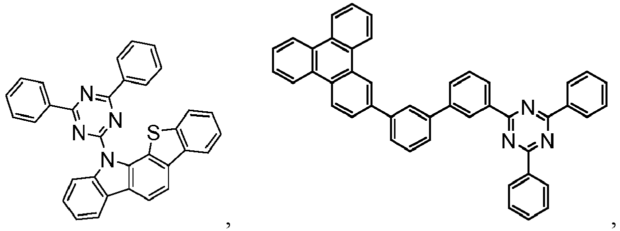

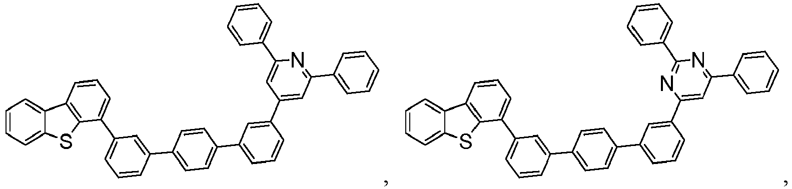

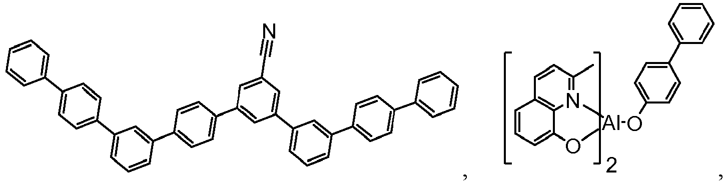

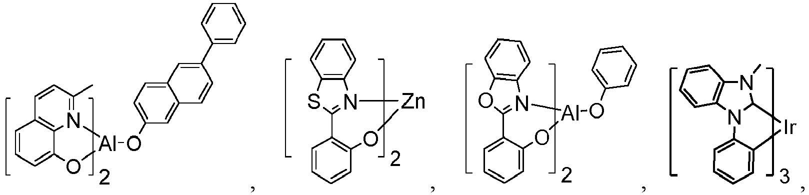

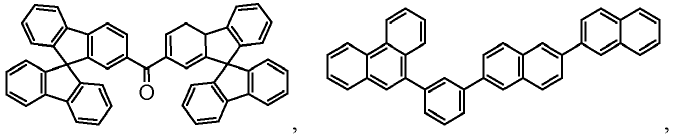

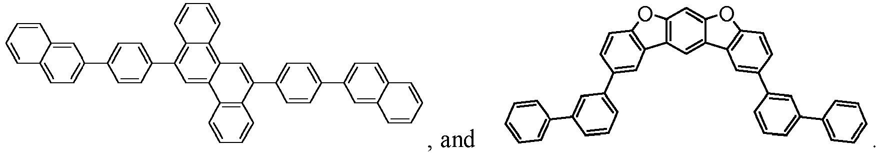

### Additional Emitters:

One or more additional emitter dopants may be used in conjunction with the compound of the present disclosure. Examples of the additional emitter dopants are not particularly limited, and any compounds may be used as long as the compounds are typically used as emitter materials. Examples of suitable emitter materials include compounds which can produce emissions via phosphorescence, fluorescence, thermally activated delayed fluorescence, i.e., TADF (also referred to as E-type delayed fluorescence), triplet-triplet annihilation, or combinations of these processes.

Examples of the emitter materials that may be used in an OLED in combination with materials disclosed herein are exemplified below together with references that disclose those materials: CN103694277, CN1696137, EB01238981, EP01239526, EP01961743, EP1239526, EP1244155, EP1642951, EP1647554, EP1841834, EP1841834B, EP2062907, EP2730583, JP2012074444, JP2013110263, JP4478555, KR1020090133652, KR20120032054, KR20130043460, TW201332980, US06699599, US06916554, US20010019782, US20020034656, US20030068526, US20030072964, US20030138657, US20050123788, US20050244673, US2005123791, US2005260449, US20060008670, US20060065890, US20060127696, US20060134459, US20060134462, US20060202194, US20060251923, US20070034863, US20070087321, US20070103060, US20070111026, US20070190359, US20070231600, US2007034863, US2007104979, US2007104980, US2007138437, US2007224450, US2007278936, US20080020237, US20080233410, US20080261076, US20080297033, US200805851, US2008161567, US2008210930, US20090039776, US20090108737, US20090115322, US20090179555, US2009085476, US2009104472, US20100090591, US20100148663, US20100244004, US20100295032, US2010102716, US2010105902, US2010244004, US2010270916, US20110057559, US20110108822, US20110204333, US2011215710, US2011227049, US2011285275, US2012292601, US20130146848, US2013033172, US2013165653, US2013181190, US2013334521, US20140246656, US2014103305, US6303238, US6413656, US6653654, US6670645, US6687266, US6835469, US6921915, US7279704, US7332232, US7378162, US7534505, US7675228, US7728137, US7740957, US7759489, US7951947, US8067099, US8592586, US8871361, WO06081973, WO06121811, WO07018067, WO07108362, WO07115970, WO07115981, WO08035571, WO2002015645, WO2003040257, WO2005019373, WO2006056418, WO2008054584, WO2008078800, WO2008096609, WO2008101842, WO2009000673, WO2009050281, WO2009100991, WO2010028151, WO2010054731, WO2010086089, WO2010118029, WO2011044988, WO2011051404, WO2011107491, WO2012020327, WO2012163471, WO2013094620, WO2013107487, WO2013174471, WO2014007565, WO2014008982, WO2014023377, WO2014024131, WO2014031977, WO2014038456, WO2014112450. 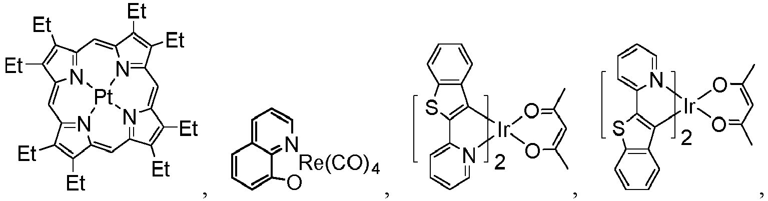 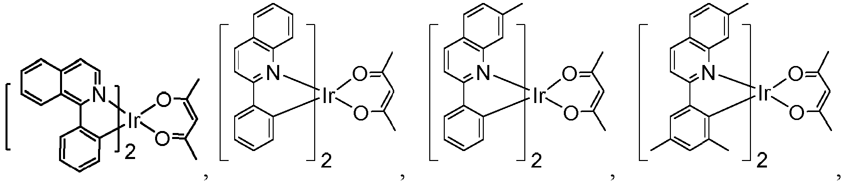 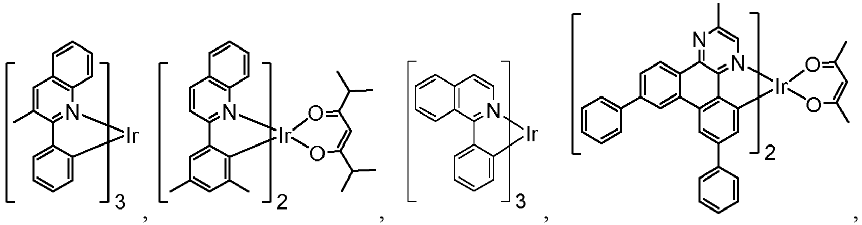 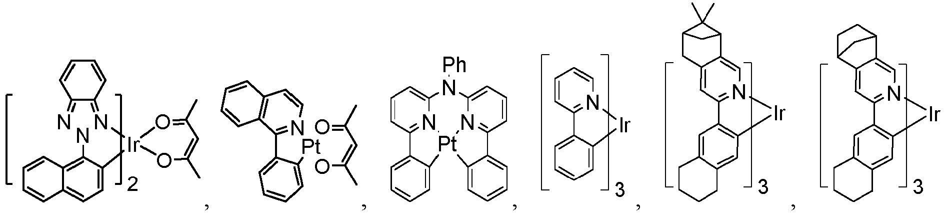 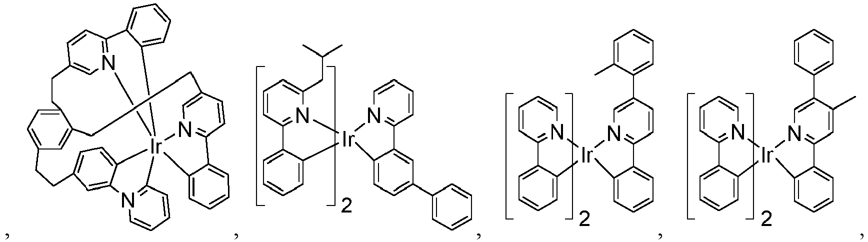 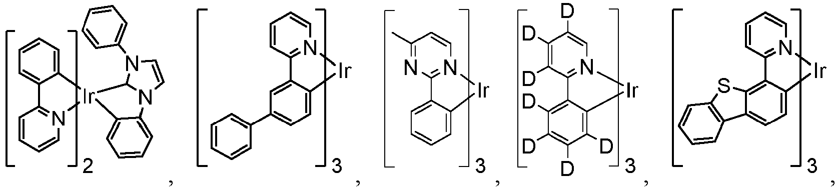 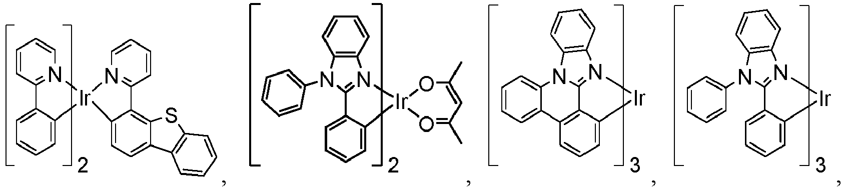 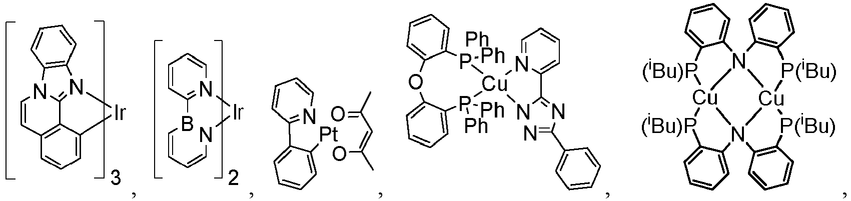 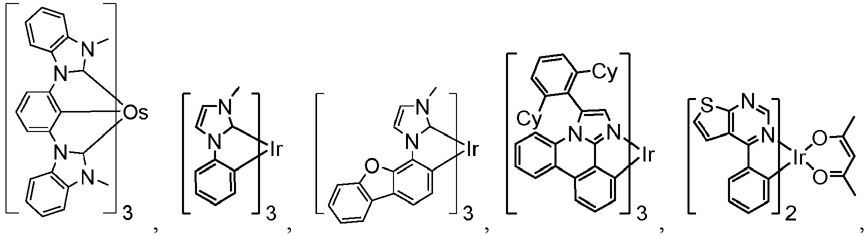 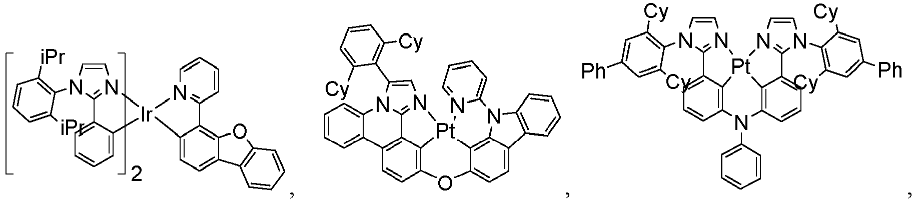 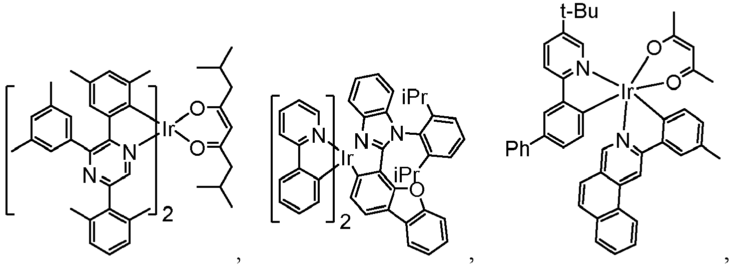 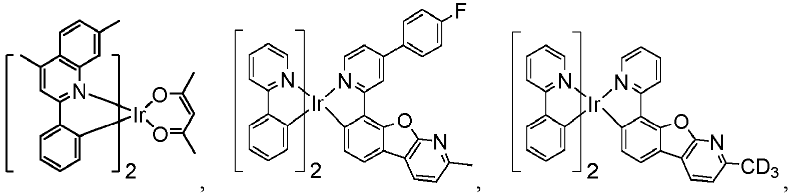 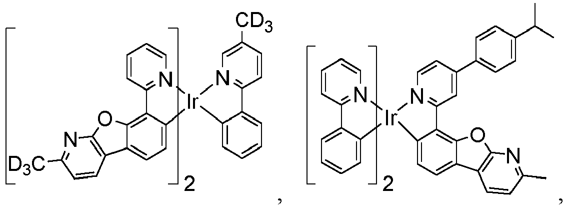 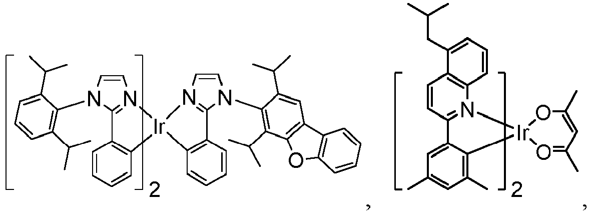 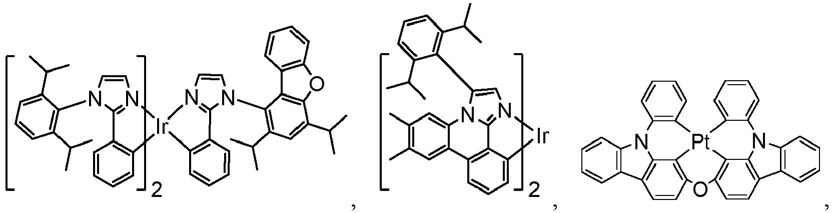 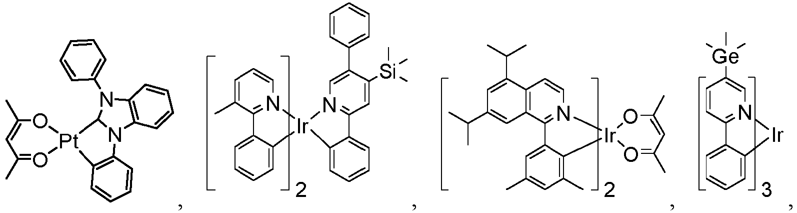 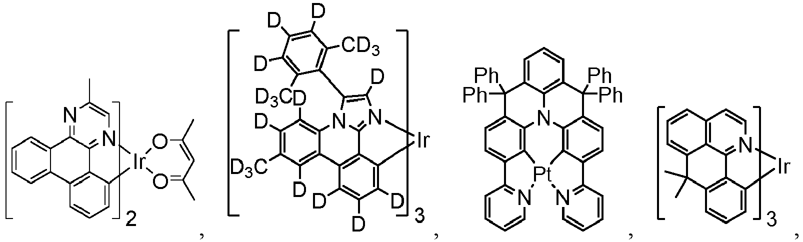 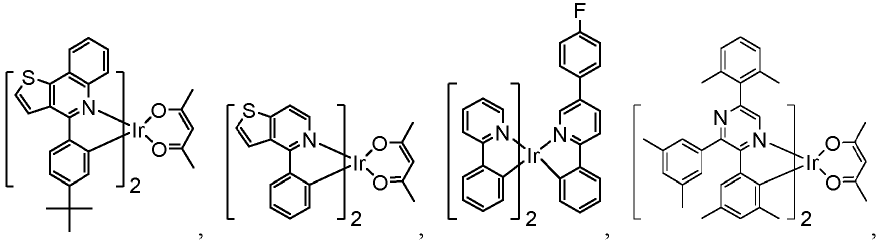 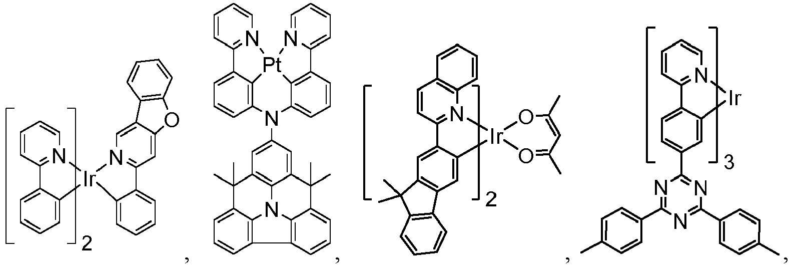 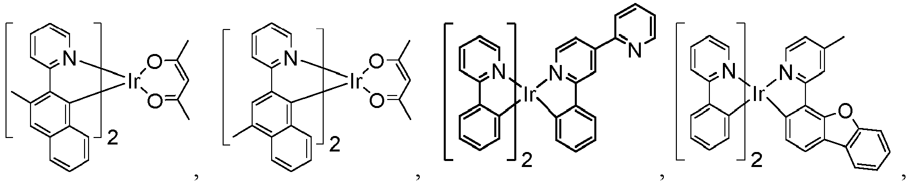 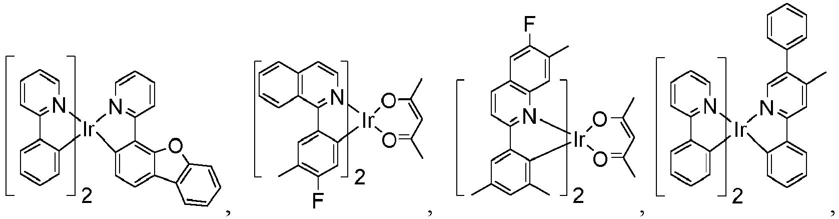 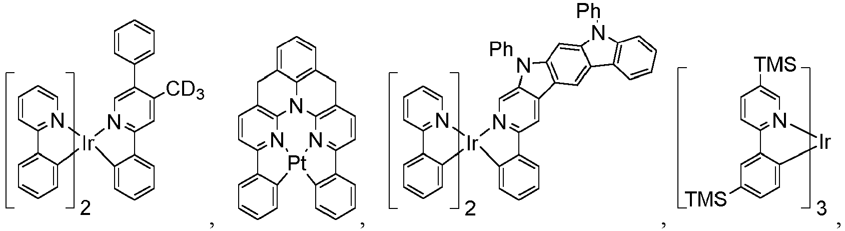 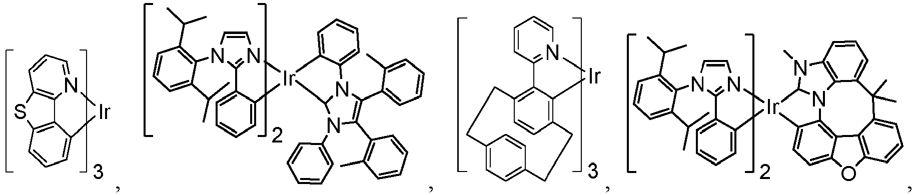 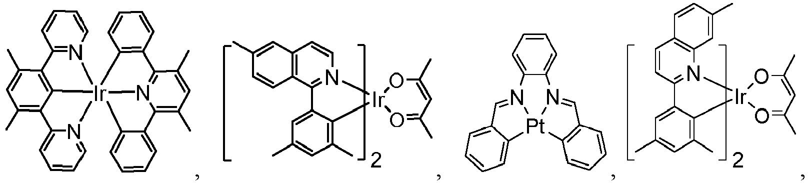 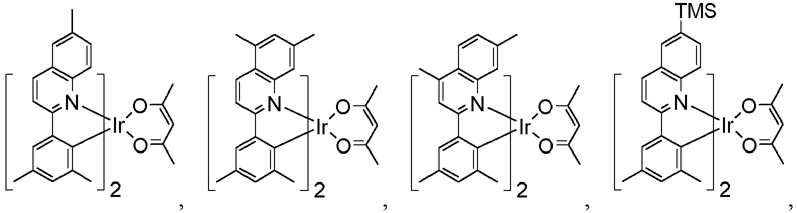 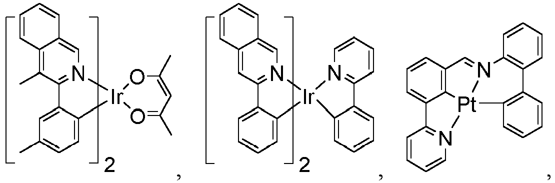 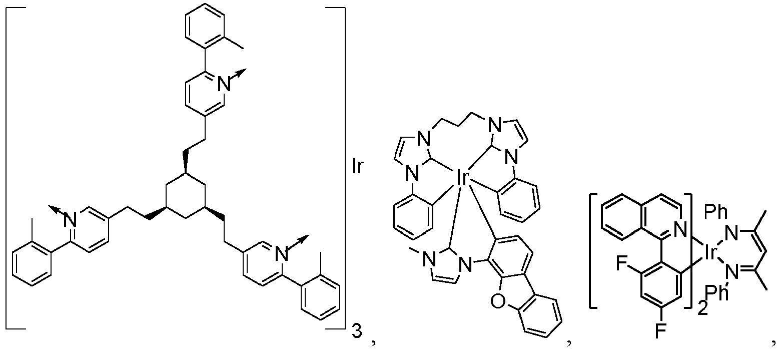 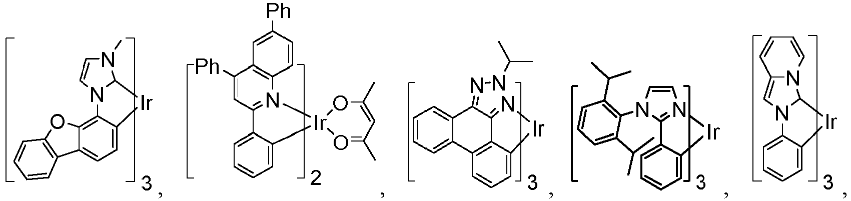 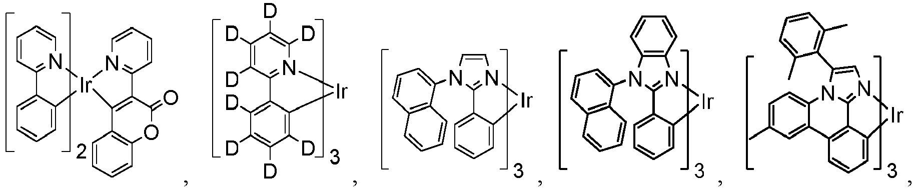 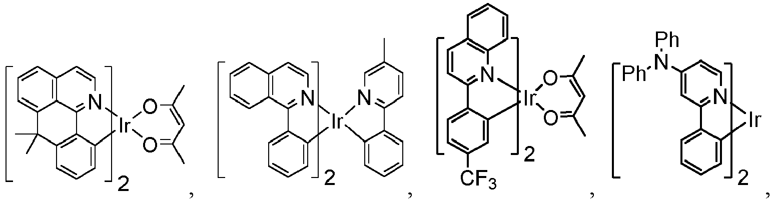 and

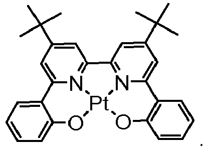

### HBL:

A hole blocking layer (HBL) may be used to reduce the number of holes and/or excitons that leave the emissive layer. The presence of such a blocking layer in a device may result in substantially higher efficiencies and/or longer lifetime as compared to a similar device lacking a blocking layer. Also, a blocking layer may be used to confine emission to a desired region of an OLED. In some embodiments, the HBL material has a lower HOMO (further from the vacuum level) and/or higher triplet energy than the emitter closest to the HBL interface. In some embodiments, the HBL material has a lower HOMO (further from the vacuum level) and/or higher triplet energy than one or more of the hosts closest to the HBL interface.

In one aspect, compound used in HBL contains the same molecule or the same functional groups used as host described above.

In another aspect, compound used in HBL contains at least one of the following groups in the molecule: 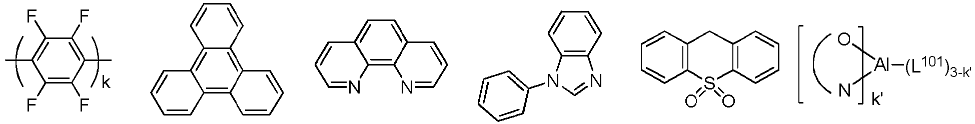 wherein k is an integer from 1 to 20; L¹⁰¹ is an another ligand, k' is an integer from 1 to 3.

### ETL:

Electron transport layer (ETL) may include a material capable of transporting electrons. Electron transport layer may be intrinsic (undoped), or doped. Doping may be used to enhance conductivity. Examples of the ETL material are not particularly limited, and any metal complexes or organic compounds may be used as long as they are typically used to transport electrons.

In one aspect, compound used in ETL contains at least one of the following groups in the molecule: 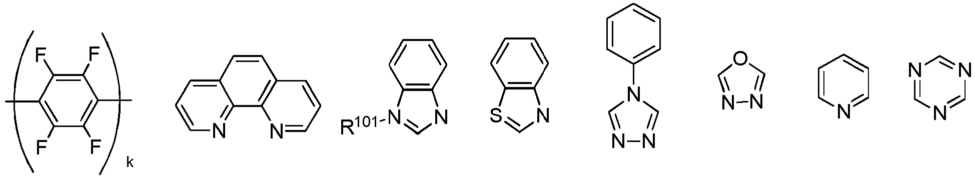 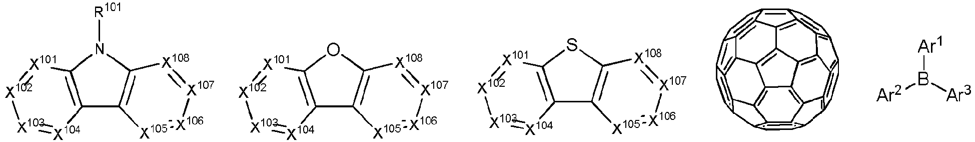 wherein R¹⁰¹ is selected from the group consisting of hydrogen, deuterium, halide, alkyl, cycloalkyl, heteroalkyl, arylalkyl, alkoxy, aryloxy, amino, silyl, alkenyl, cycloalkenyl, heteroalkenyl, alkynyl, aryl, heteroaryl, acyl, carbonyl, carboxylic acids, ester, nitrile, isonitrile, sulfanyl, sulfinyl, sulfonyl, phosphino, and combinations thereof, when it is aryl or heteroaryl, it has the similar definition as Ar's mentioned above. Ar¹ to Ar³ has the similar definition as Ar's mentioned above. k is an integer from 1 to 20. X¹⁰¹ to X¹⁰⁸ is selected from C (including CH) or N.

In another aspect, the metal complexes used in ETL contains, but not limit to the following general formula: 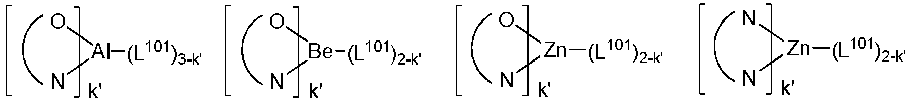 wherein (O-N) or (N-N) is a bidentate ligand, having metal coordinated to atoms O, N or N, N; L¹⁰¹ is another ligand; k' is an integer value from 1 to the maximum number of ligands that may be attached to the metal.

Examples of the ETL materials that may be used in an OLED in combination with materials disclosed herein are exemplified below together with references that disclose those materials: CN103508940, EP01602648, EP01734038, EP01956007, JP2004-022334, JP2005149918, JP2005-268199, KR0117693, KR20130108183, US20040036077, US20070104977, US2007018155, US20090101870, US20090115316, US20090140637, US20090179554, US2009218940, US2010108990, US2011156017, US2011210320, US2012193612, US2012214993, US2014014925, US2014014927, US20140284580, US6656612, US8415031, WO2003060956, WO2007111263, WO2009148269, WO2010067894, WO2010072300, WO2011074770, WO2011105373, WO2013079217, WO2013145667, WO2013180376, WO2014104499, WO2014104535,

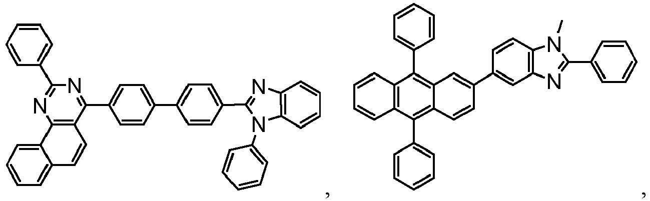

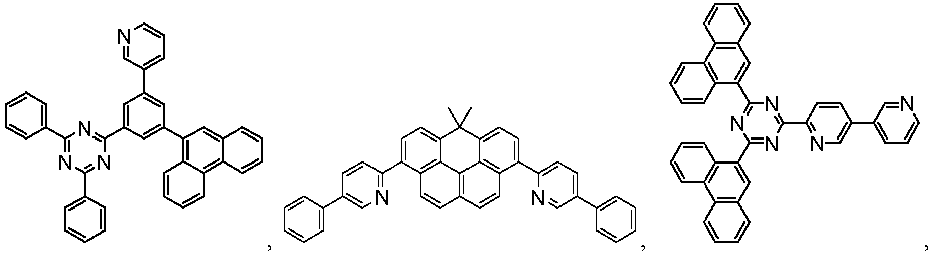

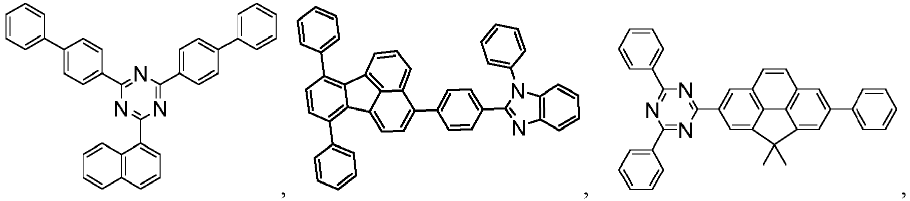

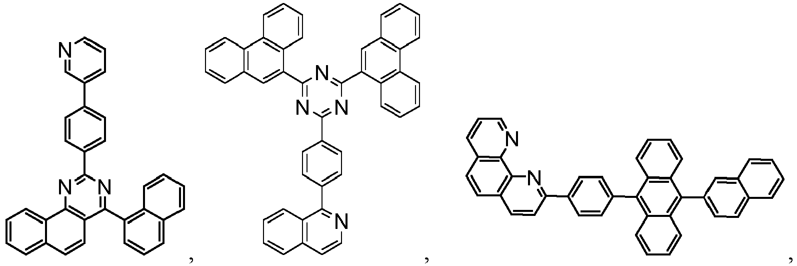

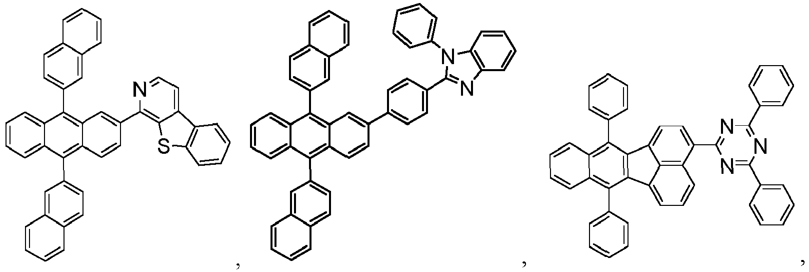

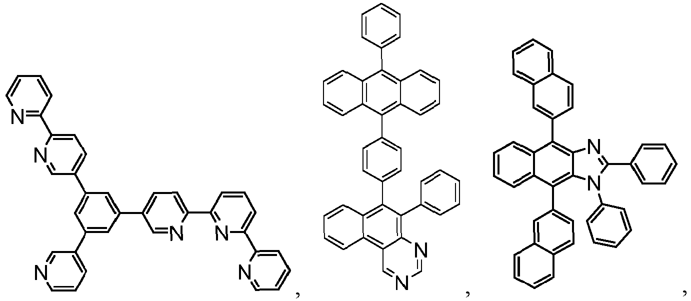

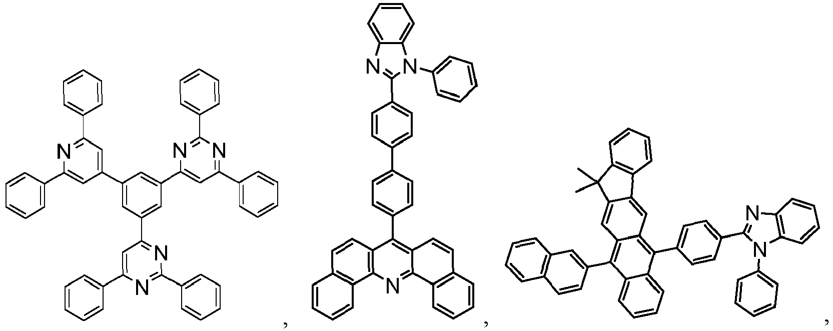

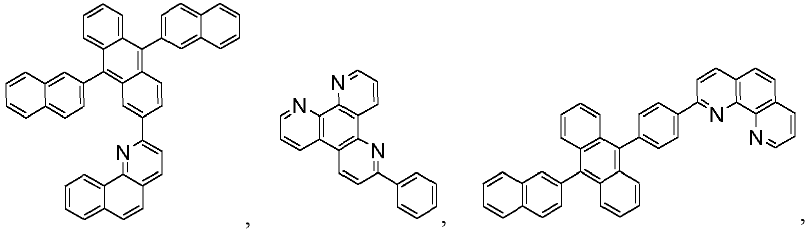

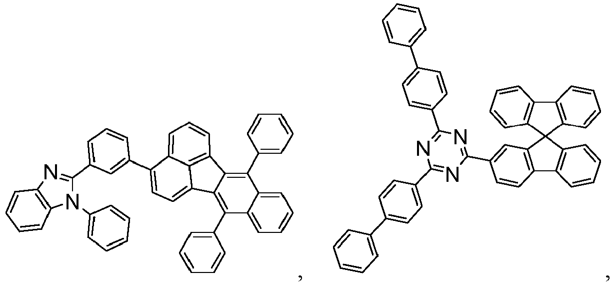

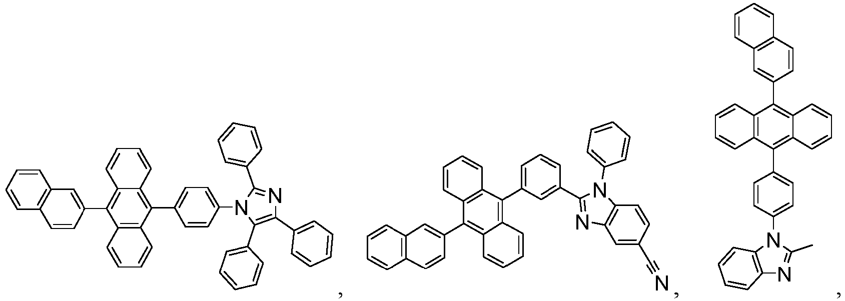

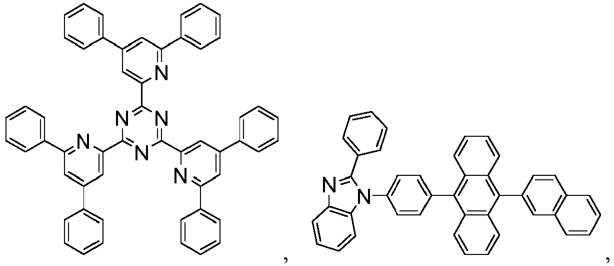

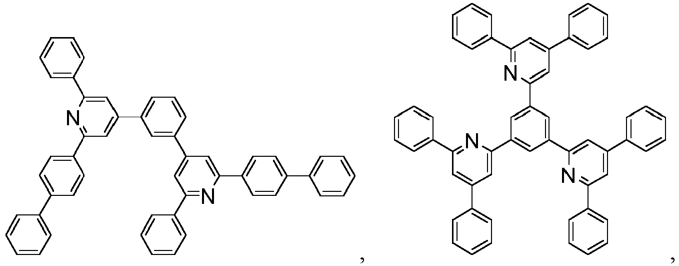

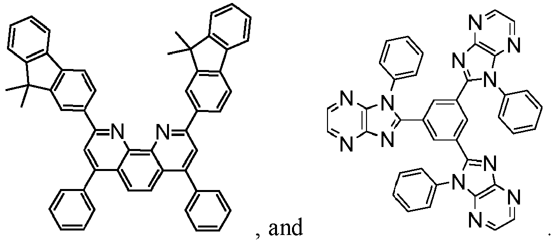

### Charge generation layer (CGL)

In tandem or stacked OLEDs, the CGL plays an essential role in the performance, which is composed of an n-doped layer and a p-doped layer for injection of electrons and holes, respectively. Electrons and holes are supplied from the CGL and electrodes. The consumed electrons and holes in the CGL are refilled by the electrons and holes injected from the cathode and anode, respectively; then, the bipolar currents reach a steady state gradually. Typical CGL materials include n and p conductivity dopants used in the transport layers.

In any above-mentioned compounds used in each layer of the OLED device, the hydrogen atoms can be partially or fully deuterated. Thus, any specifically listed substituent, such as methyl, phenyl, pyridyl may be undeuterated, partially deuterated, and fully deuterated versions thereof. Similarly, classes of substituents such as alkyl, aryl, cycloalkyl, heteroaryl also may be undeuterated, partially deuterated, and fully deuterated versions thereof.

### EXPERIMENTAL

### SYNTHETIC EXAMPLES

### 1. Synthesis of Comp (L_{A1})₂Ir(L_{B227}) (comparative compound)

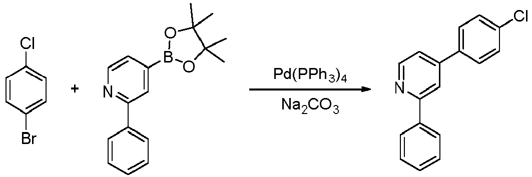

To a 500 mL round bottom flask, 1-bromo-4-chlorobenzene (9.60 g, 50.1 mmol), 2-phenyl-4-(4,4,5,5-tetramethyl-1,3,2-dioxaborolan-2-yl)pyridine (11.75 g, 41.8 mmol), Pd(PPh₃)₄ (2.415 g, 2.090 mmol), sodium carbonate (13.29 g, 125 mmol), DME (200 mL) and water (100 mL) were added and refluxed overnight. The reaction mixture was worked up and purified to yield 9.1g of the desired product (yield 89%). GC and NMR confirmed the desired product. 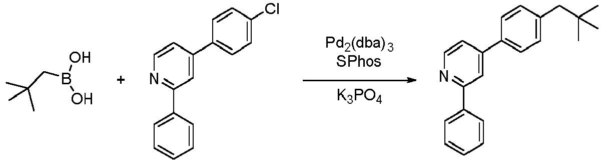 To a 500 mL round bottom flask, neopentylboronic acid (5.0 g, 43.1 mmol), dicyclohexyl(2',6'-dimethoxy-[1,1'-biphenyl]-2-yl)phosphane (SPhos) (1.112 g, 2.71 mmol), Pd₂(dba)₃ (0.620 g, 0.677 mmol), potassium phosphate (21.57 g, 102 mmol), water (25 ml), and toluene (250 ml) were added. The reaction mixture was degassed by bubbling in nitrogen for 15 minutes then heated in an oil bath and refluxed for 24 hours. The reaction was cooled down and purified by silica column chromatography to yield 8.0 g of the desired product (78.3% yield). 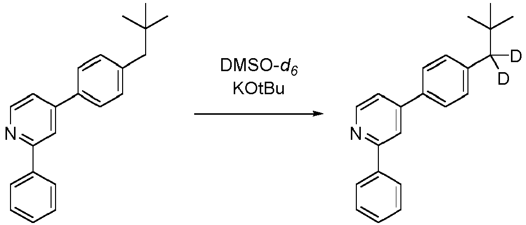 This deuteration reaction was carried out based on the literature procedure published in Tetrahedron 71(2015)1425-1430. 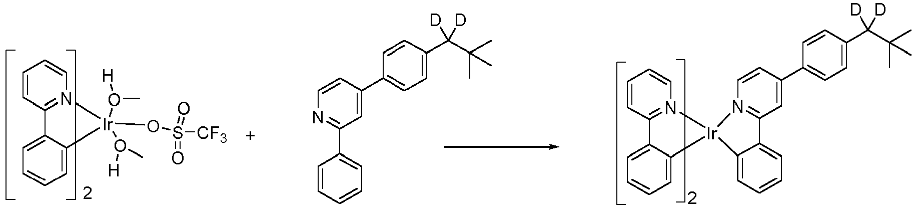 To a 100 mL round bottom flask, the iridium precursor (1.7 g, 2.38 mmol), 4-(4-(2,2-dimethylpropyl-11-*d₂*)phenyl)pyridine (1.8 g, 5.93 mmol), ethanol (25 mL) and methanol (25 mL) were added and heated under nitrogen in an oil bath and refluxed at 80 °C for 2 days. The reaction mixture was purified by silica column chromatography to give 0.9 g (47% yield) of desired product which was confirmed by LC-MS and NMR

### 2. Synthesis of Comp (L_{A147})₂Ir(L_{B184}) (comparative compound)

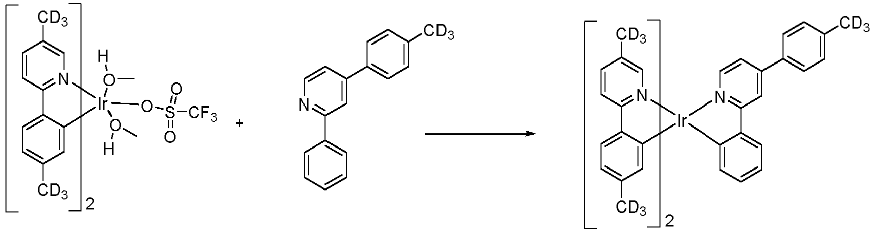

To a 100 mL flask, the iridium precursor (2.5 g, 3.20 mmol), 4-(4-(methyl-*d₃*)phenyl)-2-phenylpyridine (2.382 g, 9.59 mmol), ethanol (25 mL), and methanol (25 mL) were added. The reaction mixture was heated under nitrogen in an oil bath and refluxed at 80 °C for 15 hours. The reaction was allowed to cool to room temperature and filtered off the solid, washed with methanol and dried. The yellow solid was further purified by silica column chromatography to yield 1.25 g product (yield 48.9%) which was confirmed by LC-MS and NMR

### 3. Synthesis of Comp (L_{A147})₂Ir(L_{B86}) (according to this invention)

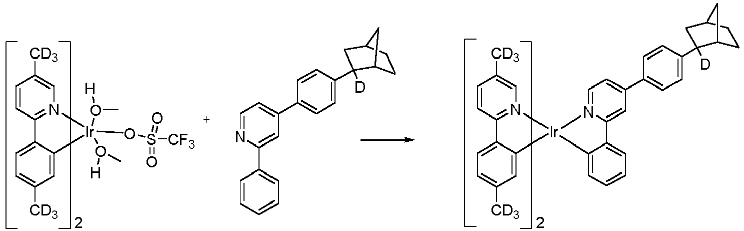

To a 500 mL round bottom flask , the iridium precursor (2 g, 2.56 mmol), 4-(4-((1S,2S,4R)-bicyclo[2.2.1]heptan-2-yl-2-d)phenyl)-2-phenylpyridine (2.104 g, 6.45 mmol), ethanol (40 mL) and methanol (40 mL) were added and refluxed at 80 °C for 23 hours. The reaction mixture was cooled down and filtered. The yellow solid collected was subjected to silica column chromatography to yield the desired product (0.61g, 26% yield).

### 4. Synthesis of Comp (L_{A147})₂Ir(L_{B109}) (according to this invention)

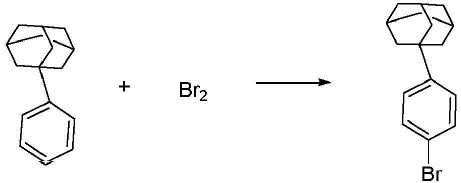

One 100 mL flask was charged with1-phenyladamantane (2 g, 9.42 mmol), CCl₄ (40 mL), dibromine (19.40 mL, 377 mmol), stirred for overnight and protected from the light. The reaction mixture was slowly poured into ice water and quenched with sodium thiosulfate. The reaction mixture was extracted with ethyl acetate. The organic portion was evaporated to yield the desired product (2.74 g, 100%). 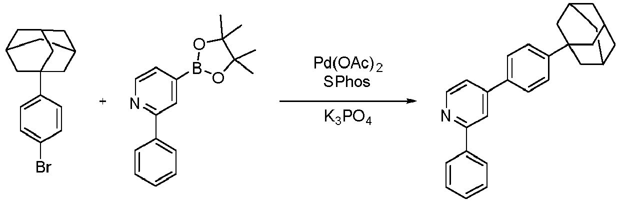 One 250 mL flask was charged with 1-(4-bromophenyl)adamantane (2.76 g, 9.48 mmol), 2-phenyl-4-(4,4,5,5-tetramethyl-1,3,2-dioxaborolan-2-yl)pyridine (4.00 g, 14.22 mmol), diacetoxypalladium (0.064 g, 0.284 mmol), dicyclohexyl(2',6'-dimethoxy-[1,1'-biphenyl]-2-yl)phosphane (SPhos) (0.233 g, 0.569 mmol), K₃PO₄(4.02 g, 18.95 mmol), toluene (30 mL) and water (3 mL). The reaction mixture was heated to 100 °C for overnight and subjected to the aqueous work up with EtOAc. The organic portion was combined and subjected to column chromatography to yield the desired product (2.46 g, 71%). 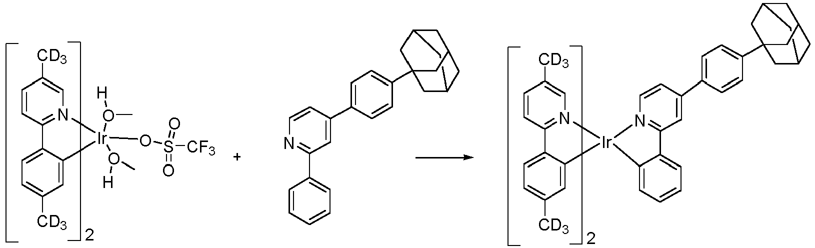 One 500 mL flask was charged with the iridium precursor (2.0 g, 2.56 mmol), 4-(4-(adamantan-1-yl)phenyl)-2-phenylpyridine (2.10 g, 5.75 mmol), ethanol (25 mL) and methanol (25 mL). The reaction mixture was heated to 80 °C for 5 days. The reaction mixture was filtered and the precipitate collected was subjected to column chromatography to yield the desired product (0.74 g, 31%). NMR and LC-MS confirmed the desired product.

### 5. Synthesis of Comp (L_{A147})₂Ir(L_{B88}) (according to this invention)

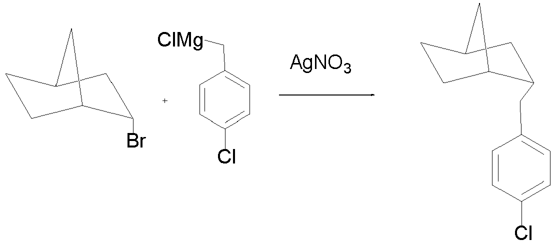

One 100 mL flask was charged with (nitrooxy)silver (0.137 g, 0.805 mmol), 100 mL of anhydrous ether, (1R,2S,4S)-2-bromobicyclo[2.2.1]heptane (3.45 mL, 26.8 mmol) was then added, followed by the addition of (4-chlorobenzyl)magnesium chloride (0.5 M solution in 2-MeTHF, 77 mL, 38.5 mmol) via addition funnel in a dropwise manner for a period of 20 minutes. The reaction mixture was stirred at room temperature for overnight. The reaction mixture was then diluted with water and extracted by ether. The organic portion was combined and subjected to column chromatography to yield the desired product (2.48 g, 41%). 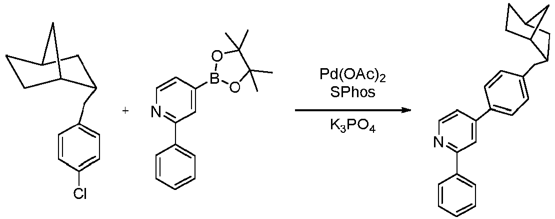 One 250 mL flask was charged with(1R,2R,4S)-2-(4-chlorobenzyl)bicyclo[2.2.1]heptane (2.48 g, 11.23 mmol)2-phenyl-4-(4,4,5,5-tetramethyl-1,3,2-dioxaborolan-2-yl)pyridine (4.11 g, 14.61 mmol), diacetoxypalladium (0.076 g, 0.337 mmol), dicyclohexyl(2',6'-dimethoxy-[1,1'-biphenyl]-2-yl)phosphane (SPhos) (0.277 g, 0.674 mmol), K₃PO₄ (4.77 g, 22.47 mmol), toluene (30 mL) and water (3.00 mL). The reaction mixture was heated to 105 °C for overnight. The reaction mixture was subjected to aqueous work up and extracted with ethyl acetate. The organic portion was combined and subjected to silica column chromatography to yield pure product (3.69 g, 97%). 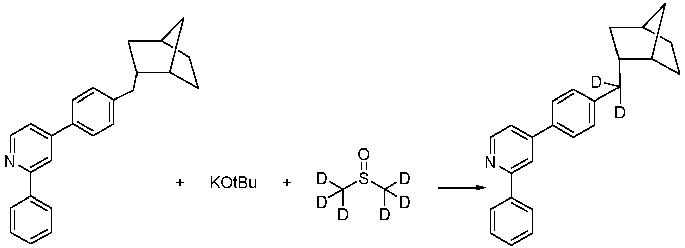 The deuteration reaction was carried out based on the literature procedure published in Tetrahedron 71(2015)1425-1430. 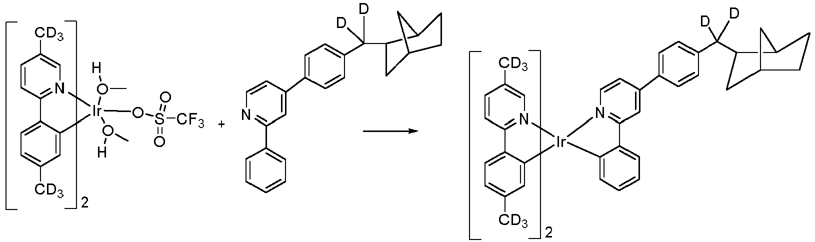 One 500 mL round bottom flask was charged with iridium precursor (2.8 g, 3.58 mmol), 4-(4-(((1R,2 S,4 S)-bicyclo[2.2.1]heptan-2-yl)methyl-d2)phenyl)-2-phenylpyridine (2.446 g, 7.16 mmol), ethanol (25 mL) and MeOH (25 mL). The reaction mixture was heated to 80 °C for 4 days. The reaction mixture was filtered and the precipitate was collected and subjected to silica column chromatography to yield the desired product (1 g, 30.7%).

### 6. Synthesis of Comp (L_{A147})₂Ir(L_{B225}) (comparative)

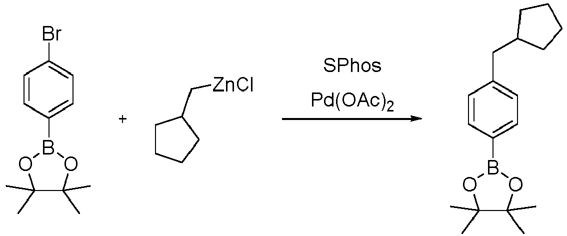

One 500 mL flask was charged with 2-(4-bromophenyl)-4,4,5,5-tetramethyl-1,3,2-dioxaborolane (10.5 g, 37.1 mmol), dicyclohexyl(2',6'-dimethoxy-[1,1'-biphenyl]-2-yl)phosphane (SPhos) (0.914 g, 2.226 mmol), and diacetoxypalladium (0.250 g, 1.113 mmol). The solution of (cyclopentylmethyl)zinc(II) chloride (20.48 g, 111 mmol) was transferred via a cannula into the reaction flask. The reaction mixture was stirred at room temperature for overnight. The reaction mixture was diluted with saturated ammonium chloride solution and extracted by ethyl acetate. The organic portion was combined and subjected to silica column chromatography to yield the desired product. (7.10 g, 67%). 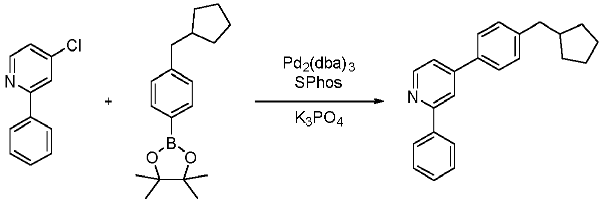 One 250 mL flask was charged with 4-chloro-2-phenylpyridine (3.92 g, 20.67 mmol), 2-(4-(cyclopentylmethyl)phenyl)-4,4,5,5-tetramethyl-1,3,2-dioxaborolane (7.10 g, 24.80 mmol), Pd₂(dba)₃(0.379 g, 0.413 mmol), dicyclohexyl(2',6'-dimethoxy-[1,1'-biphenyl]-2-yl)phosphane (SPhos) (0.679 g, 1.654 mmol), K₃PO₄ (13.16 g, 62.0 mmol), toluene (70 mL) and water (7.0 mL). The reaction was heated to 100 °C for over night. The reaction mixture was subjected to aqueous work up and extracted by EtOAc. The organic portion was combined and subjected to column chromatography to yield the product (5.71 g, 88%). 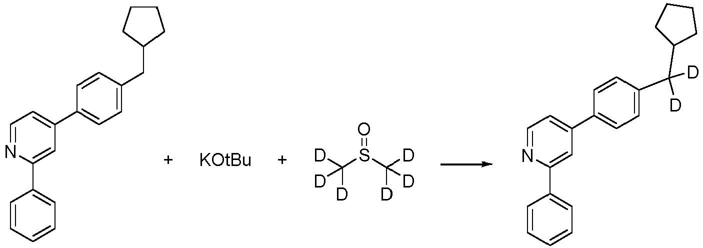 The deuteration reaction was carried out based on the literature procedure published in Tetrahedron 71(2015)1425-1430. 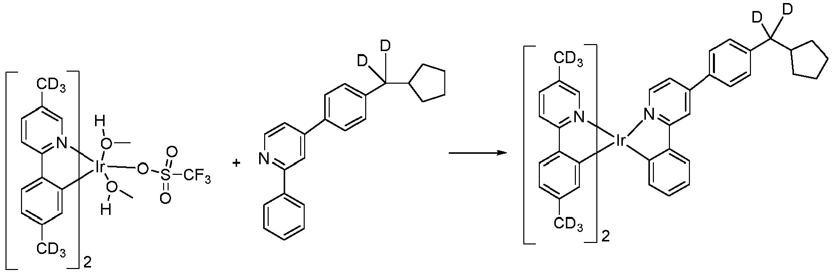 One 100 mL round bottom flask was charged with the iridium precursor (2.22 g, 2.84 mmol), 4-(4-(cyclopentylmethyl-d2)phenyl)-2-phenylpyridine (1.791 g, 5.68 mmol), ethanol (25 mL) and MeOH (25.00 mL). The reaction mixture was heated to 68 °C for 5 days. The reaction mixture was filtered and the precipitate collected was subjected to column chromatography to yield desired product (0.9 g, 36%).

### 7. Synthesis of Comp (L_{A153})₂Ir(L_{B86}) (according to this invention)

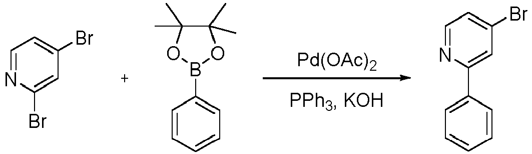

One 1000 mL round bottom flask was charged with 2,4-dibromo-pyridine (9.45 g, 40.4 mmol), 4,4,5,5-tetramethyl-2-phenyl-1,3,2-dioxaborolane (11.37 g, 55.7 mmol), diacetoxypalladium (0.569 g, 2.53 mmol), triphenylphosphane (2.66 g, 10.13 mmol), potassium hydroxide (5.68 g, 101 mmol) and acetonitrile (600 mL). The reaction mixture was heated to 60 °C for 50 hours. The reaction mixture was subjected to aqueous work up with EtOAc. The organic portion was combined and subjected to silica gel column chromatography to yield the desired product (9.45 g, 80%). 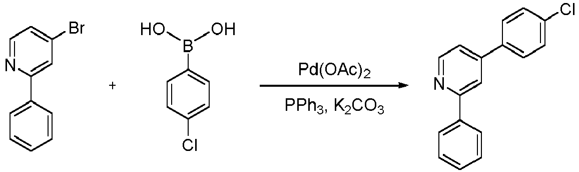 One 500 mL round bottom flask was charged with 4-bromo-2-phenylpyridine (9.52 g, 35.8 mmol), (4-chlorophenyl)boronic acid (6.94 g, 44.4 mmol), diacetoxypalladium (0.453 g, 2.018 mmol), triphenylphosphane (1.059 g, 4.04 mmol), K₂CO₃ (11.16 g, 81 mmol), acetonitrile (200 mL) and MeOH (100 mL). The reaction was heated to 40 °C for 21 hours. The reaction mixture was diluted with water and extracted with ethyl acetate. The organic portion was evaporated to dryness. The residue was subjected to column chromatography to yield the desired compound (9.52 g, 89%). 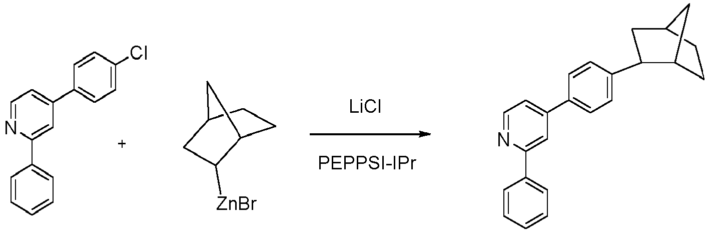 One 250 mL flask was charged with 4-(4-chlorophenyl)-2-phenylpyridine (3 g, 11.29 mmol), lithium chloride (6.52 g, 154 mmol), PEPPSI-Ipr (0.460 g, 0.677 mmol) and ((1S,2R,4R)-bicyclo[2.2.1]heptan-2-yl)zinc(II) bromide (79 ml, 39.5 mmol) in THF. The reaction mixture was stirred at room temperature for overnight. The reaction mixture was diluted with water and extracted with ethyl acetate. Organic portion was combined and subjected to column chromatography to yield (3.67 g, 100%). 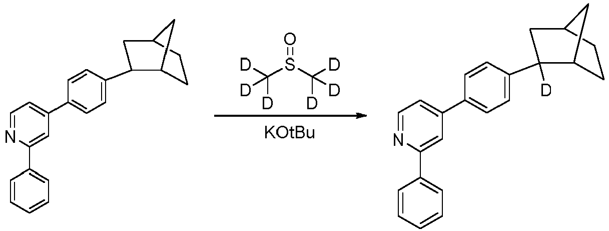 The deuteration reaction was carried out based on the literature procedure published in Tetrahedron 71(2015)1425-1430. 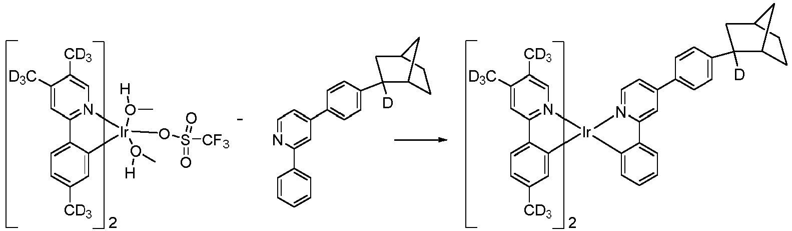 One 500 mL flask was charged with the iridium precursor (4.28 g, 5.24 mmol), 4-(4-((1S,2S,4R)-bicyclo[2.2.1]heptan-2-yl-2-d)phenyl)-2-phenylpyridine (4.36 g, 13.36 mmol), ethanol (40 mL) methanol (40 mL), heated to 70 °C for 50 hours. The reaction mixture was filtered and the yellow solid was collected was subjected to column chromatography to yield the desired product (1.18 g).

### DEVICE EXAMPLES

All example devices were fabricated by high vacuum (<10⁻⁷ Torr) thermal evaporation. The anode electrode was 750 Å of indium tin oxide (ITO). The cathode consisted of 10 Å of Liq (8-hydroxyquinoline lithium) followed by 1,000 Å of Al. Devices were encapsulated with a glass lid sealed with an epoxy resin in a nitrogen glove box (<1 ppm of H₂O and O₂) immediately after fabrication, and a moisture getter was incorporated inside the package. The stack of the device examples consisted of sequentially, from the ITO surface, 100Å of HATCN as the hole injection layer (HIL); 450 Å of HTM as a hole transporting layer (HTL); 50Å of EBM as electron blocking layer, 400Å of emissive layer (EML) containing two component host (H1:H2 1:1 ratio) and emitter 12% (Inventive or comparative emitter examples), and 350 Å of Liq (8-hydroxyquinoline lithium) doped with 40% of ETM as the electron transporting layer ETL. The chemical structures of the device materials are shown below.

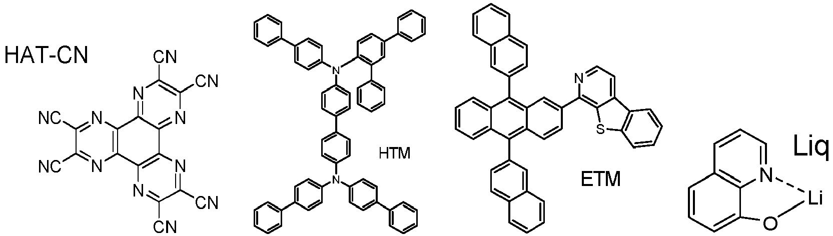

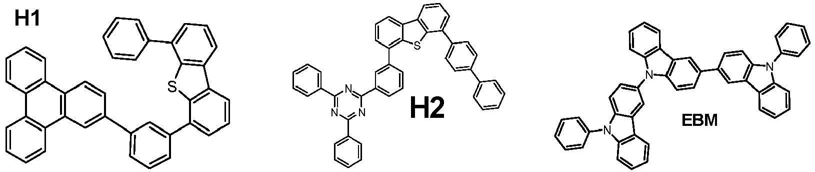

Table 5 shows the device layer thicknesses and materials.

**Table 5. Device structure for evaluating EQE of yellow emitters**

| Layer | Material | Thickness [Å] |
|---|---|---|
| Anode | ITO | 750 |
| HIL | HATCN | 100 |
| HTL | HTM | 450 |
| EBL | EBM | 50 |
| EML | H1:H2 (1:1):Emitter 12% | 400 |
| ETL | Liq: ETM 40% | 350 |
| EIL | Liq | 10 |
| Cathode | Al | 1000 |

Emitter Comparative Examples 1, 2, 5 and Examples7, 8, 9, 10 and CE2 were used to demonstrate the correlation between device EQE and emitter orientation factor. The device EQE measured at 1,000 nits is shown in the Table 6.

**Table 6. Correlation of Experimental EQE, Estimated EQE in the device with Emitter PLQY and orientation factor.**

| Example | # | Emitter | Emitter Orientation factor | Experimental EQE at 1,000 nits [%] |
|---|---|---|---|---|
| CE | 2 | Comp **(L_{A1})₂Ir(L_{B182})** | 0.80 | 26 |
| Comparative Example | 1 | **Comp (L_{A1})₂Ir(L_{B196})** | 0.82 | 28 |
| Comparative Example | 2 | **Comp (L_{A147})₂Ir(L_{B184})** | 0.85 | 28 |
| Comparative Example | 5 | **Comp (L_{A147})₂Ir(L_{B225})** | 0.90 | 30 |
| Example | 7 | **Comp (L_{A147})₂Ir(L_{B86})** | 0.92 | 33 |
| Example | 8 | **Comp (L_{A153})₂Ir(L_{B86})** | 0.92 | 32 |
| Example | 9 | **Comp (L_{A147})₂Ir(L_{B109})** | 0.92 | 33 |
| Example | 10 | **Comp (L_{A147})₂Ir(L_{B88})** | 0.94 | 33 |

The observed increase in the device EQE with increasing emitter orientation factor show that EQE is in direct correlation with the emitter orientation.

## Claims

1. A compound having the formula Ir(L_{A})ₘ(L_{B})₃₋ₘ which has a structure selected from the group consisting of 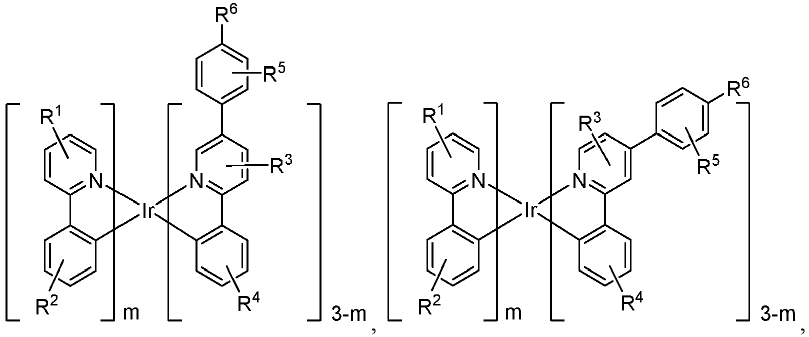 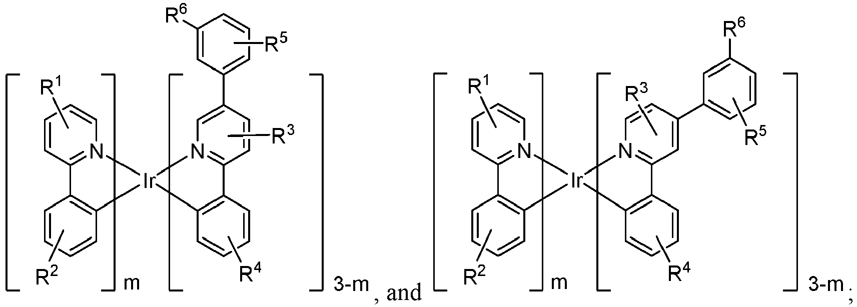
wherein m is 1 or 2;
wherein R¹, R², R⁴, and R⁵ each independently represent mono, di, tri, or tetra substitution, or no substitution;
wherein R³ represents mono, di, or tri substitution, or no substitution;
wherein R¹, R², R³, R⁴, and R⁵ are each independently selected from the group consisting of hydrogen, deuterium, C1 to C6 alkyl, C1 to C6 cycloalkyl, and partially or fully deuterated or fluorinated variants thereof; and
wherein R⁶ is selected from the group consisting of alkyl having at least seven carbon atoms, cycloalkyl having at least seven carbon atoms, alkyl-cycloalkyl having at least seven carbon atoms, and partially or fully deuterated or fluorinated variants thereof.

2. The compound of claim 1, wherein L_{A} is selected from the group consisting of: 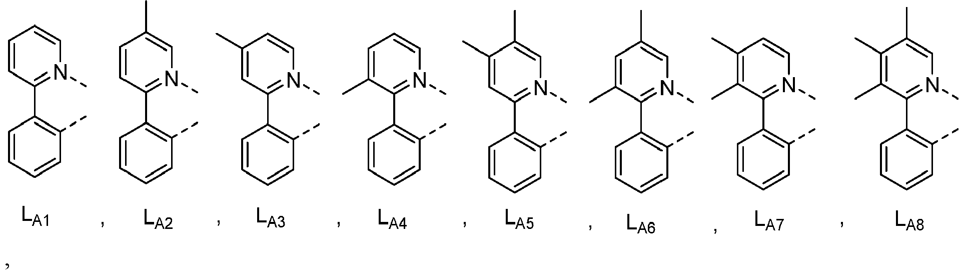 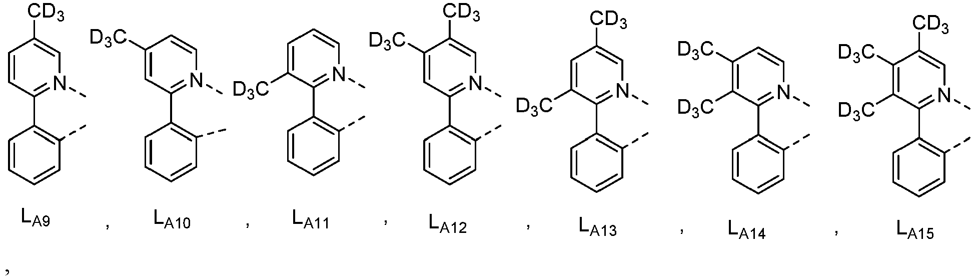 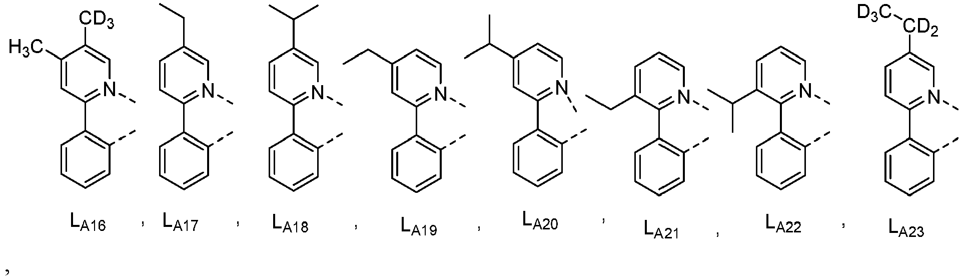 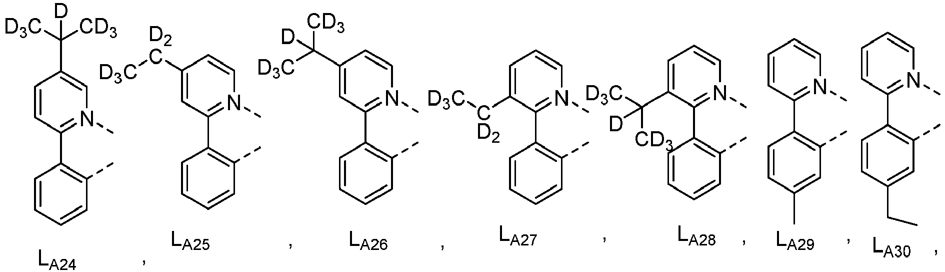 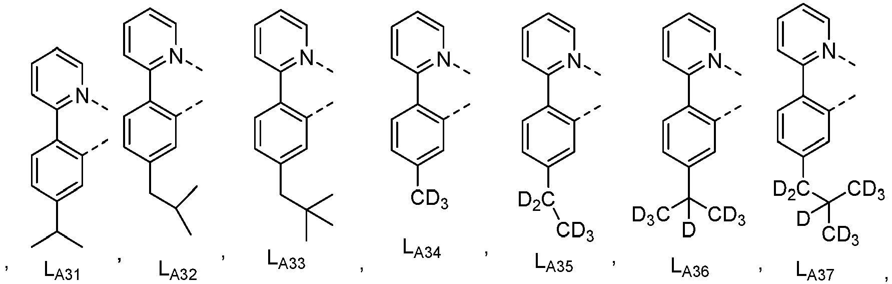 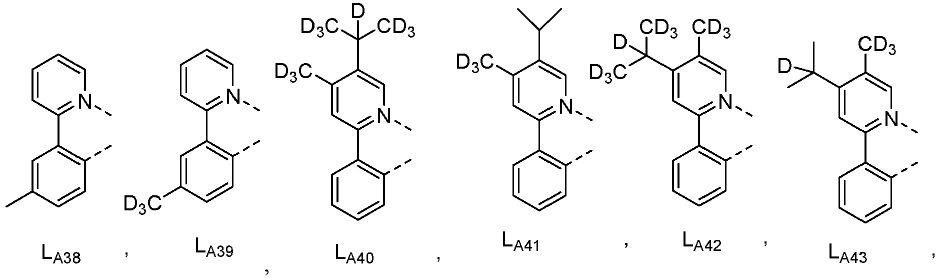 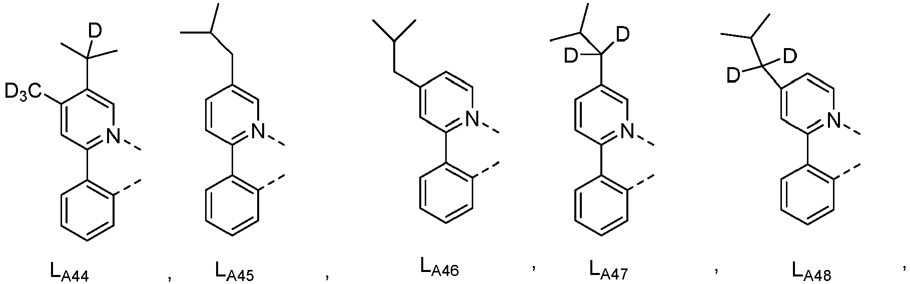 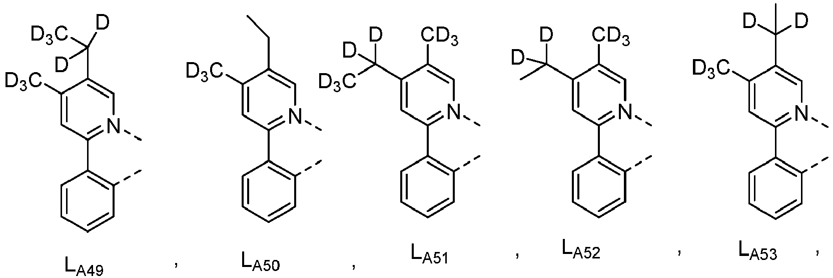 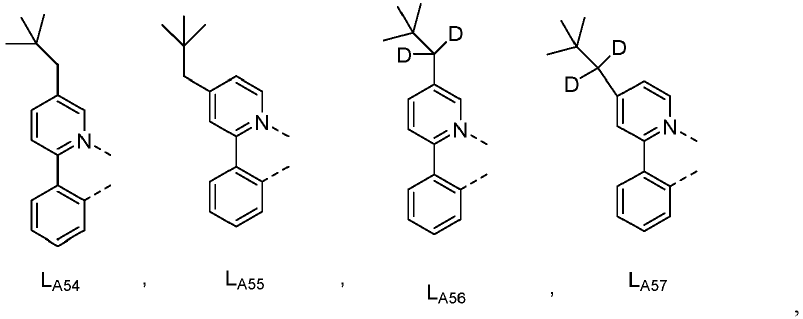 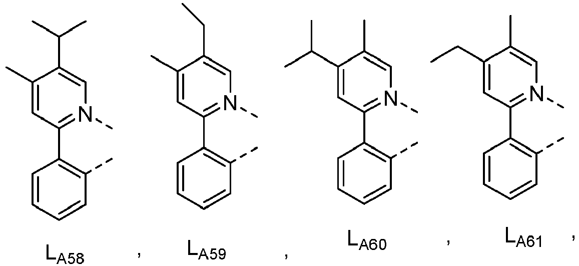 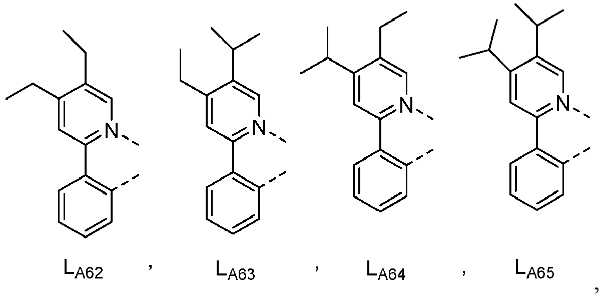 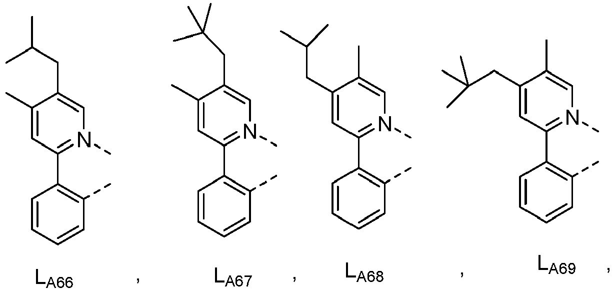 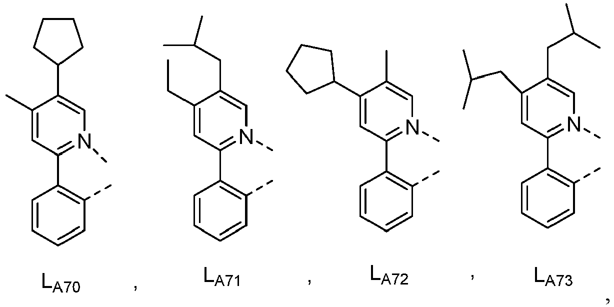 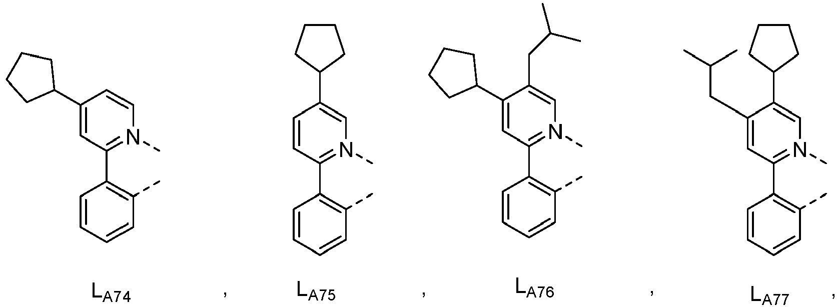 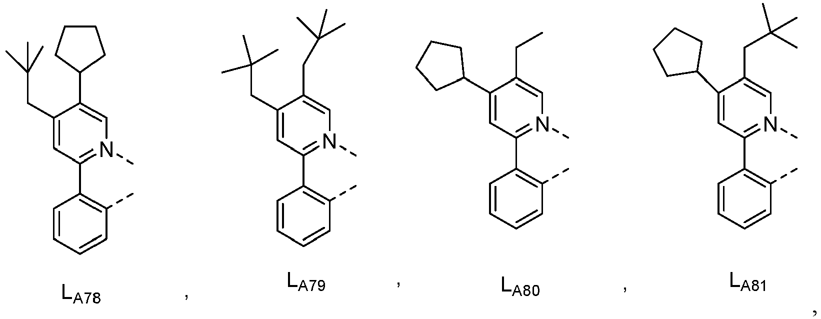 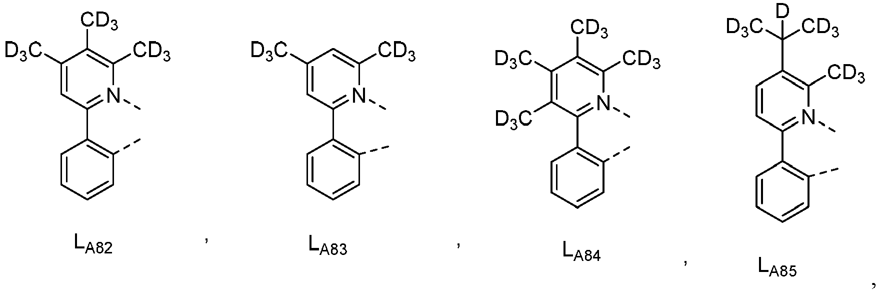 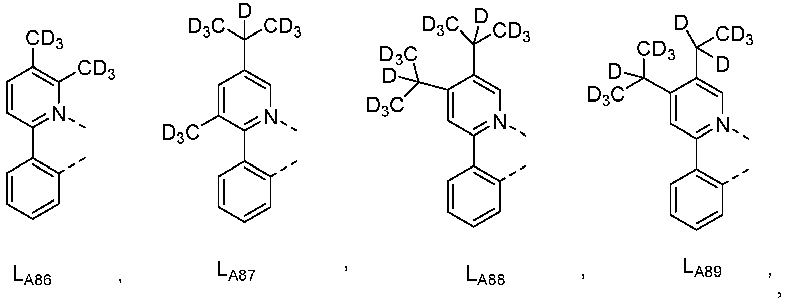 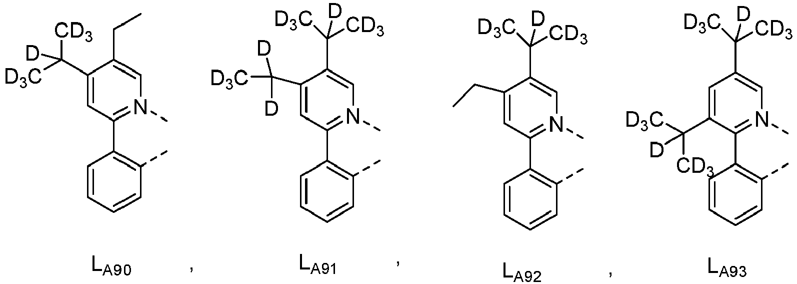 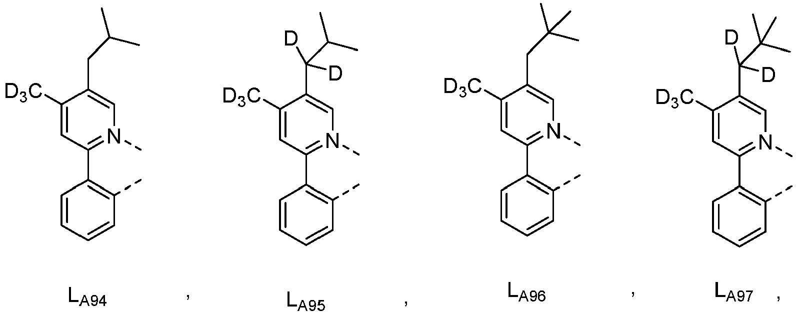 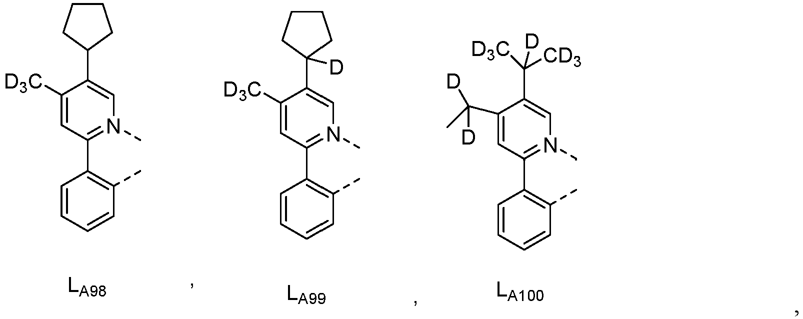 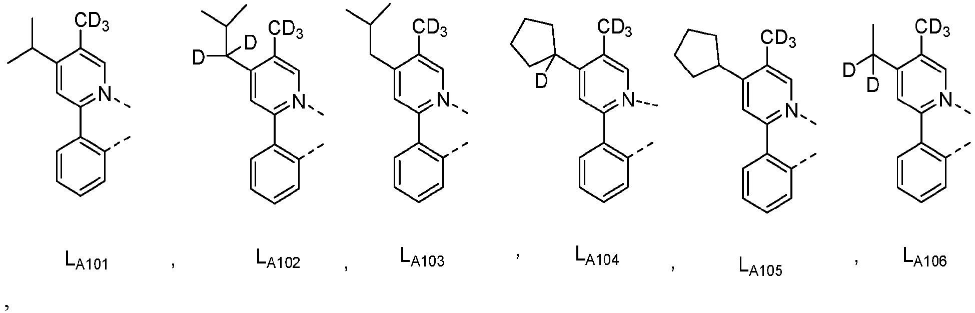 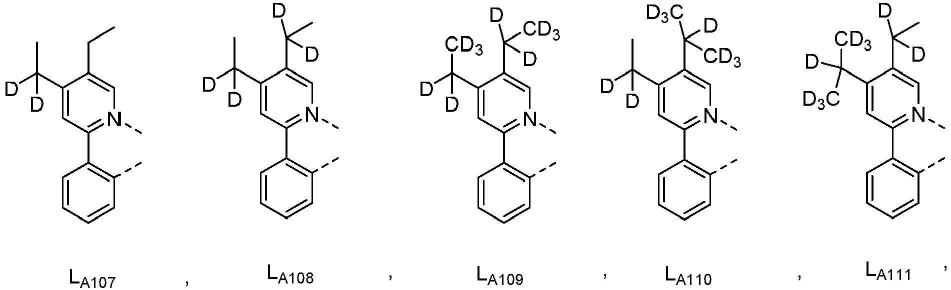 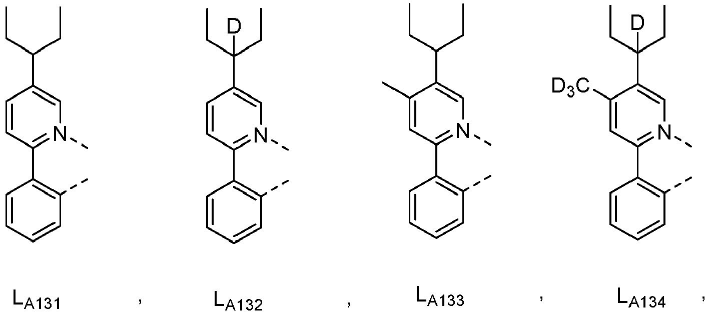 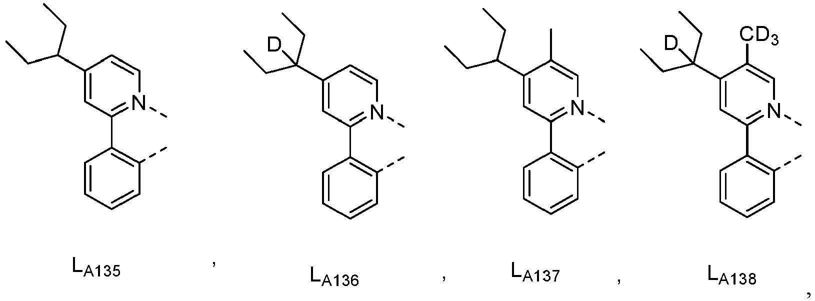 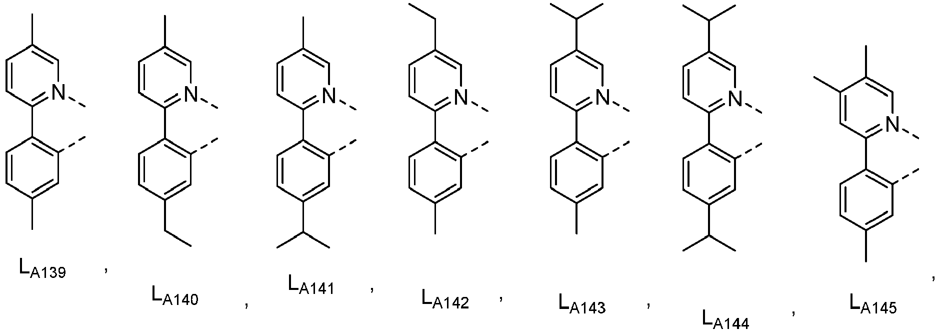 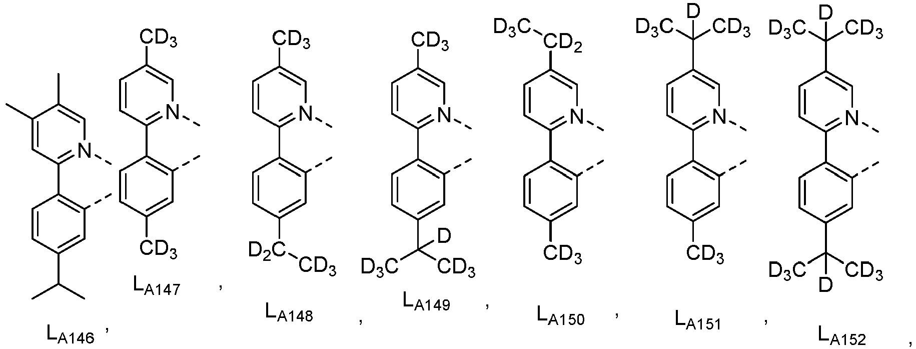 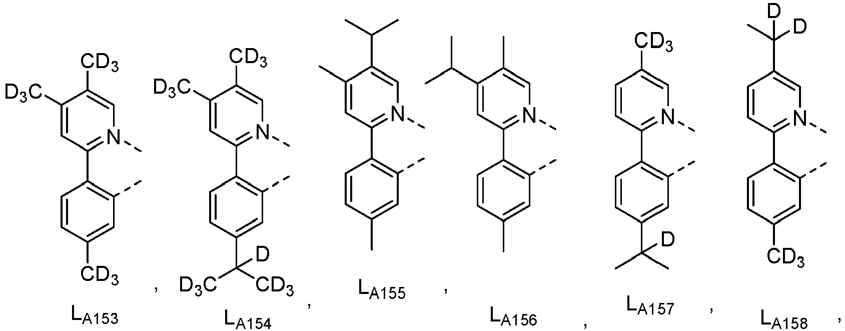 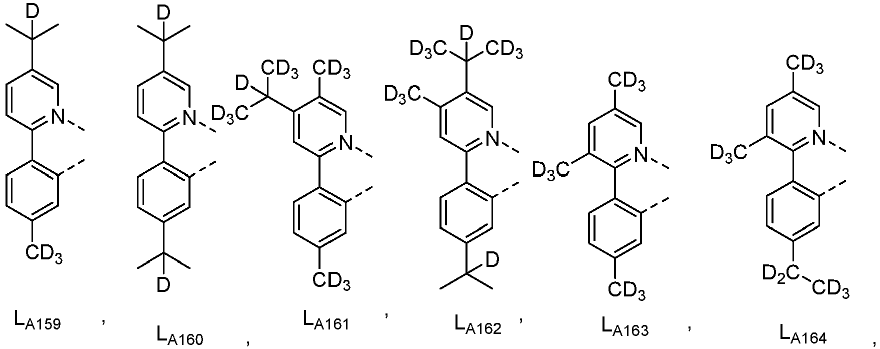 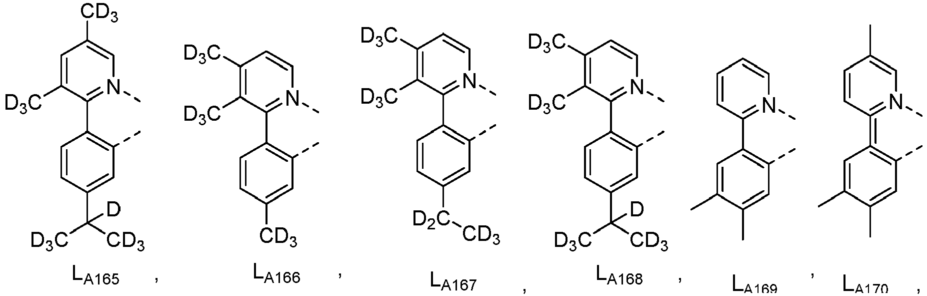 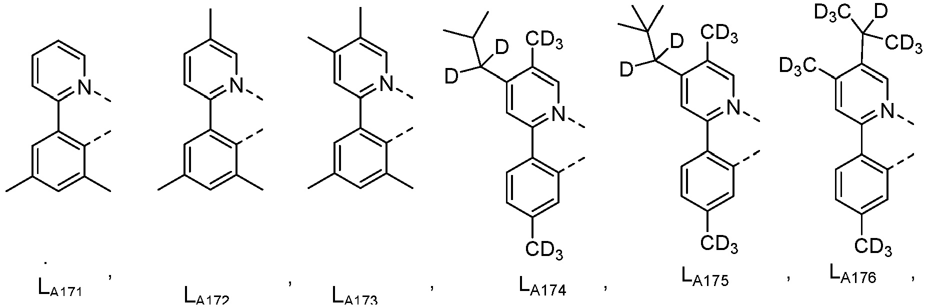 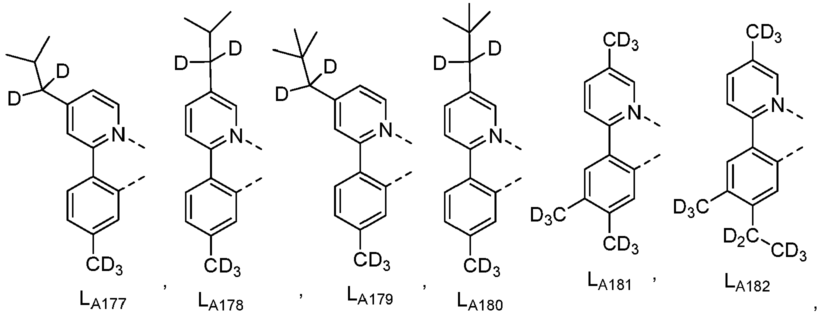 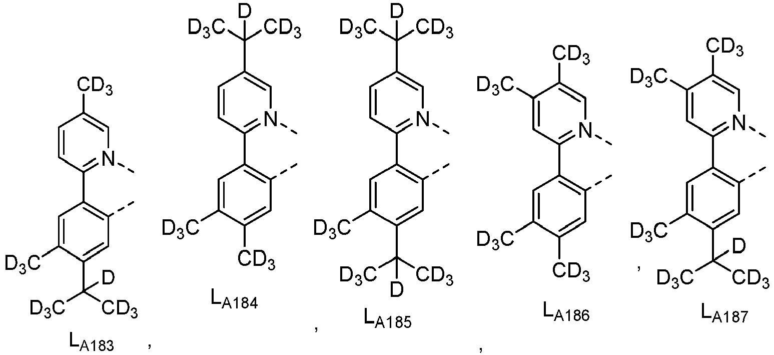 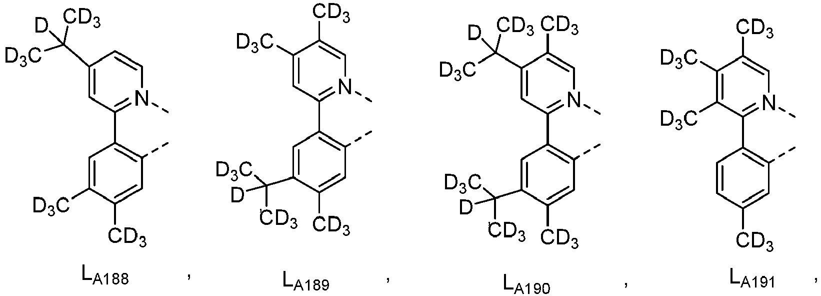 and

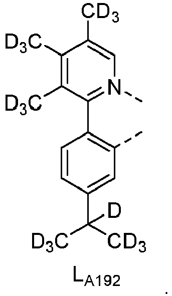

3. The compound of claim 1 or 2, wherein L_{B} is selected from the group consisting of: 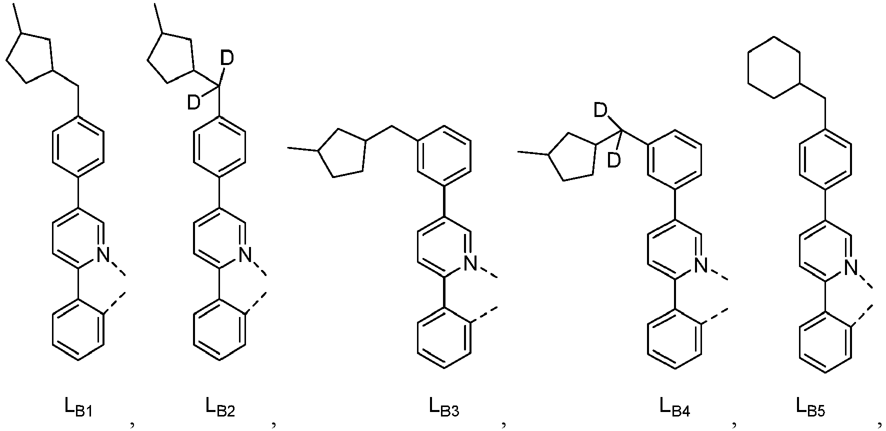 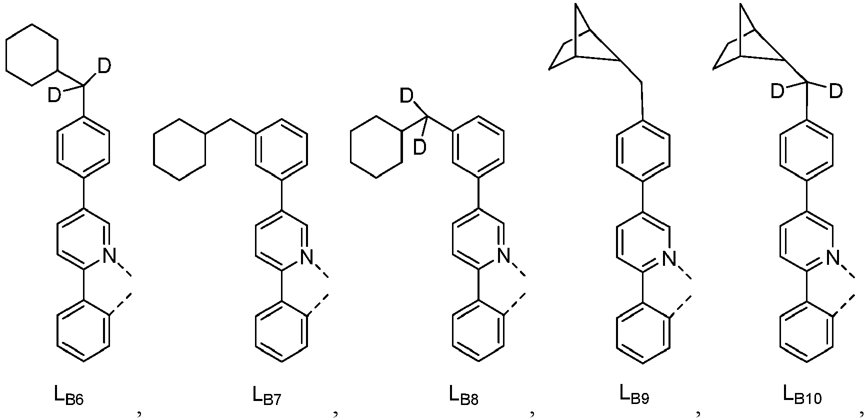 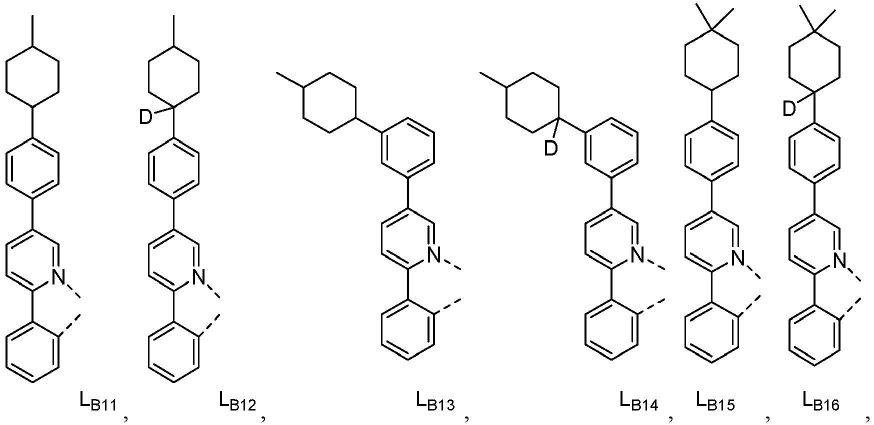 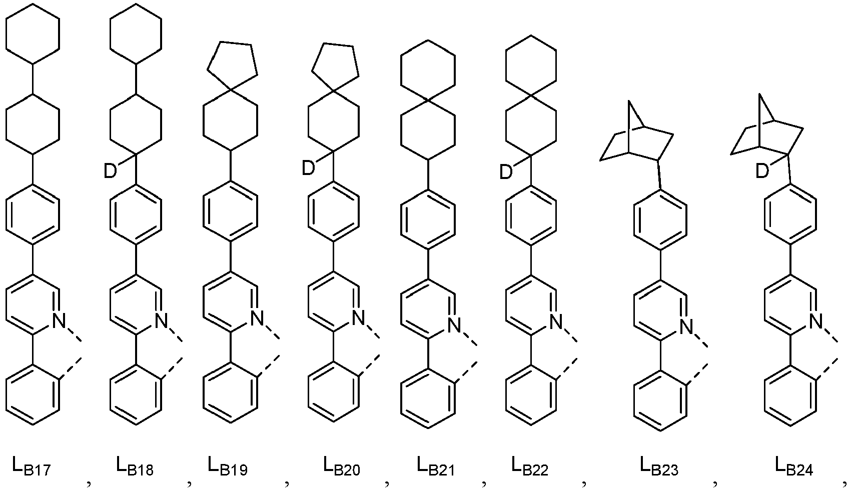 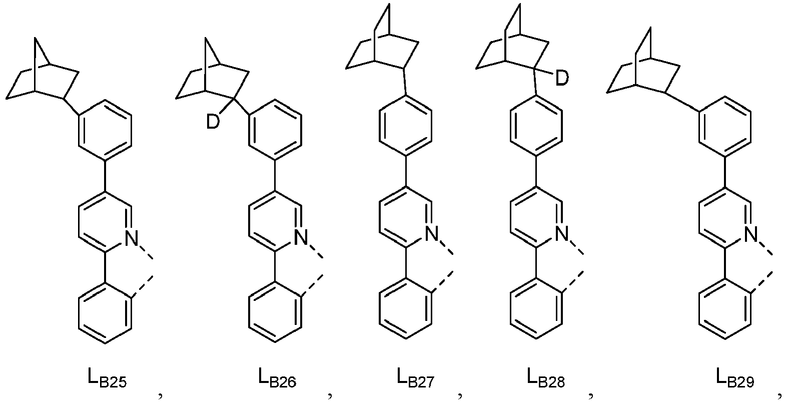 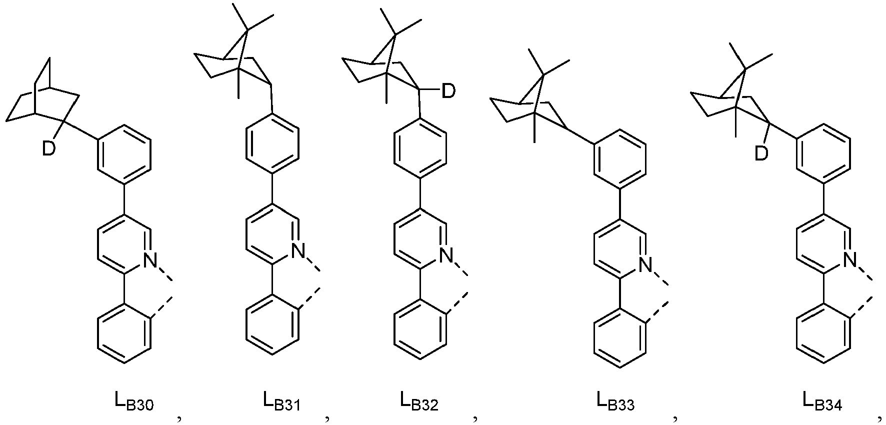 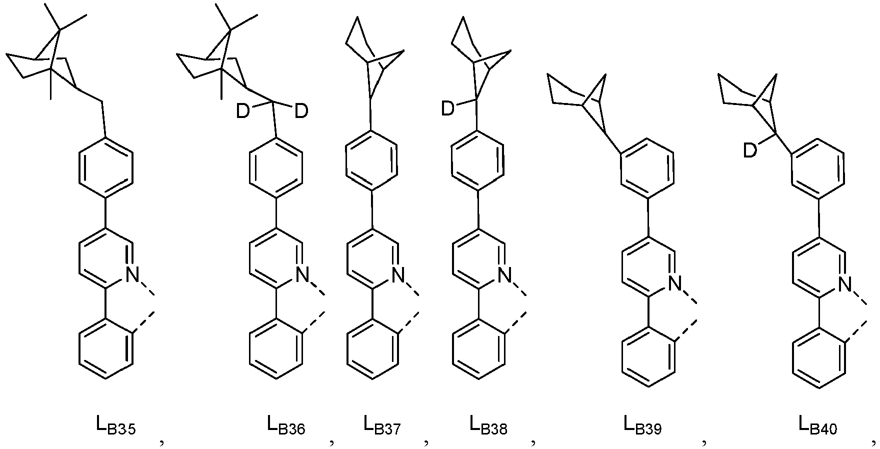 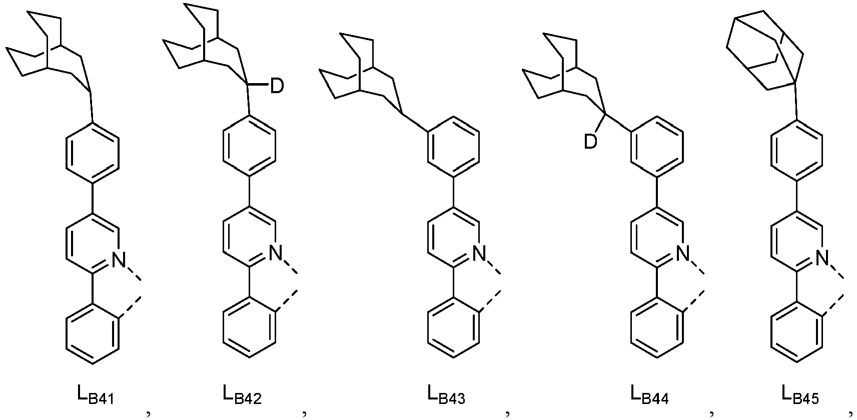 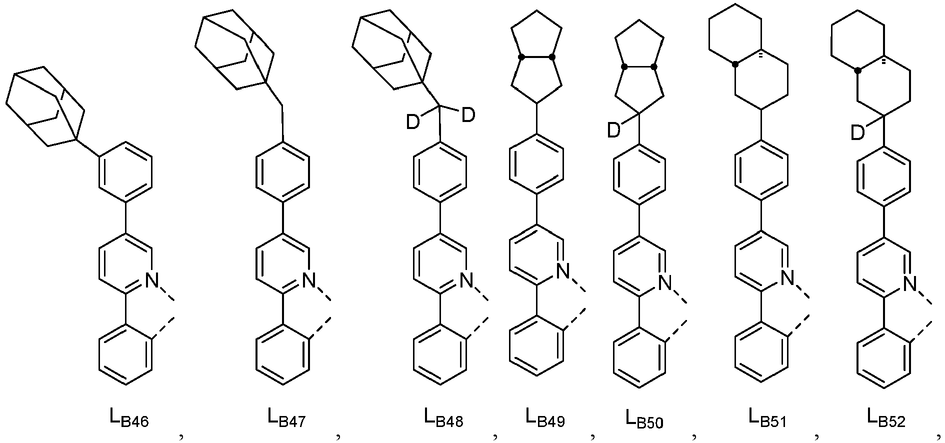 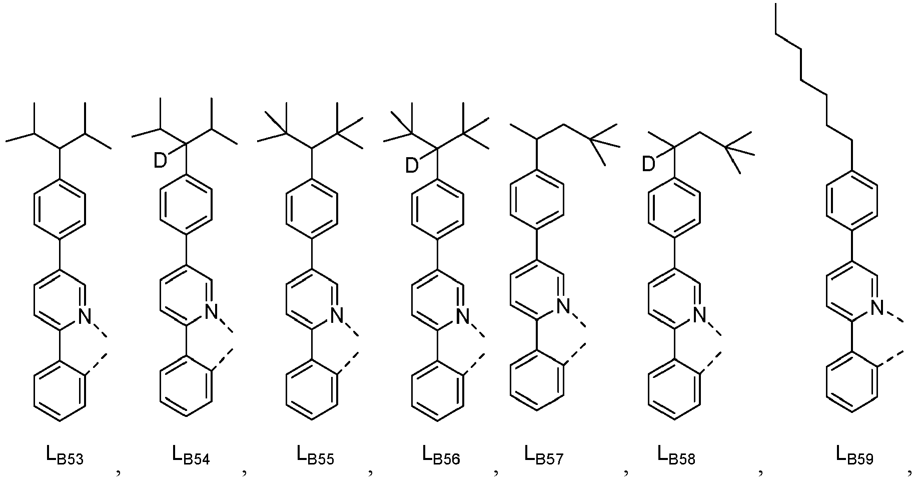 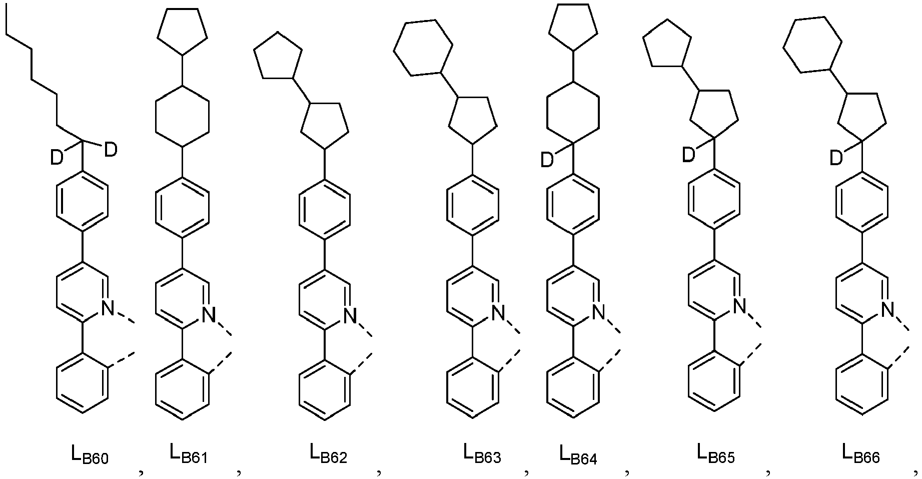 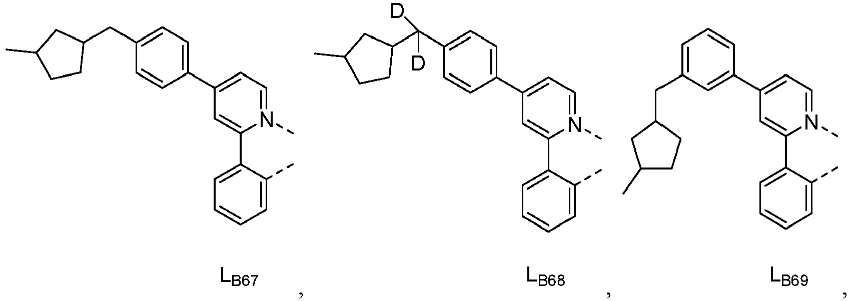 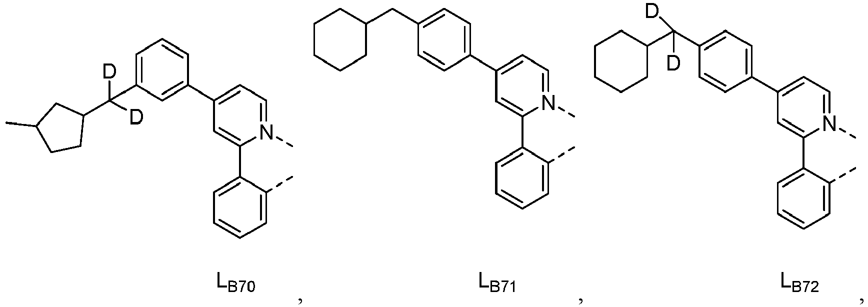 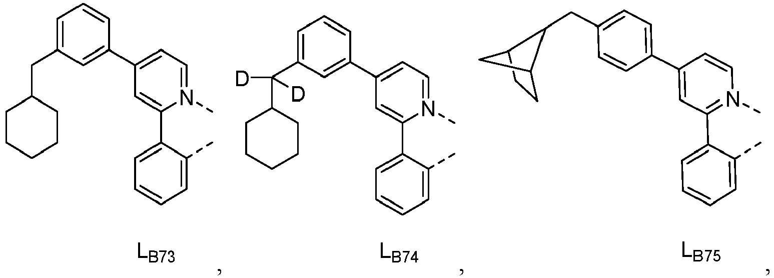 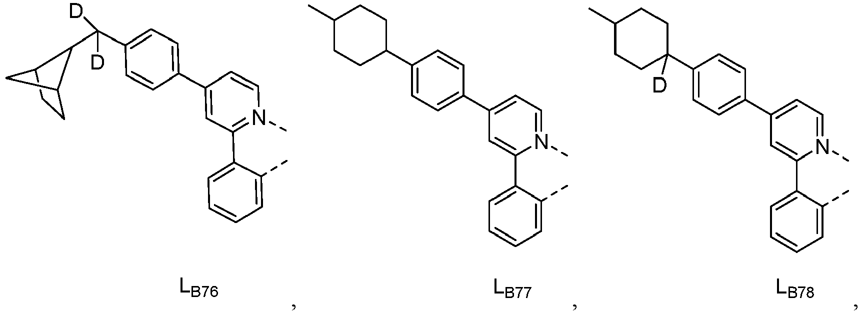 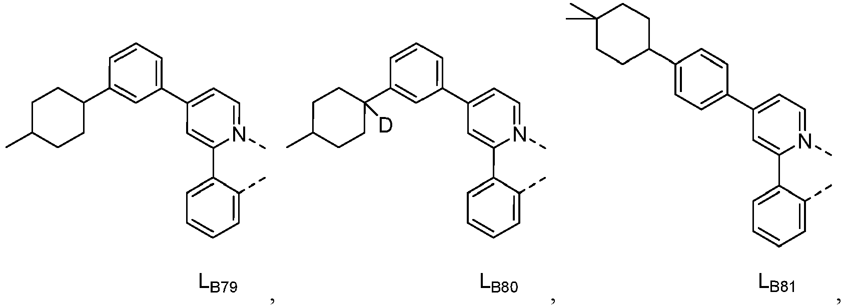 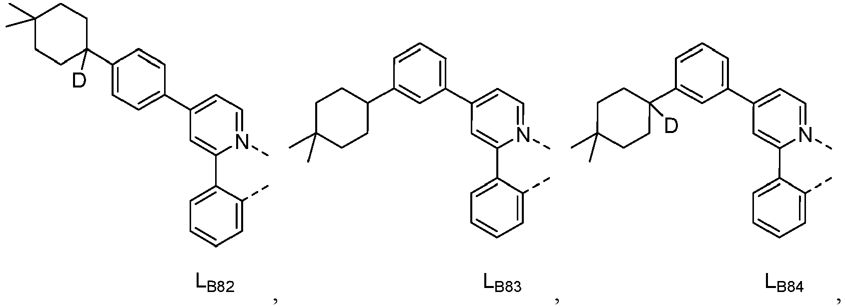 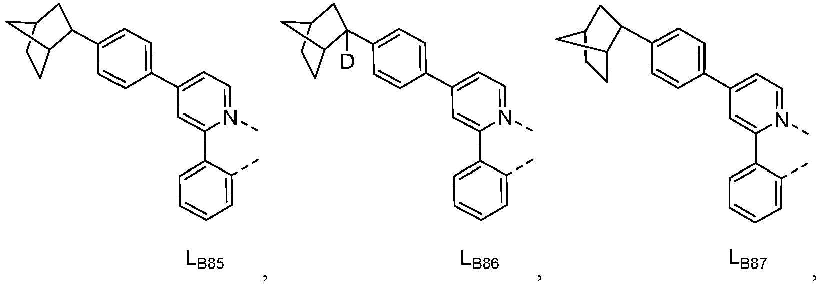 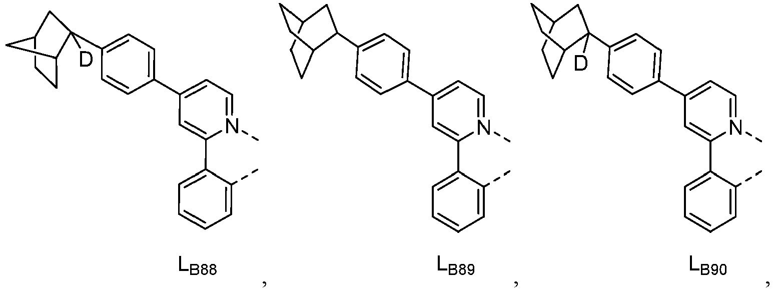 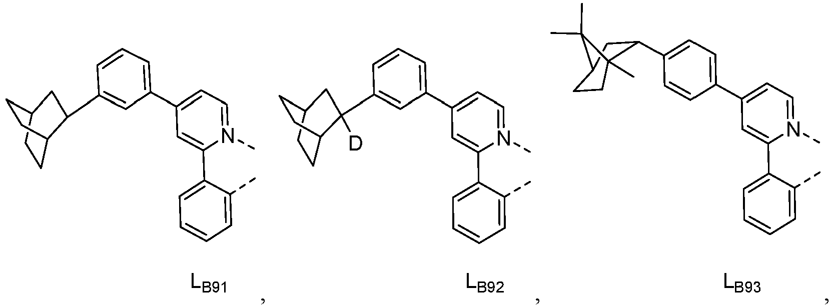 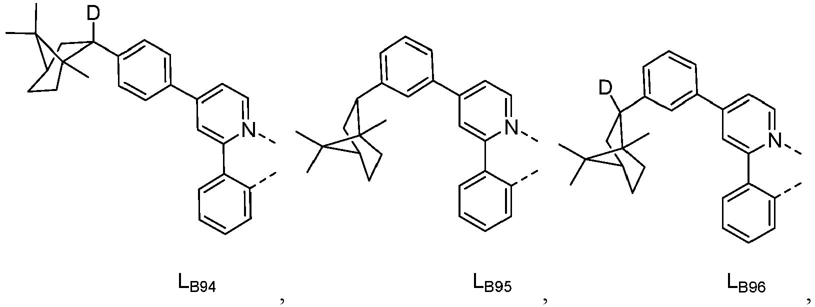 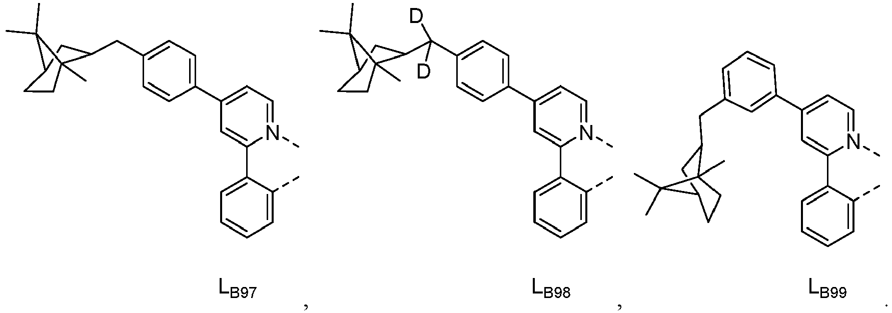 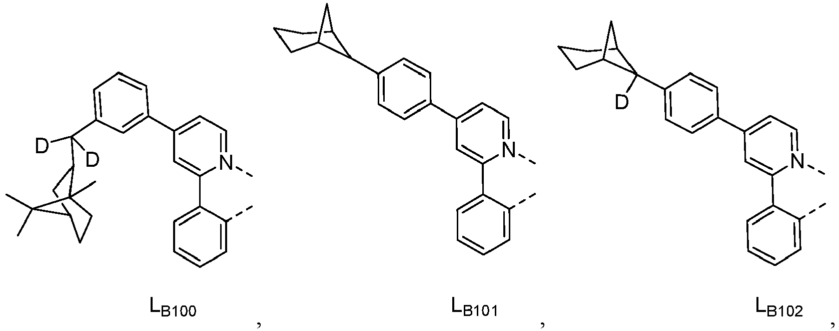 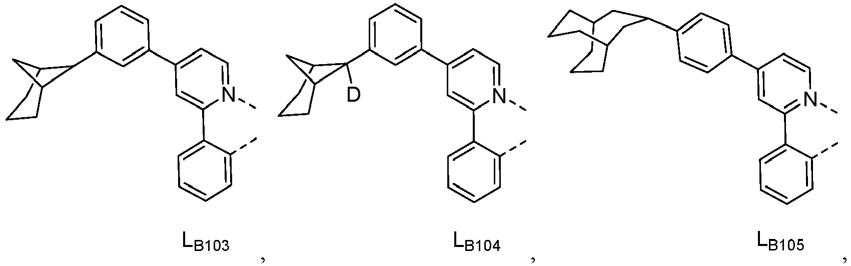 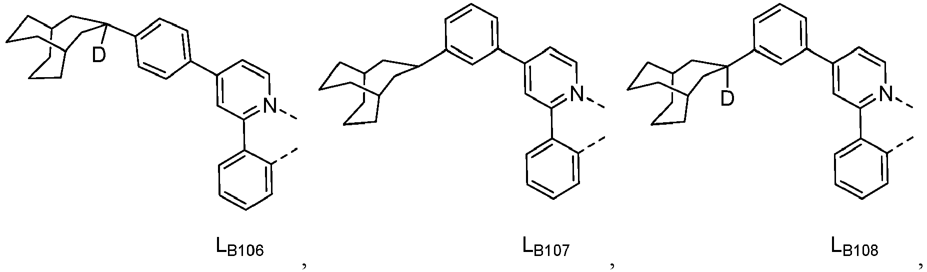 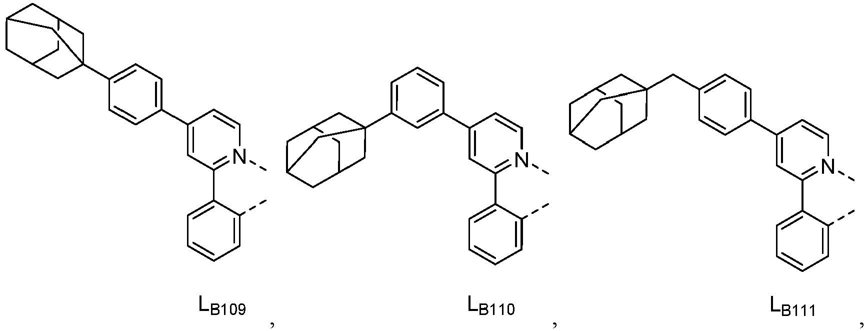 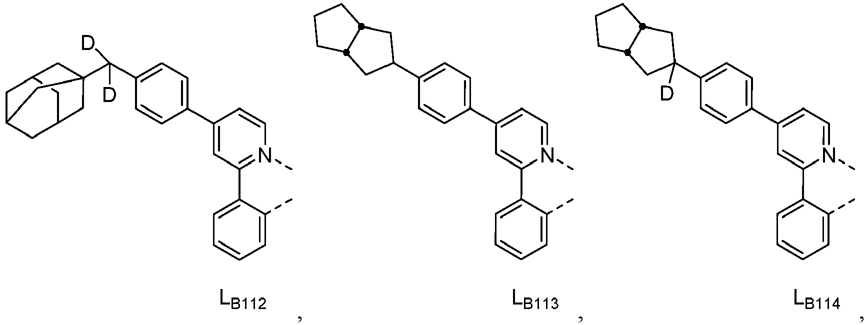 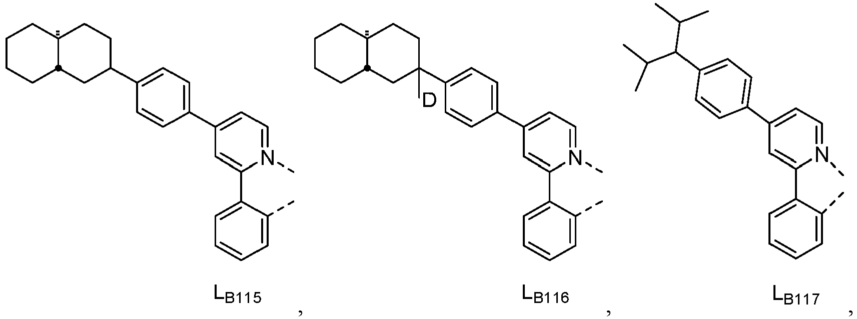 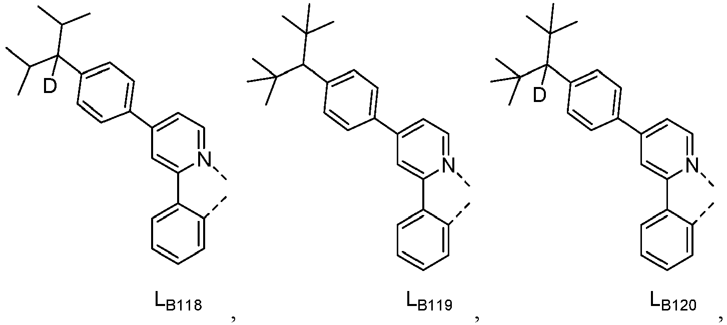 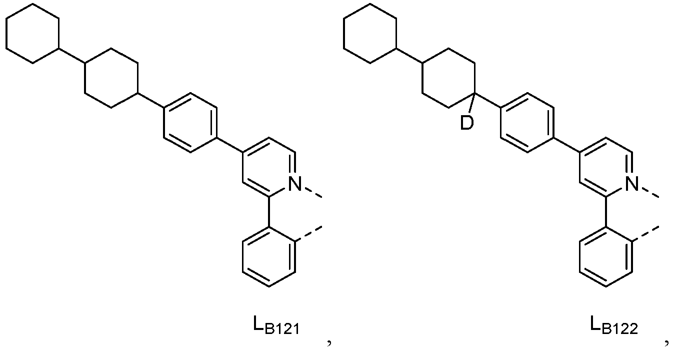 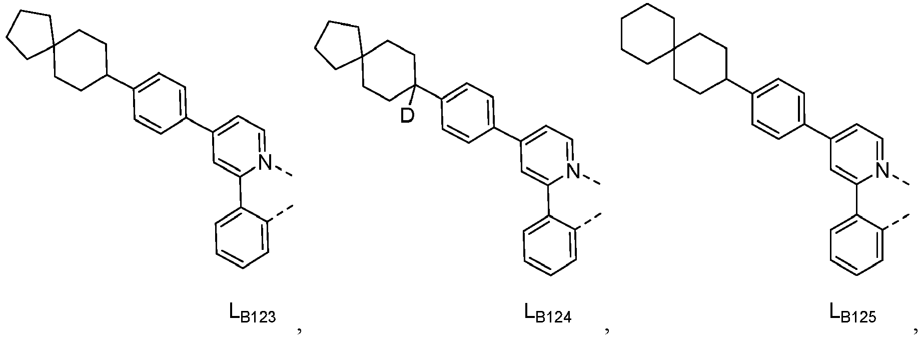 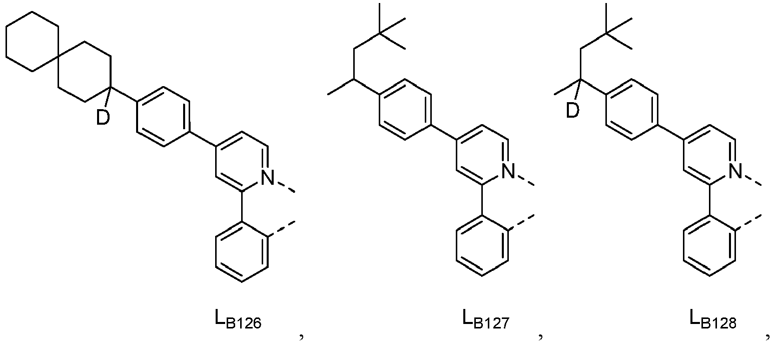 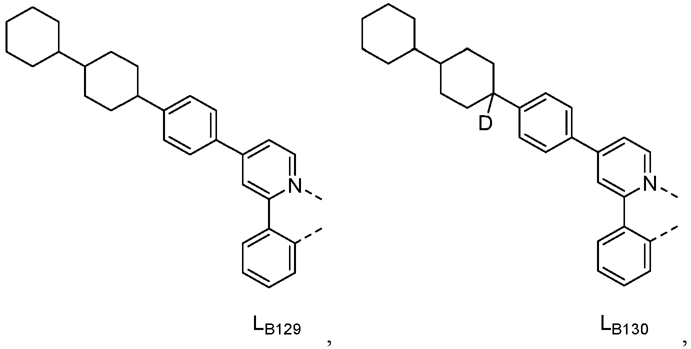 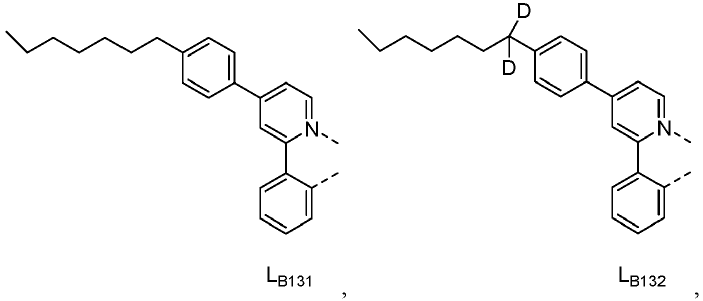 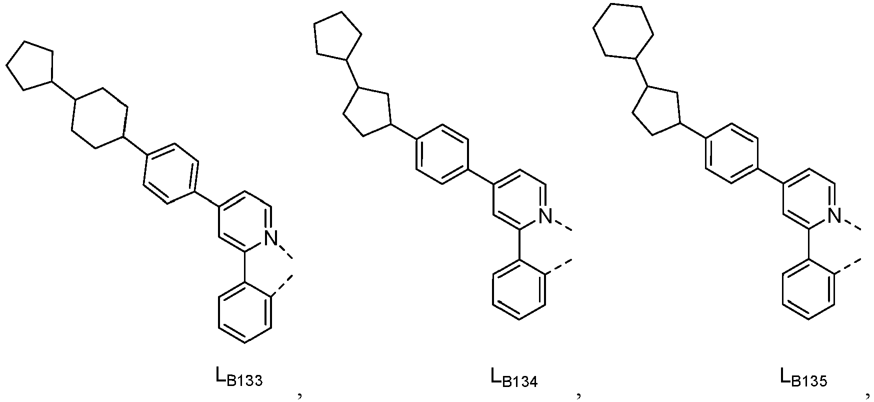 and

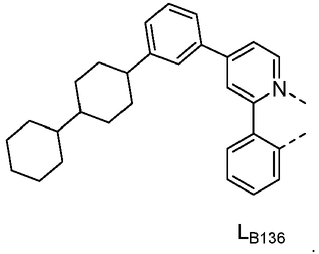

4. An organic light-emitting device (OLED) comprising:
an anode; a cathode; and
an organic layer, disposed between the anode and the cathode, comprising a compound having a formula according to any one of the preceding claims.

## Patentansprüche

1. Eine Verbindung mit der Formel Ir(L_{A})ₘ(L_{B})₃₋ₘ, deren Struktur ausgewählt ist aus der Gruppe bestehend aus 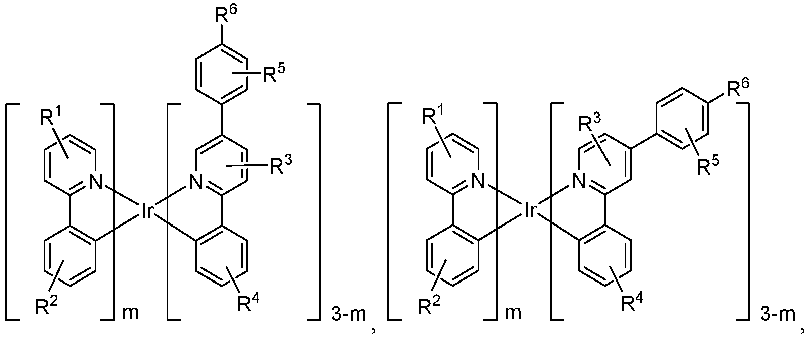 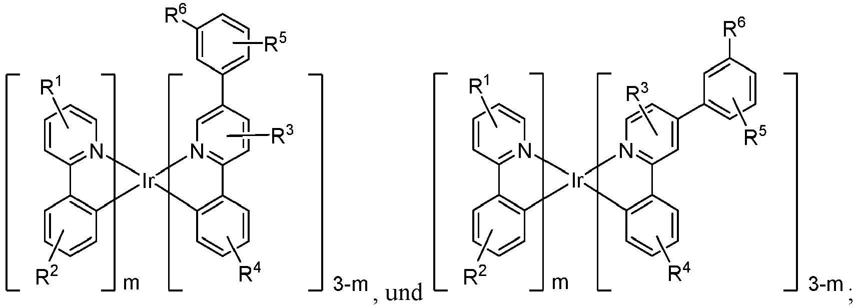
worin m 1 oder 2 ist;
worin R¹, R², R⁴, und R⁵ unabhängig voneinander jeweils eine Mono-, Di-, Tri-, oder Tetra-Substitution oder keine Substitution repräsentieren;
worin R³ eine Mono-, Di-, oder Tri--Substitution oder keine Substitution repräsentiert;
worin R¹, R², R³, R⁴, und R⁵ unabhängig voneinander jeweils ausgewählt sind aus der Gruppe bestehend aus Wasserstoff, Deuterium, C1 bis C6 Alkyl, C1 bis C6 Cycloalkyl, und partiell oder komplett deuterierten oder fluorinierten Varianten davon; und
worin R⁶ ausgewählt ist aus der Gruppe bestehend aus Alkyl mit wenigstens sieben Kohlenstoffatomen, Cycloalkyl mit wenigstens sieben Kohlenstoffatomen, Alkyl-Cycloalkyl mit wenigstens sieben Kohlenstoffatomen, und partiell oder komplett deuterierten oder fluorinierten Varianten davon.

2. Die Verbindung gemäß Anspruch 1, worin L_{A} ausgewählt ist aus der Gruppe bestehend aus: 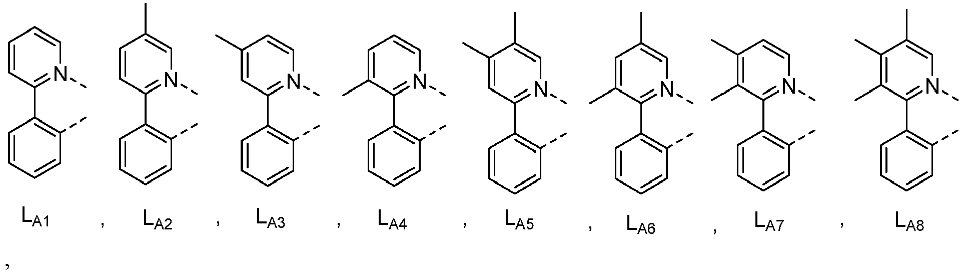 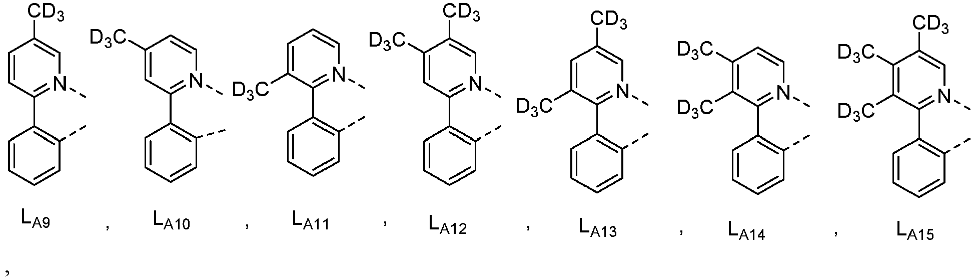 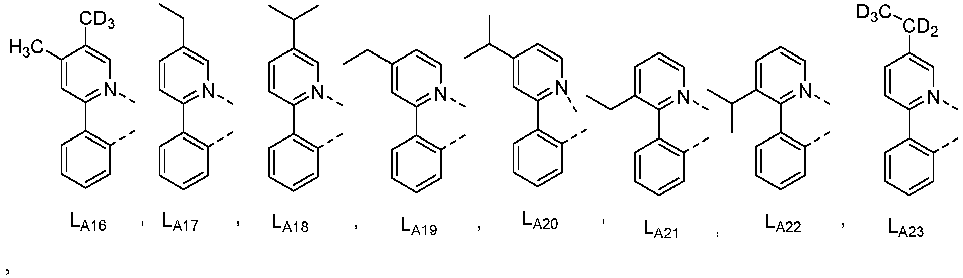 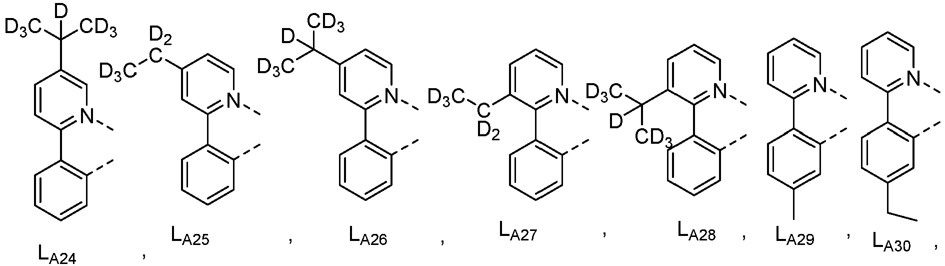 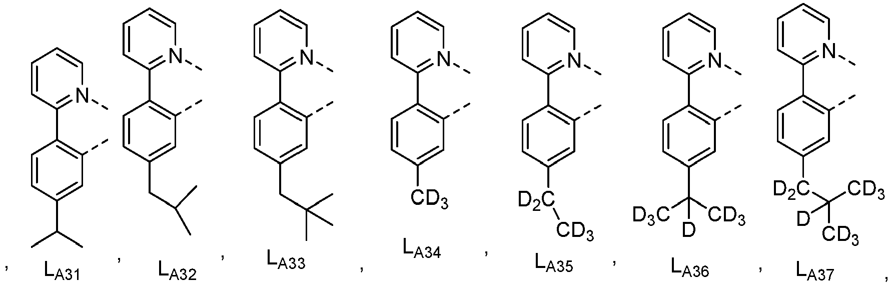 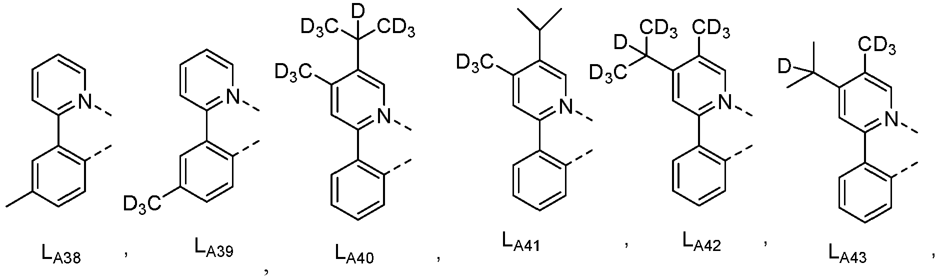 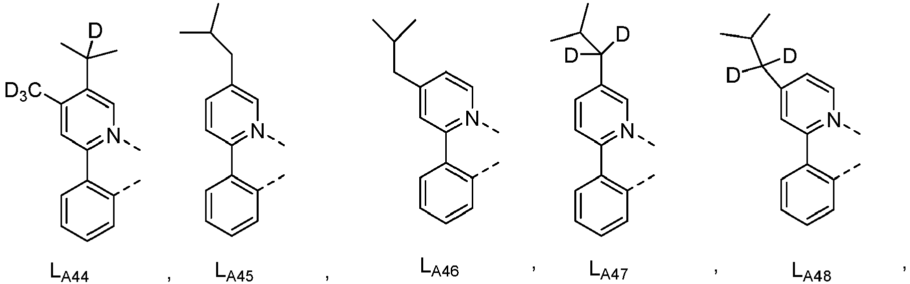 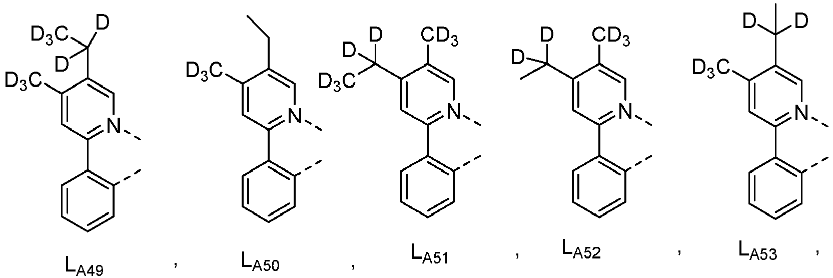 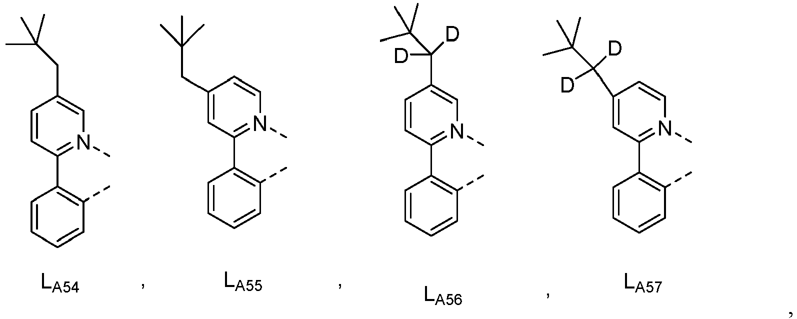 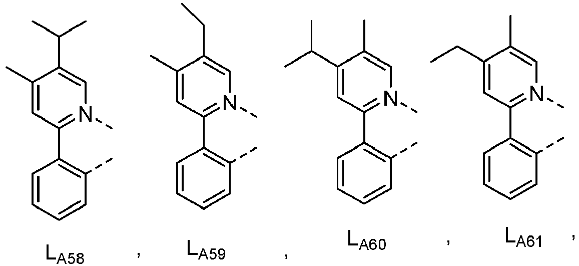 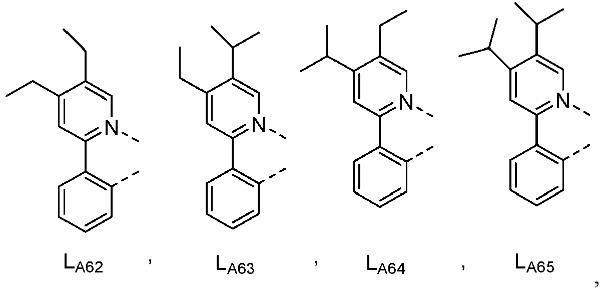 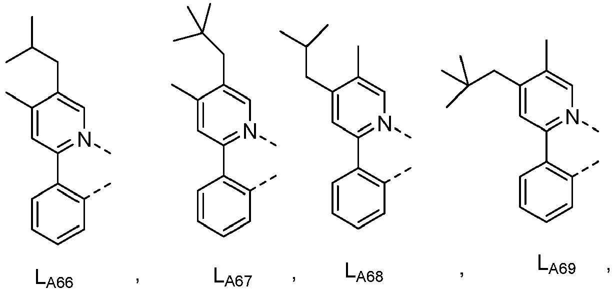 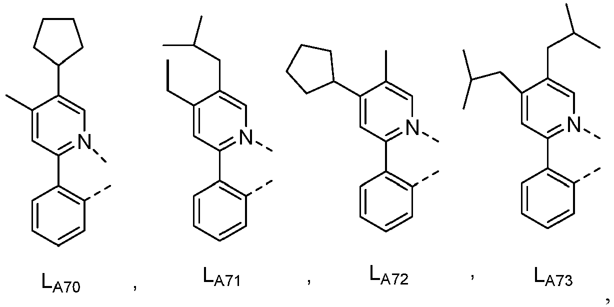 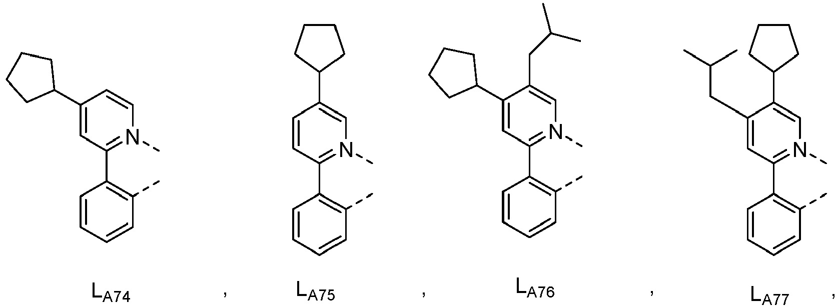 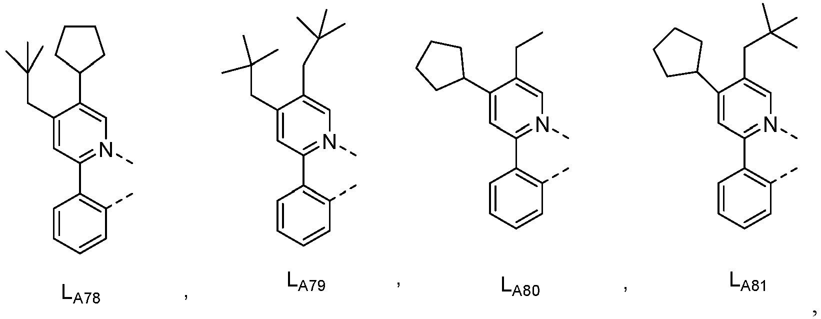 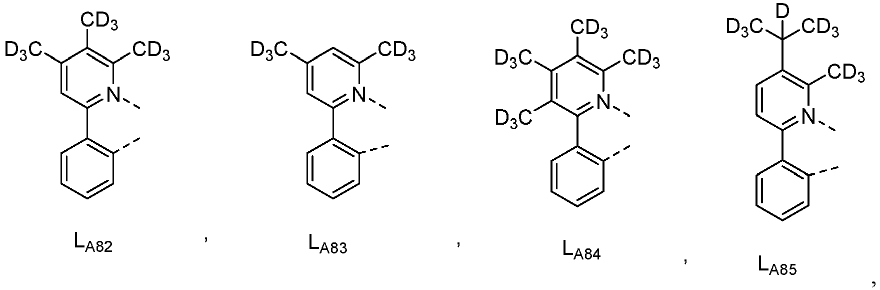 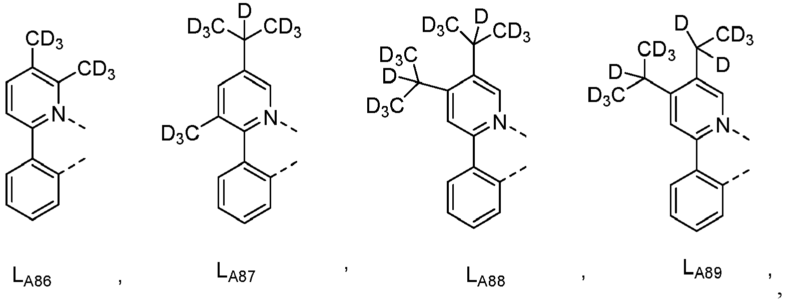 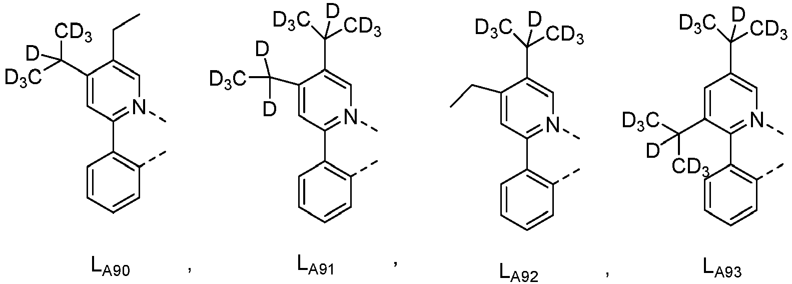 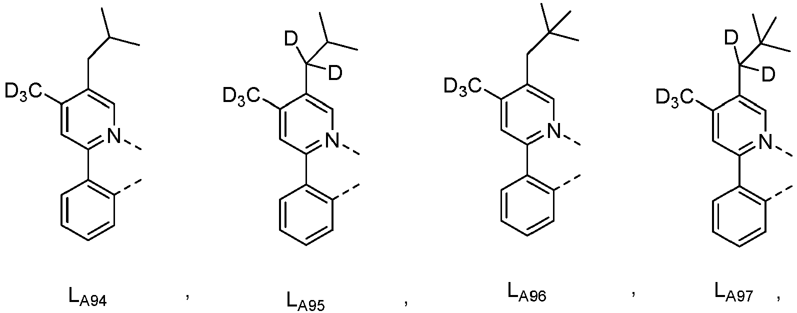 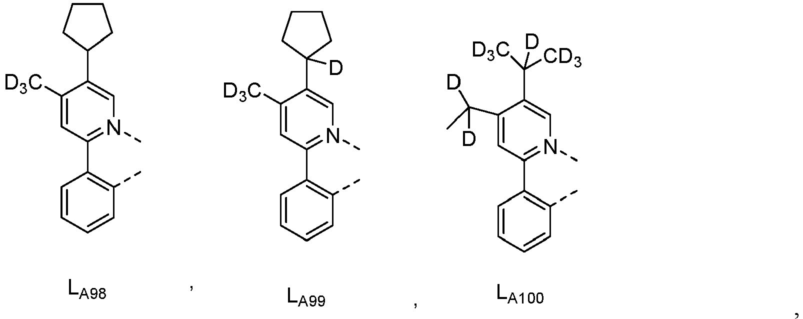 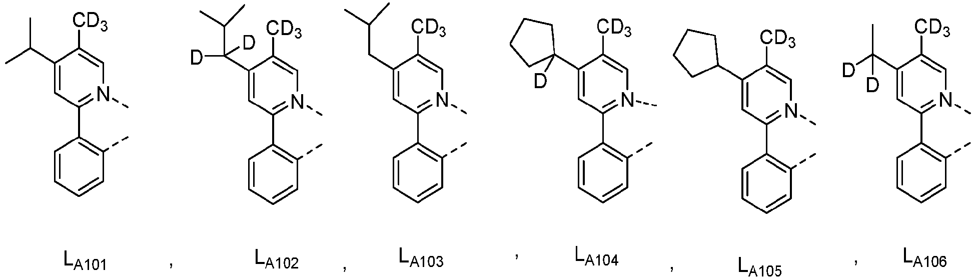 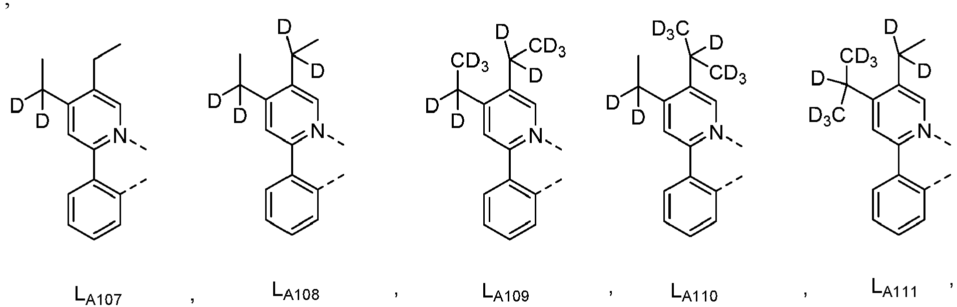 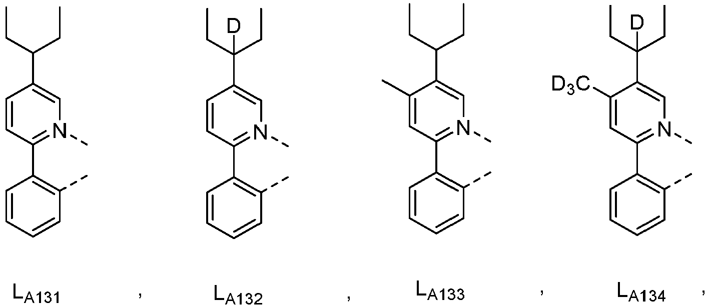 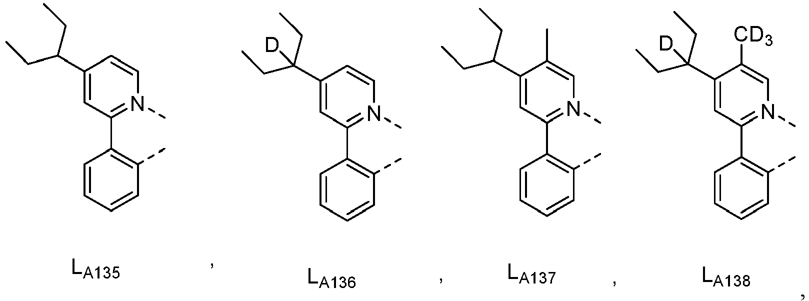 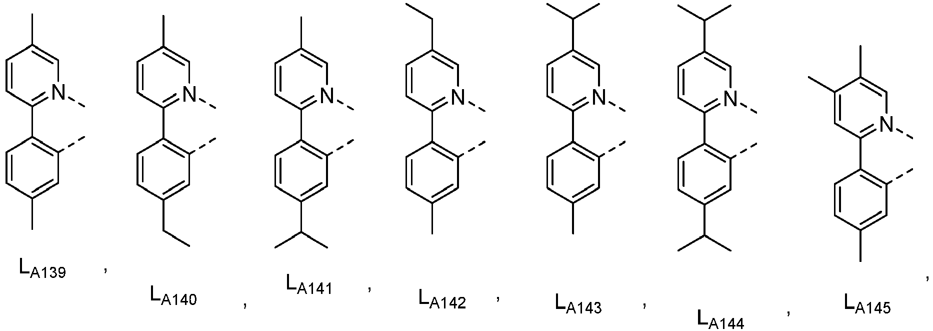 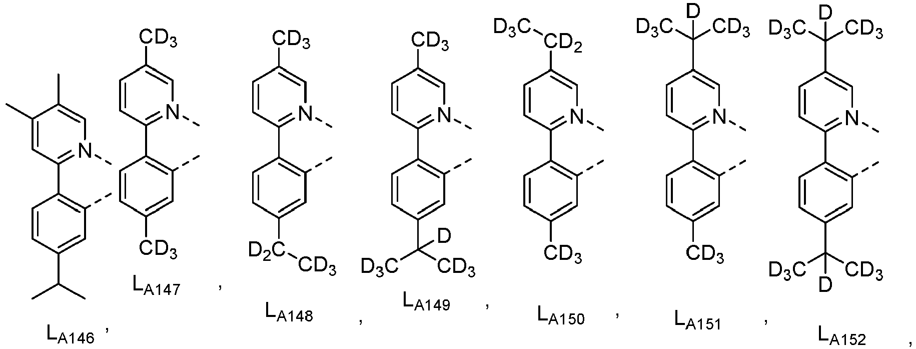 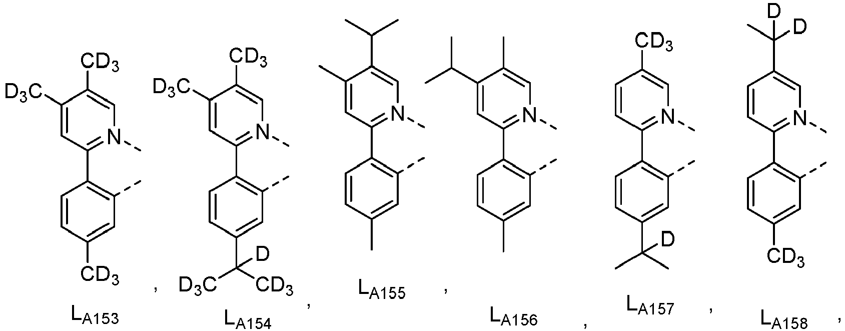 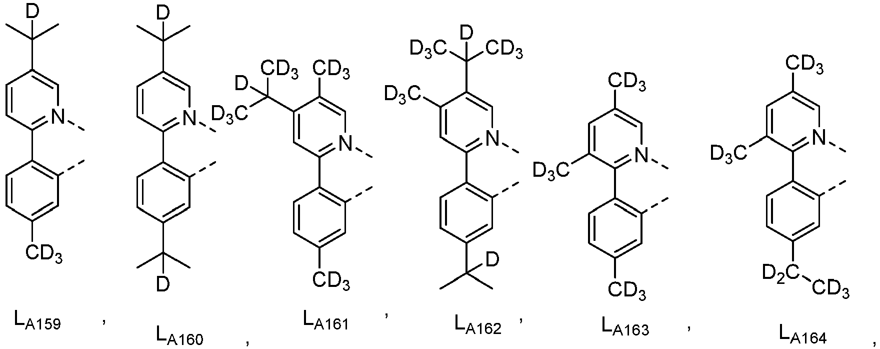 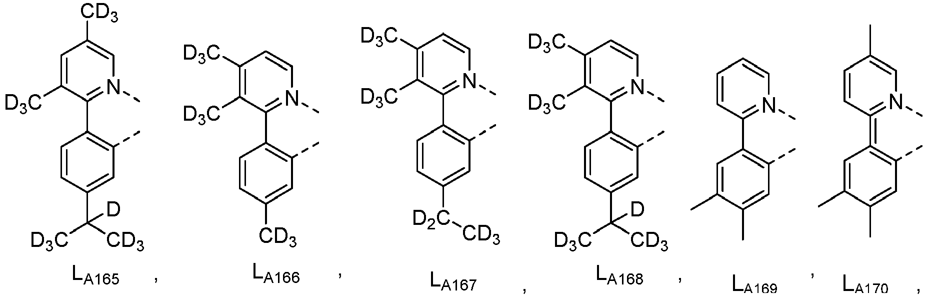 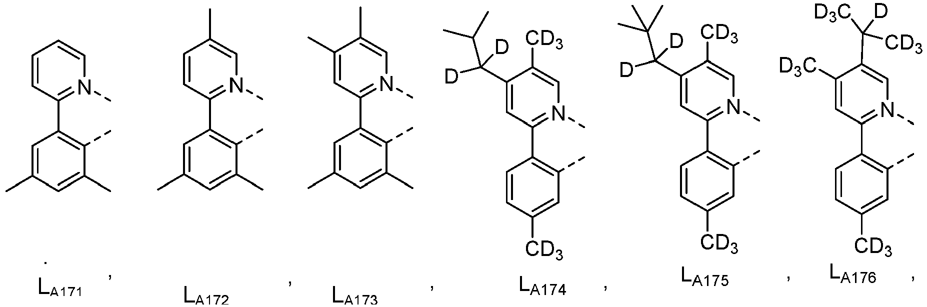 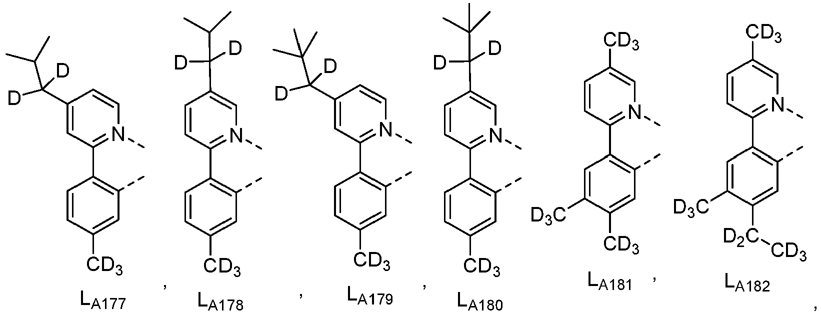 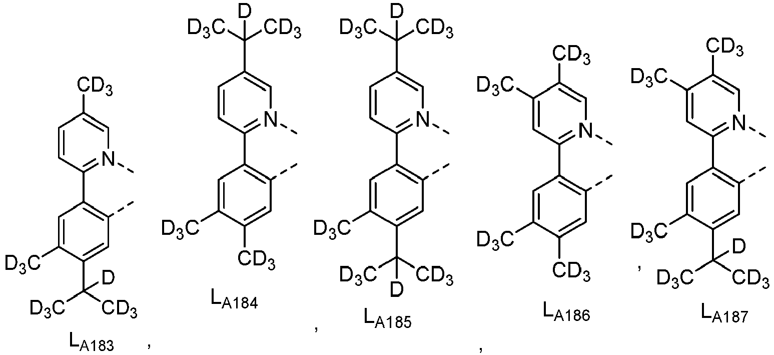 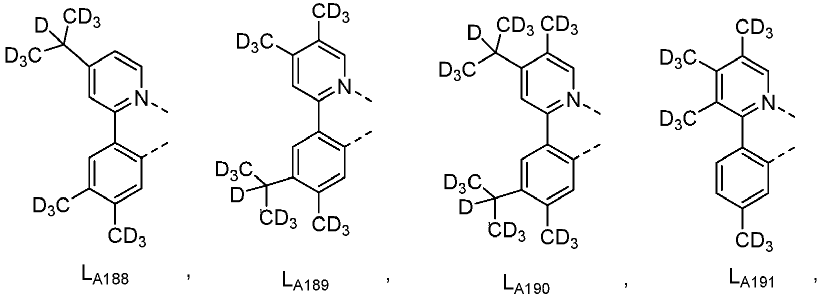 und

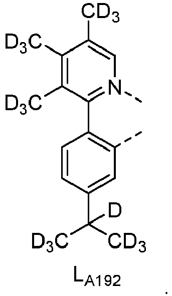

3. Die Verbindung gemäß Anspruch 1 oder 2, worin L_{B} ausgewählt ist aus der Gruppe bestehend aus: 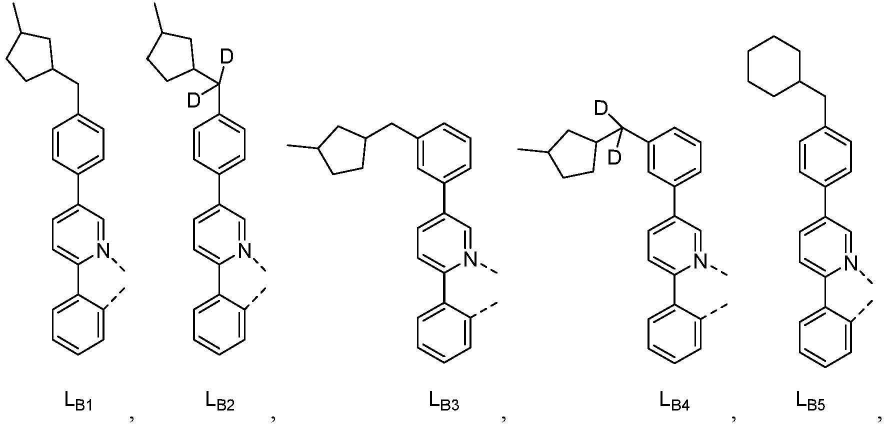 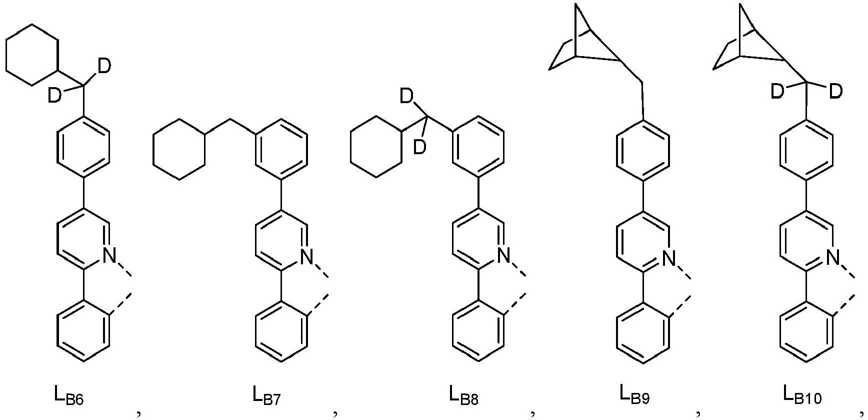 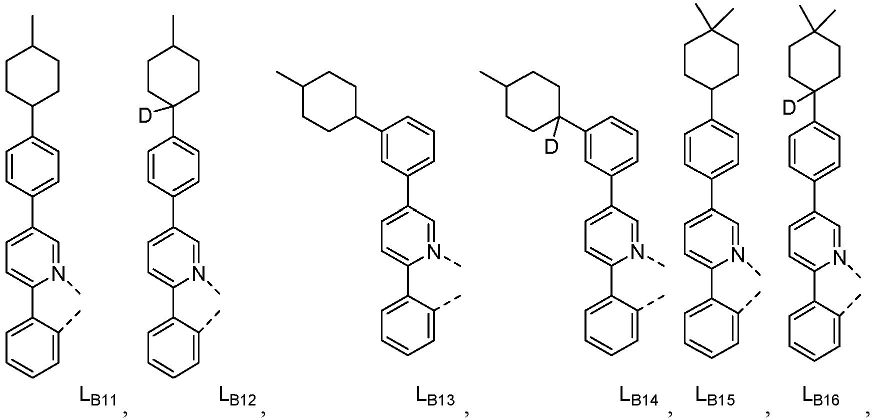 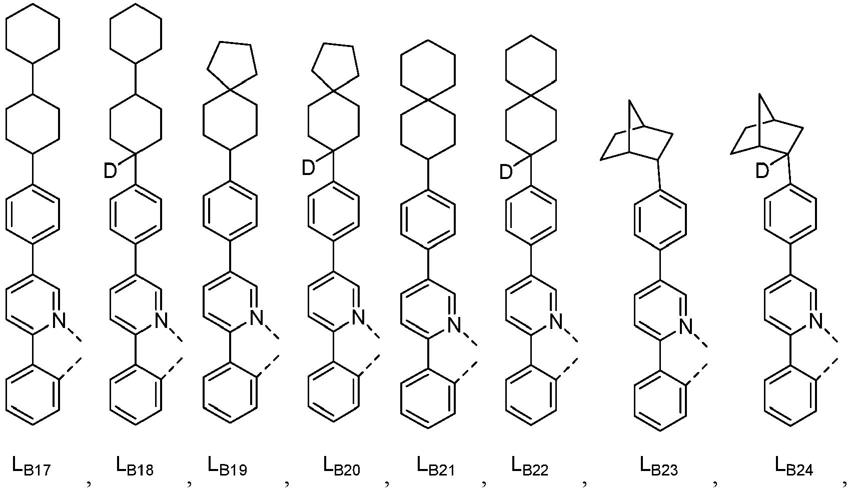 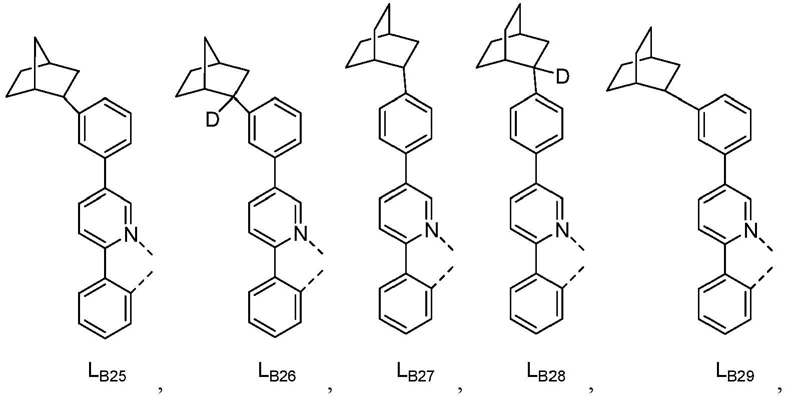 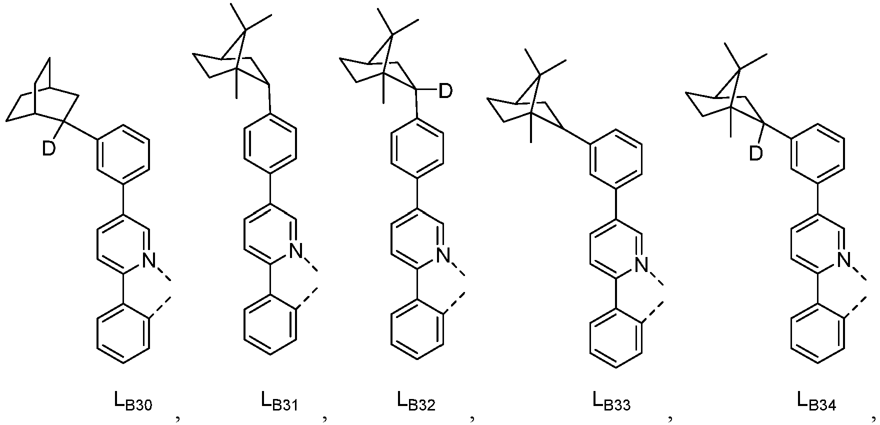 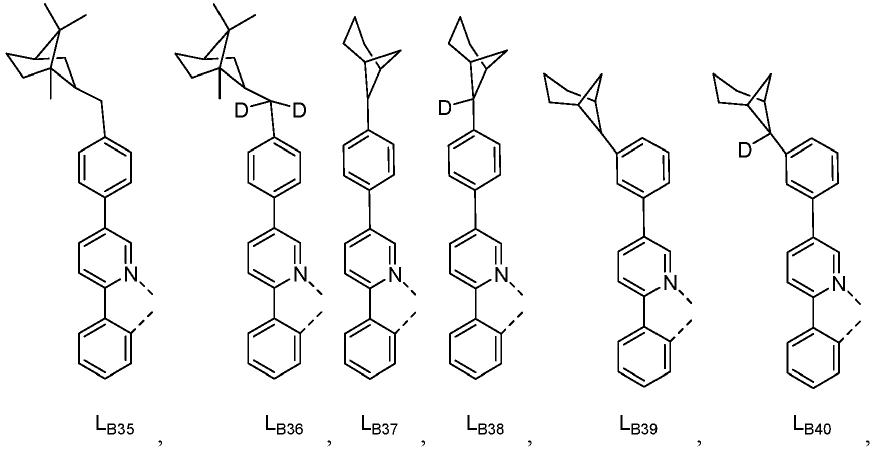 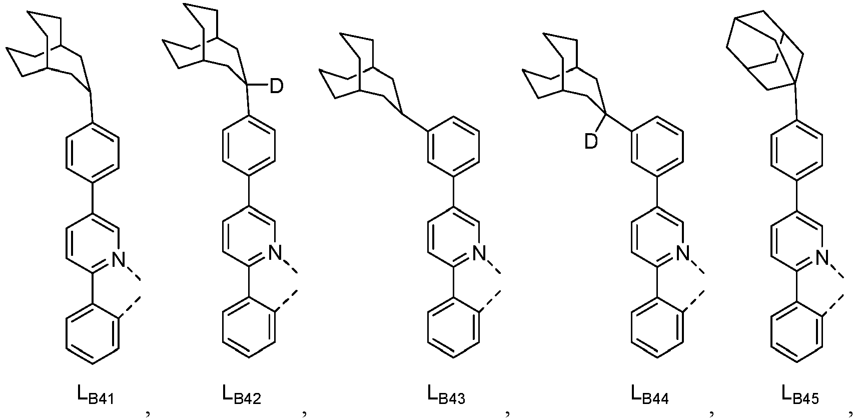 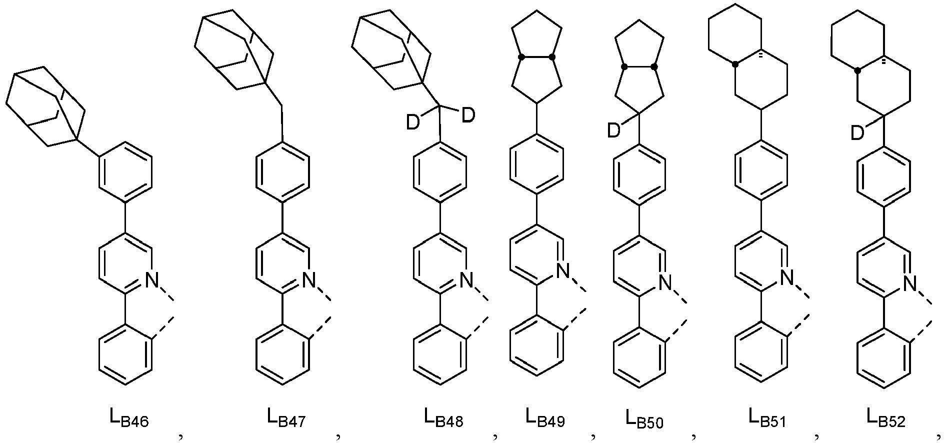 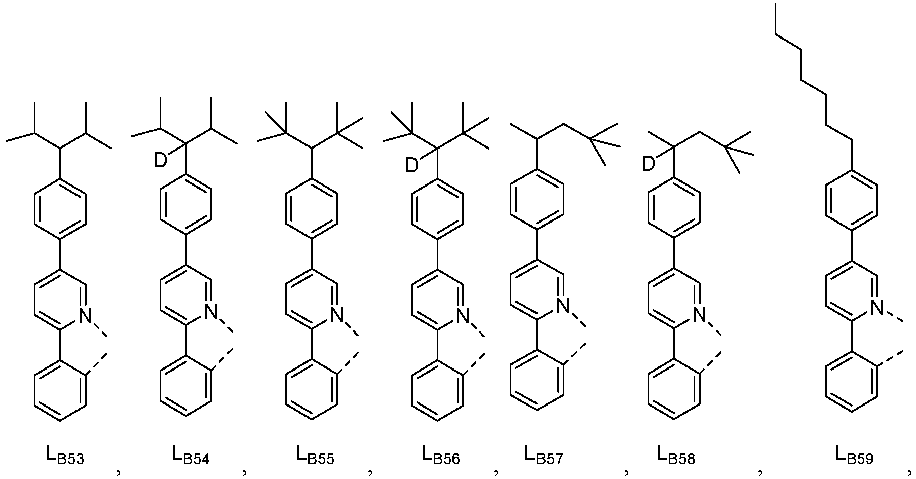 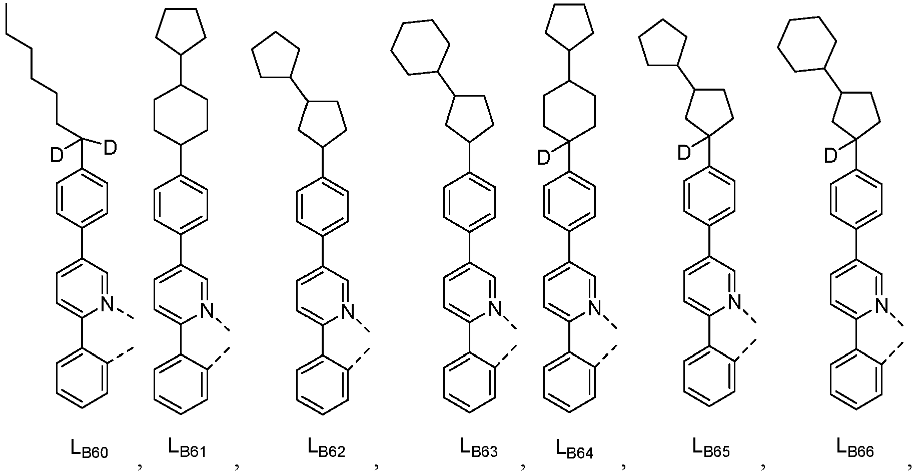 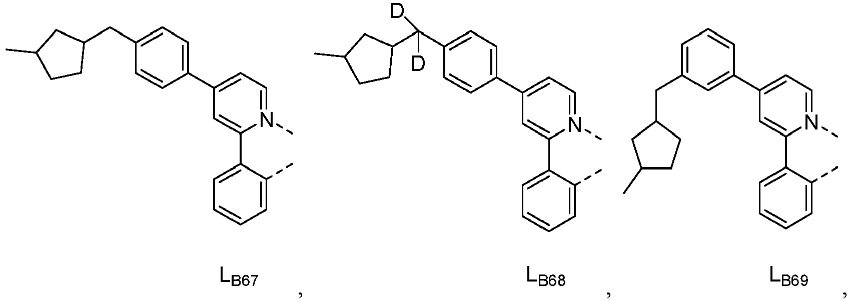 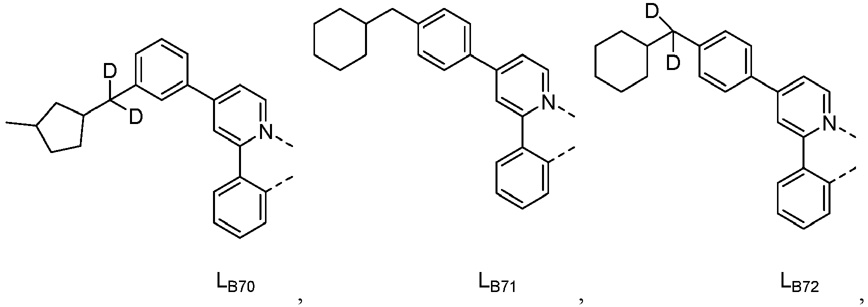 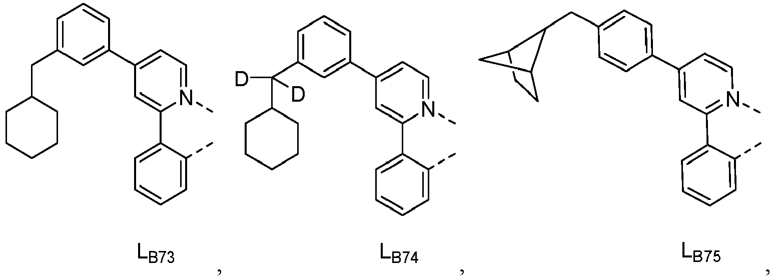 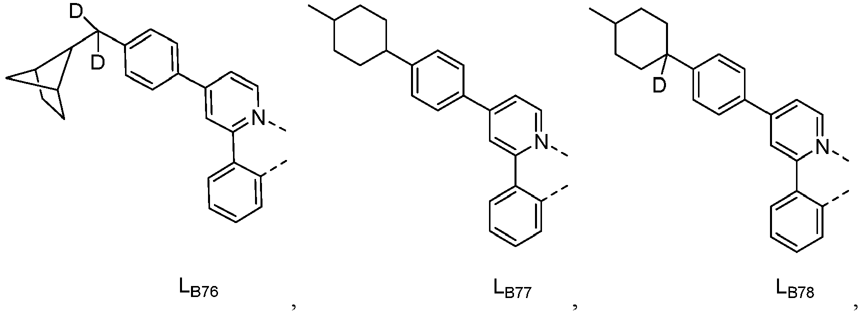 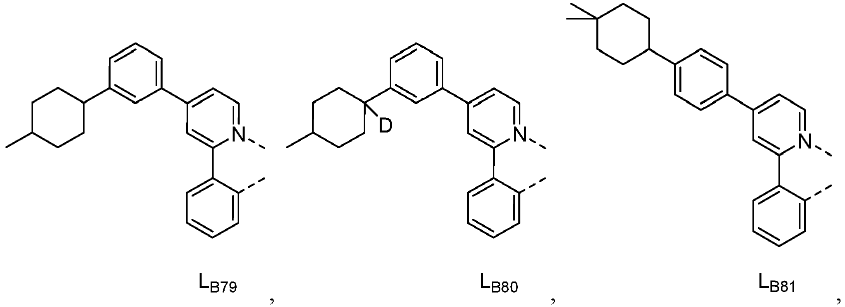 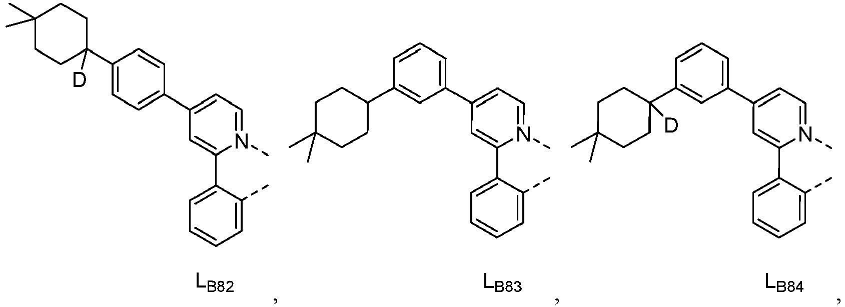 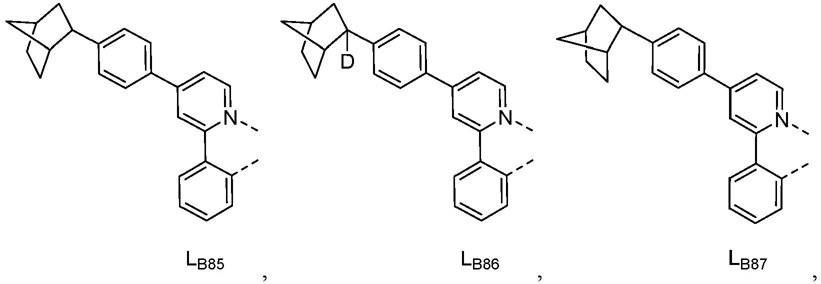 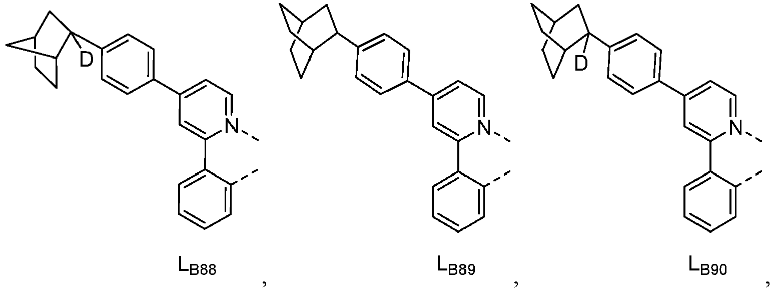 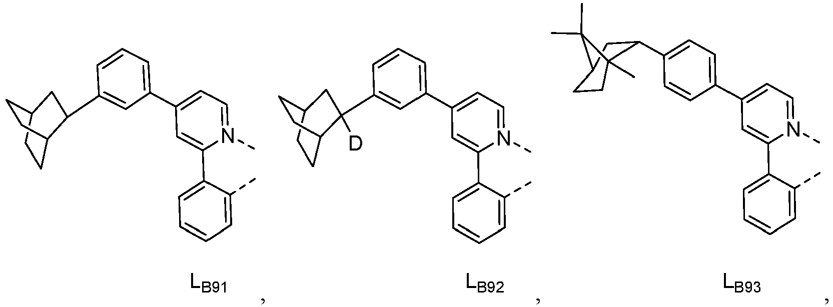 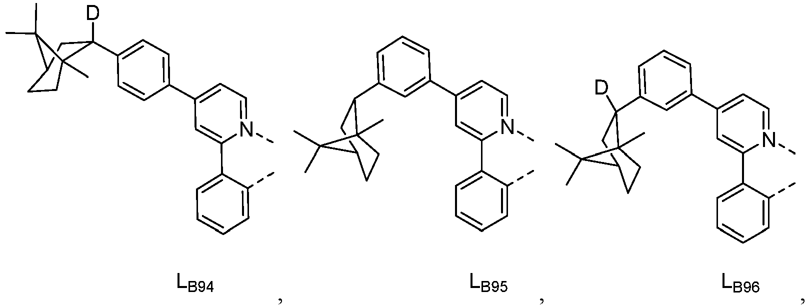 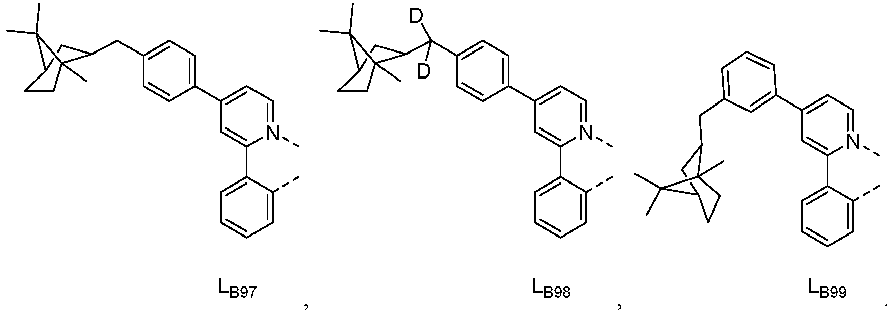 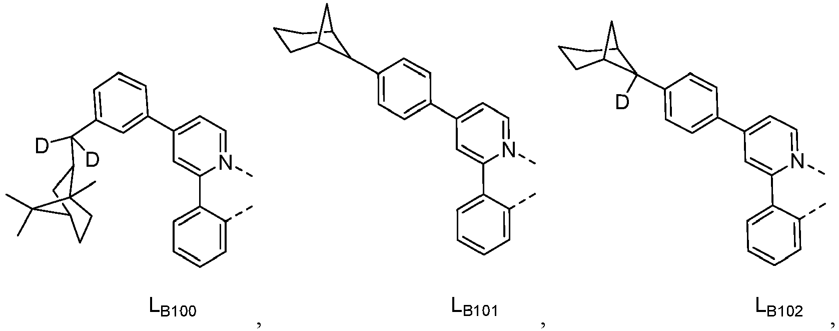 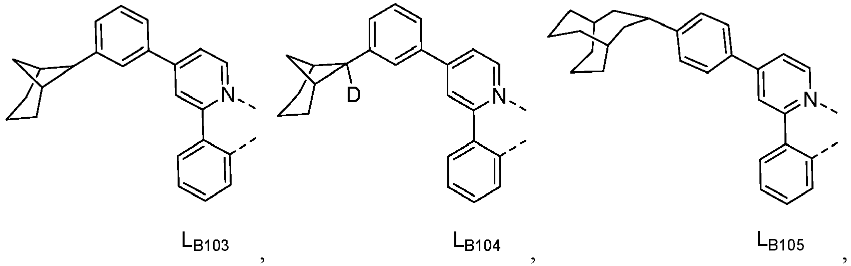 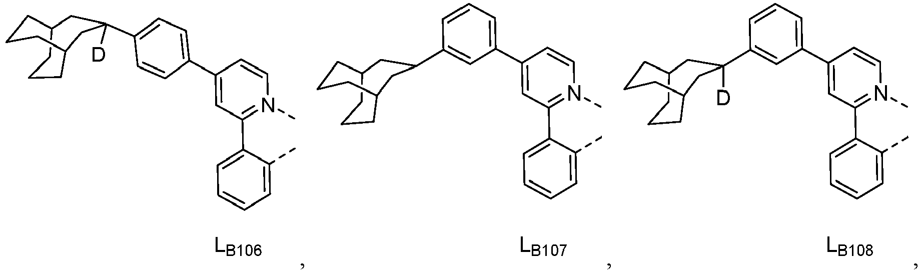 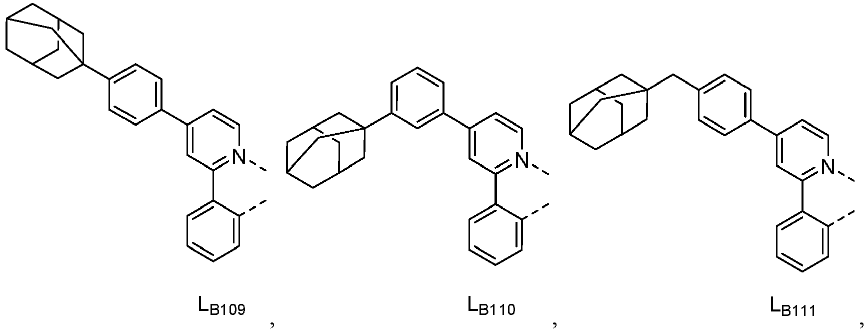 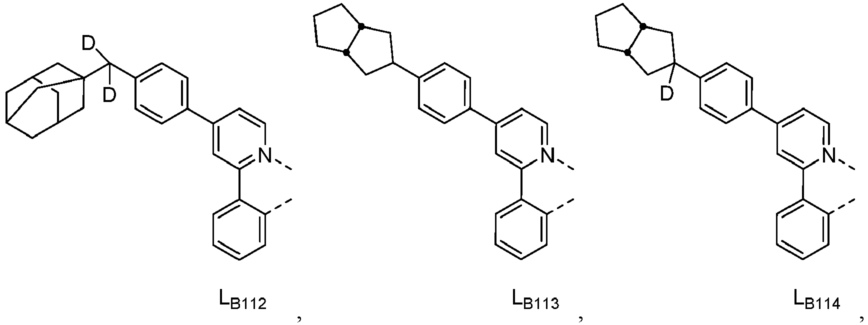 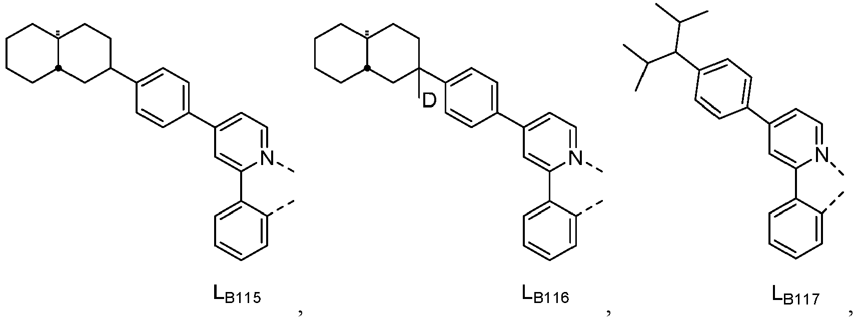 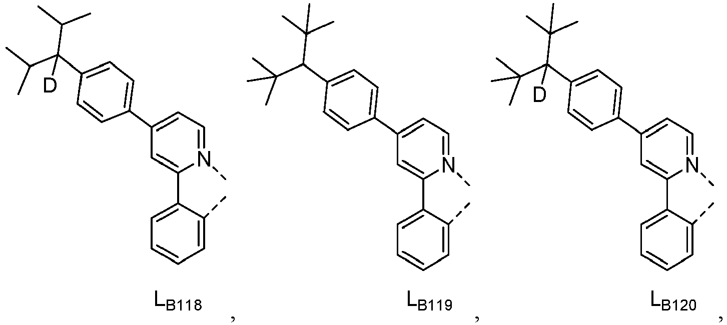 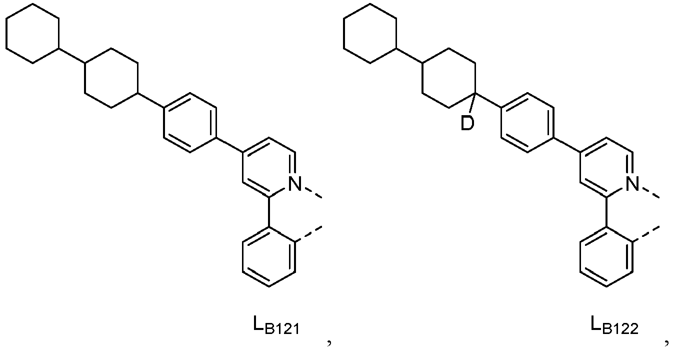 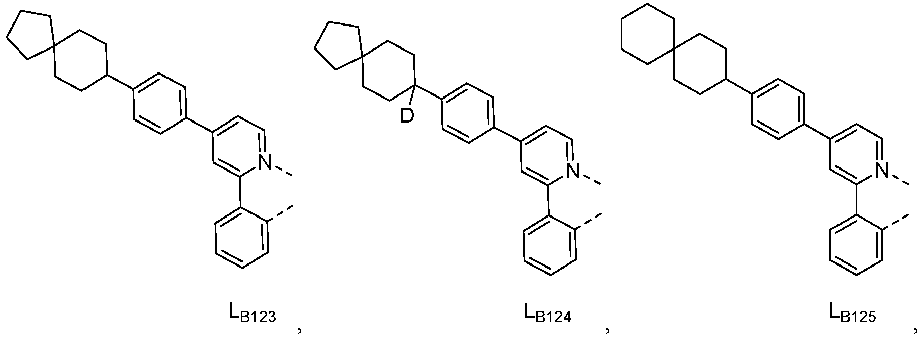 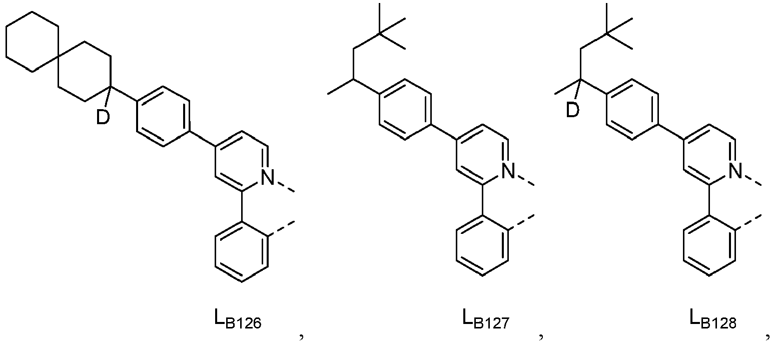 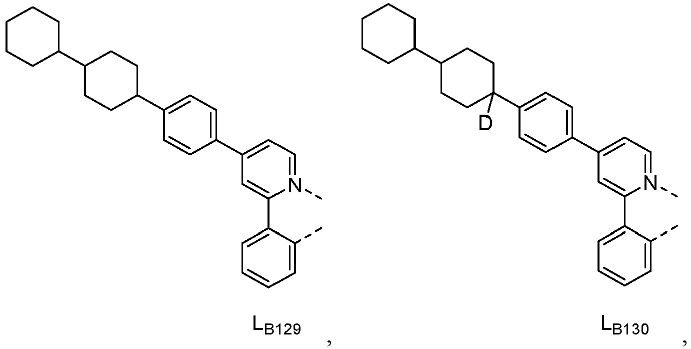 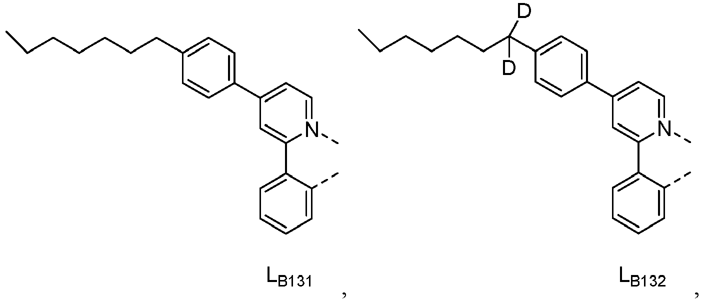 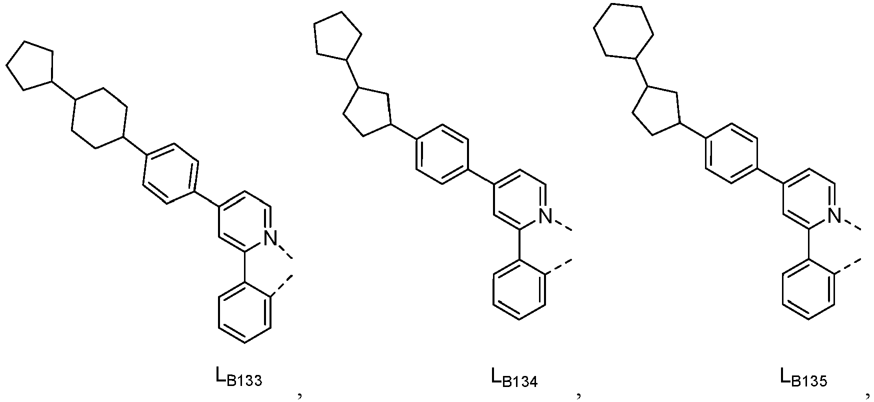 und

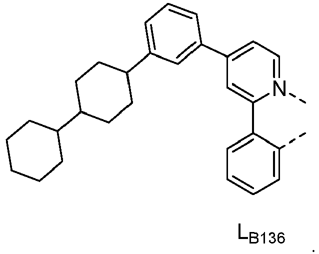

4. Eine Organische Lichtemittierende Vorrichtung (OLED) umfassend:
eine Anode; eine Kathode; und
eine organische Schicht zwischen der Anode und der Kathode, umfassend eine Verbindung mit einer Formel entsprechend irgendeinem der vorhergehenden Ansprüche.

## Revendications

1. Composé ayant la formule Ir(L_{A})ₘ(L_{B})₃₋ₘ qui a une structure choisie dans le groupe constitué par 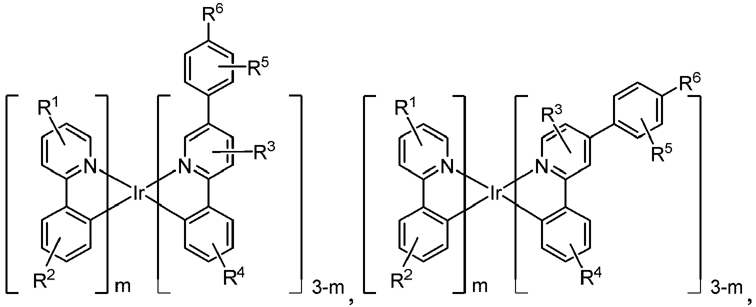 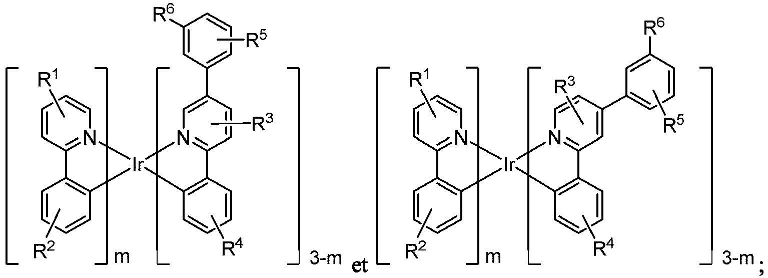
où m vaut 1 ou 2 ;
où R¹, R², R⁴ et R⁵ représentent chacun indépendamment une mono-, di-, tri ou tétra-substitution, ou aucune substitution ;
où R³ représente une mono-, di- ou tri-substitution, ou aucune substitution ;
où R¹, R², R³, R⁴ et R⁵ sont chacun indépendamment choisis dans le groupe constitué par hydrogène, deutérium, alkyle en C1 à C6, cycloalkyle en C1 à C6, et des variantes partiellement ou totalement deutérées ou fluorées de ceux-ci ; et
où R⁶ est choisi dans le groupe constitué par alkyle ayant au moins sept atomes de carbone, cycloalkyle ayant au moins sept atomes de carbone, alkyl-cycloalkyle ayant au moins sept atomes de carbone, et des variantes partiellement ou totalement deutérées ou fluorées de ceux-ci.

2. Composé selon la revendication 1, où L_{A} est choisi dans le groupe constitué par :

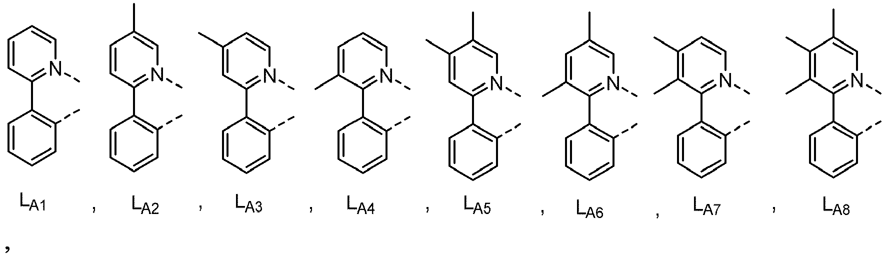

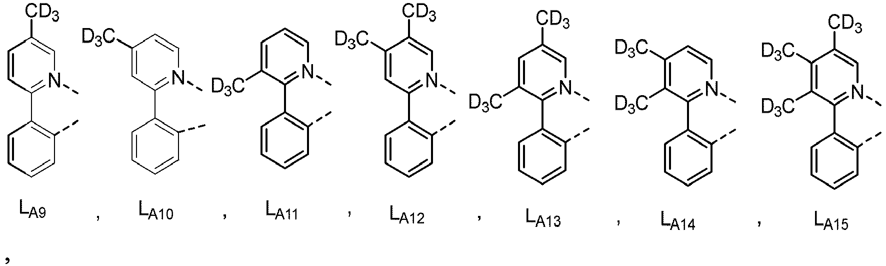

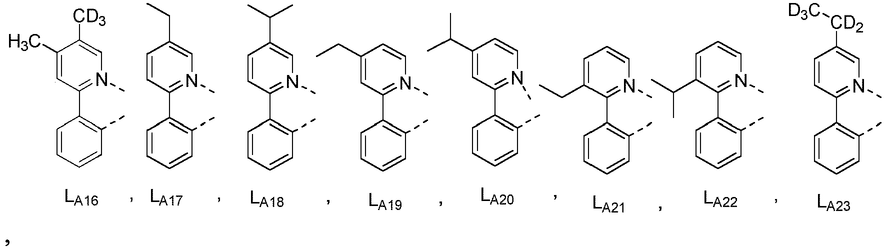

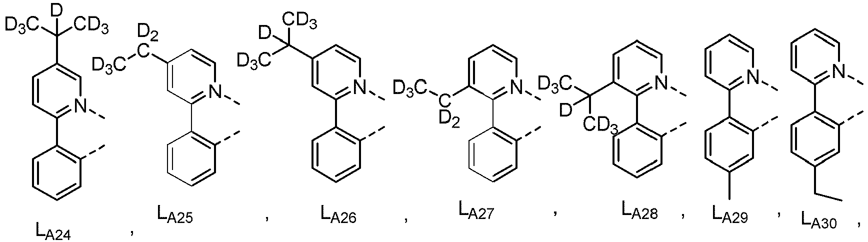

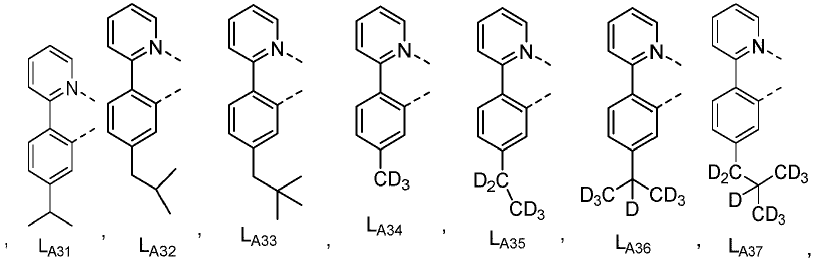

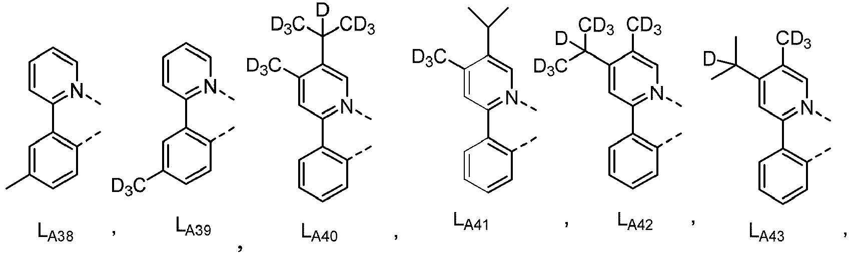

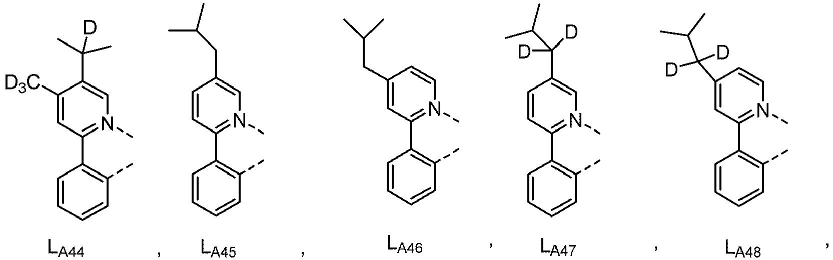

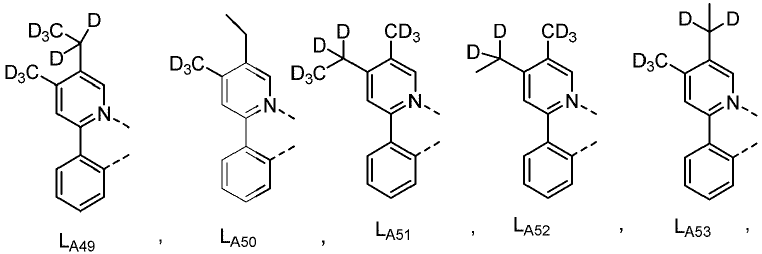

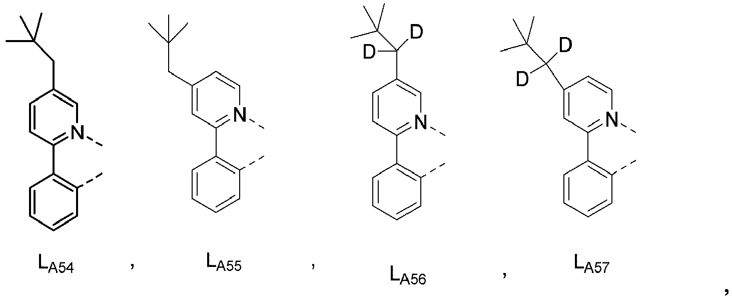

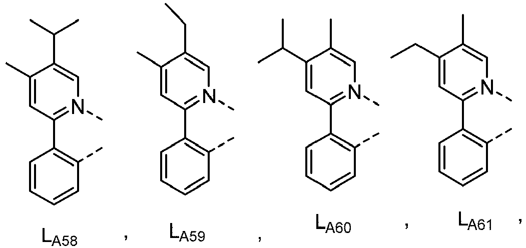

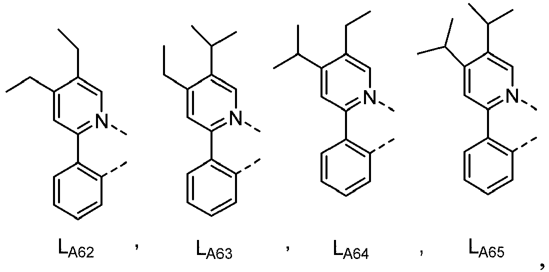

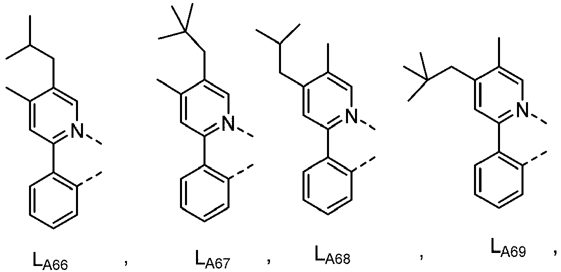

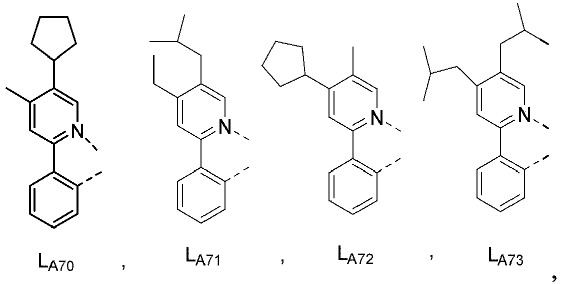

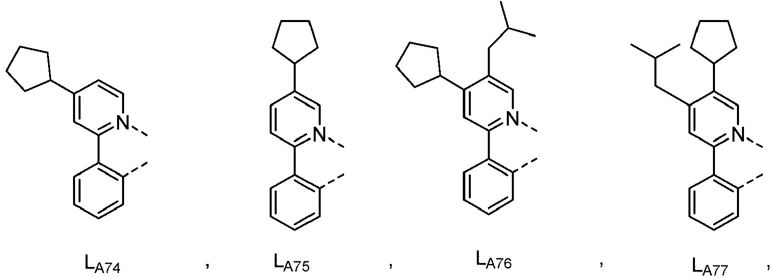

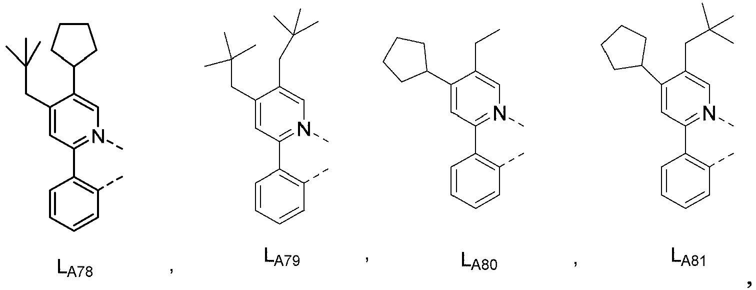

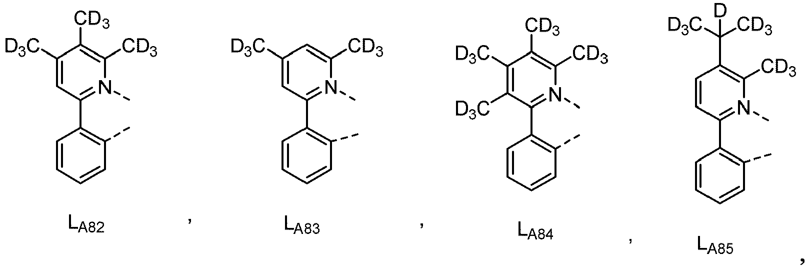

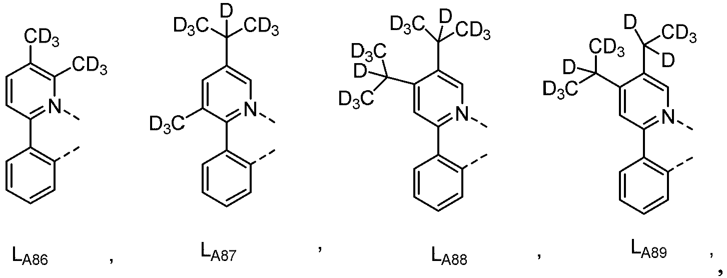

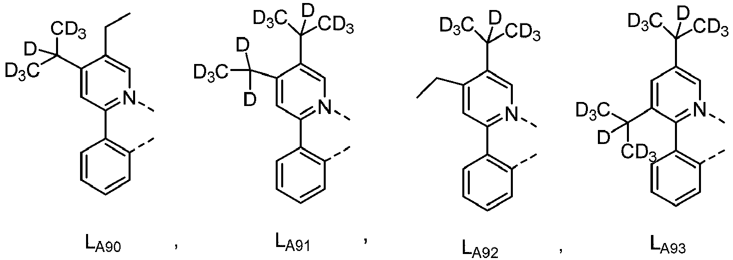

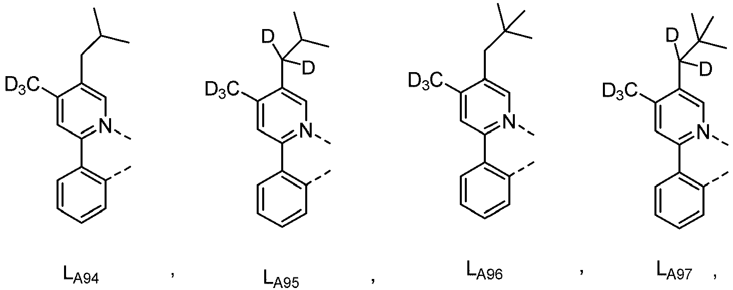

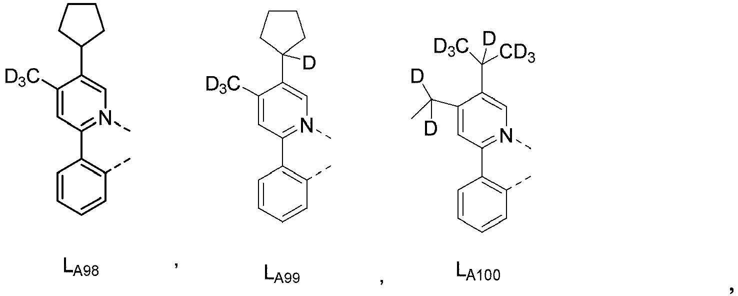

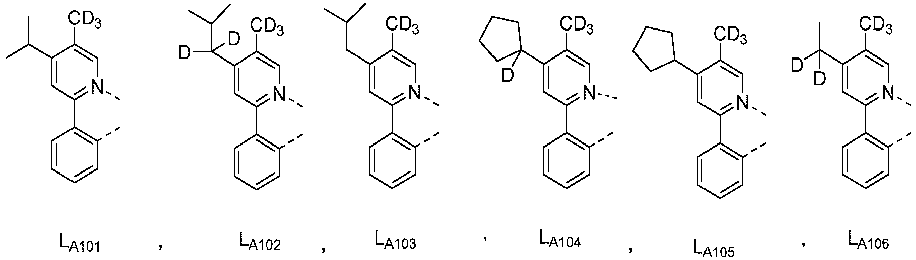

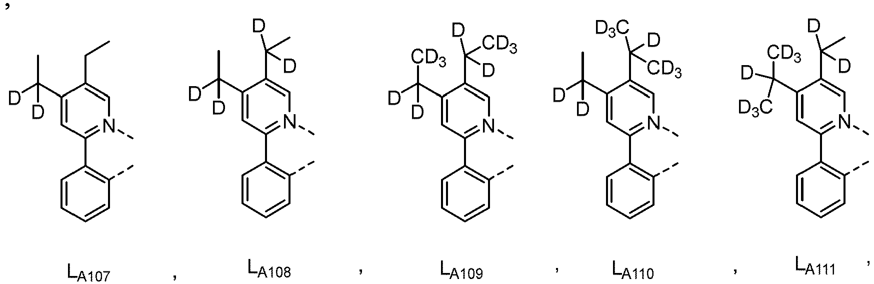

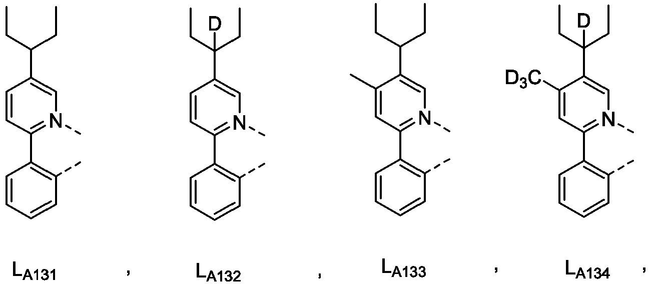

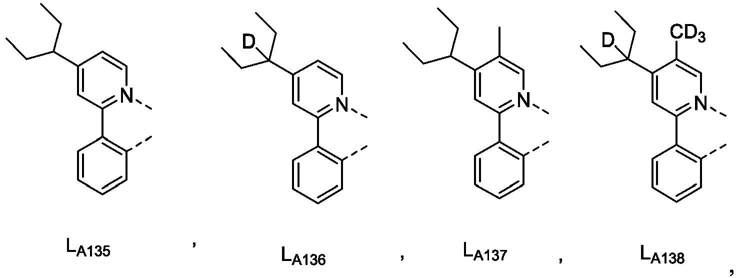

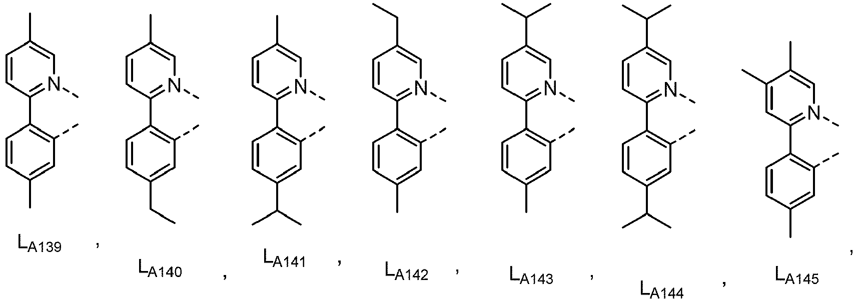

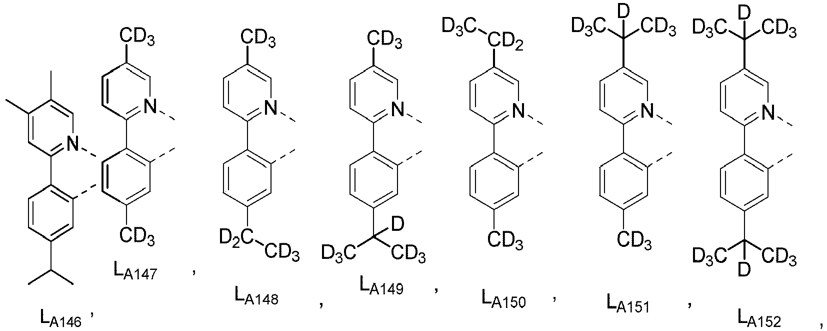

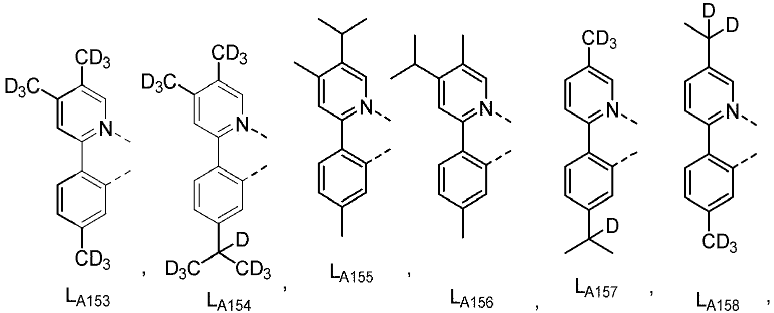

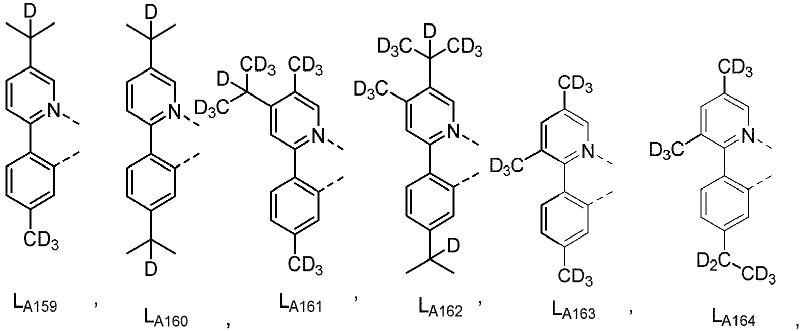

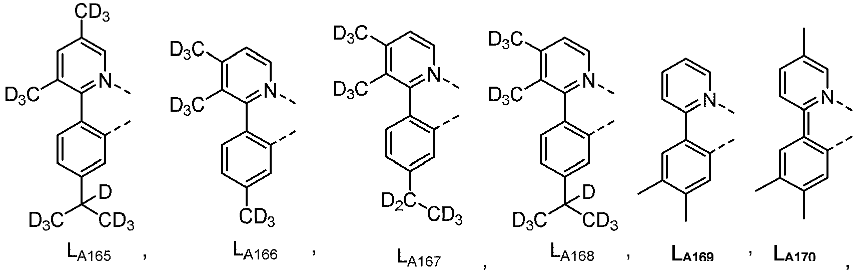

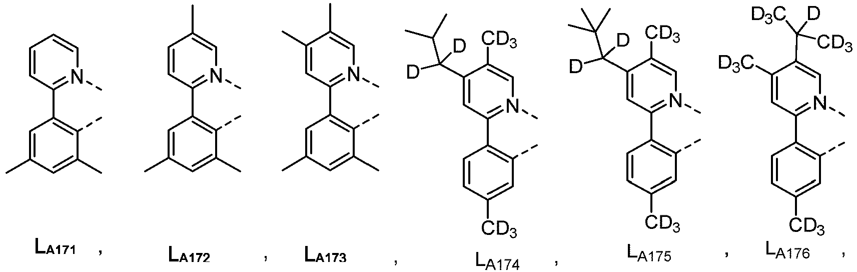

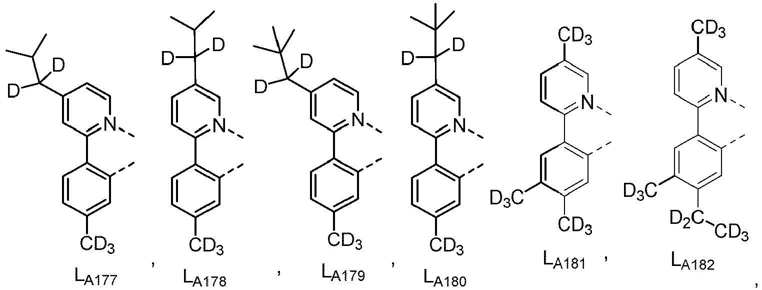

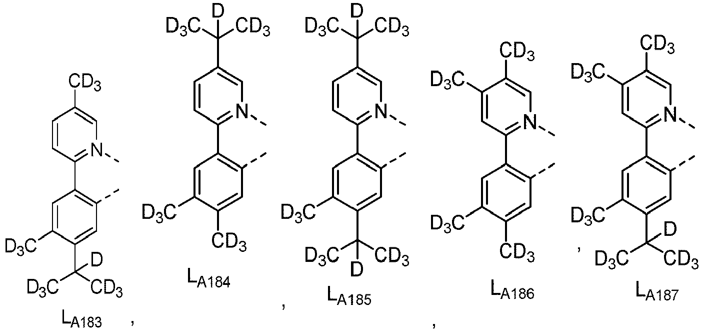

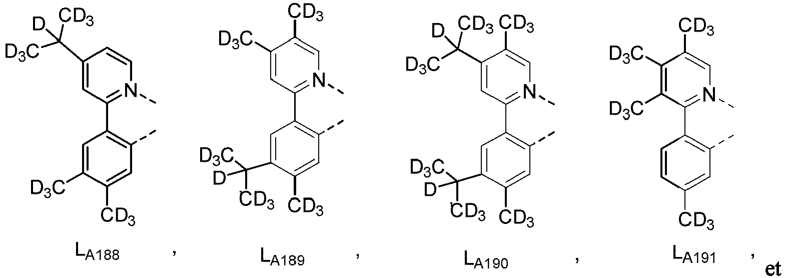

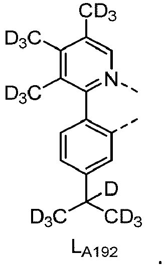

3. Composé selon la revendication 1 ou 2, où L_{B} est choisi dans le groupe constitué par : 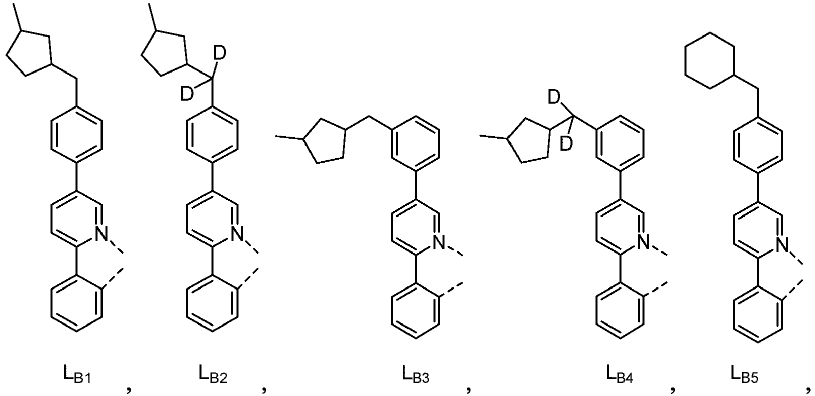 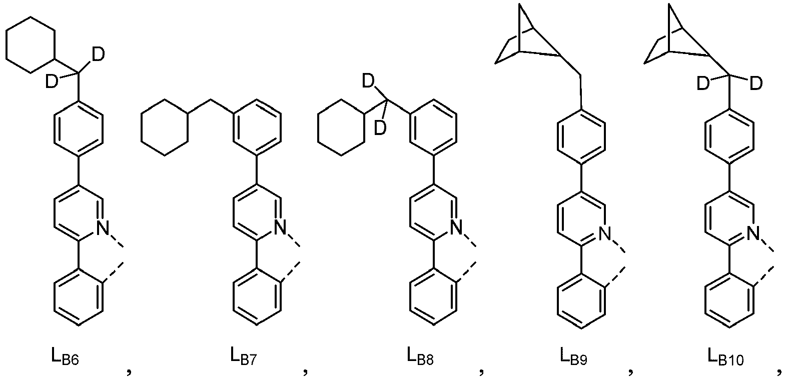 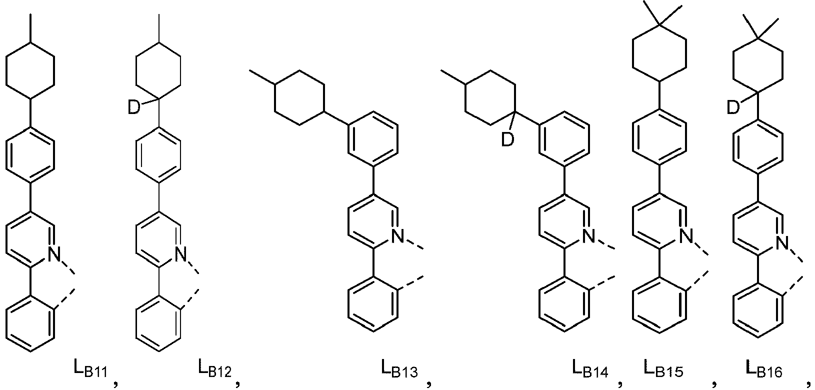 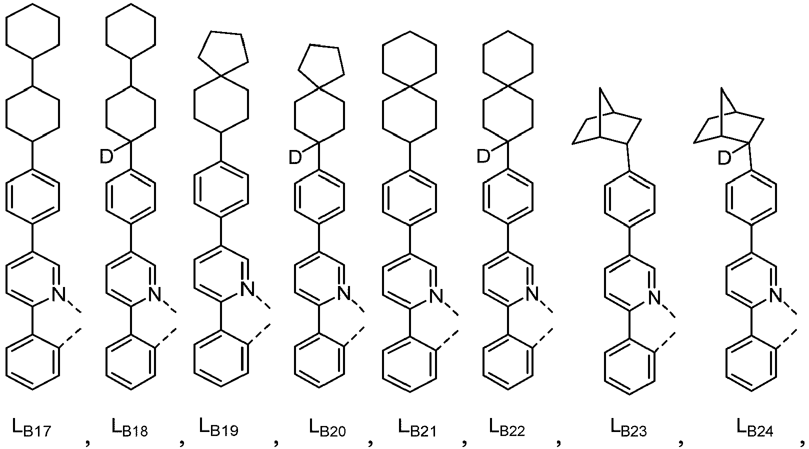 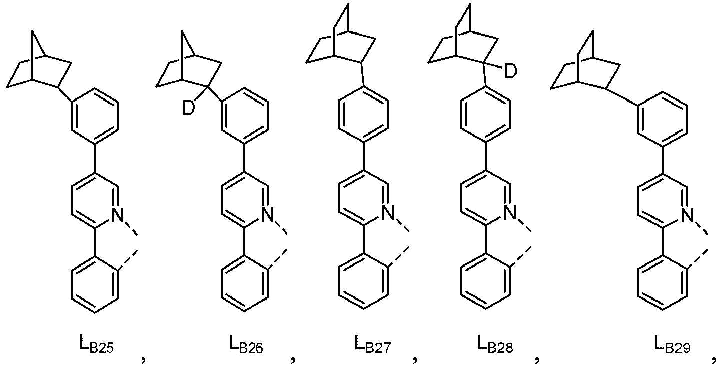 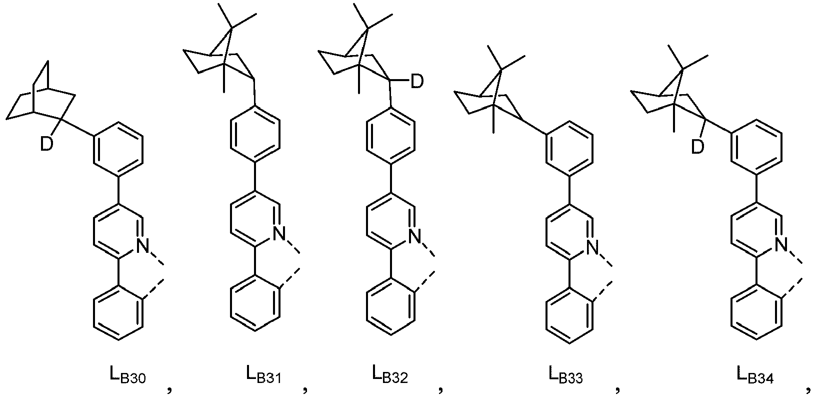 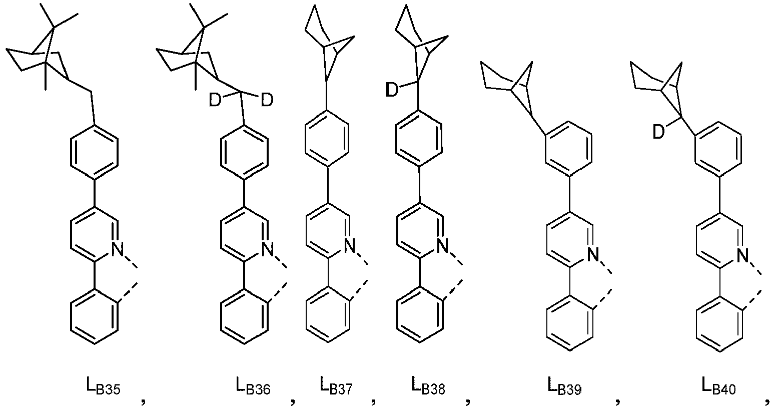 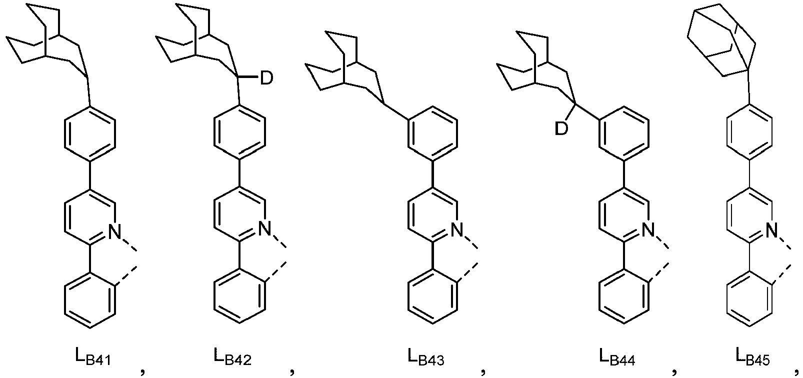 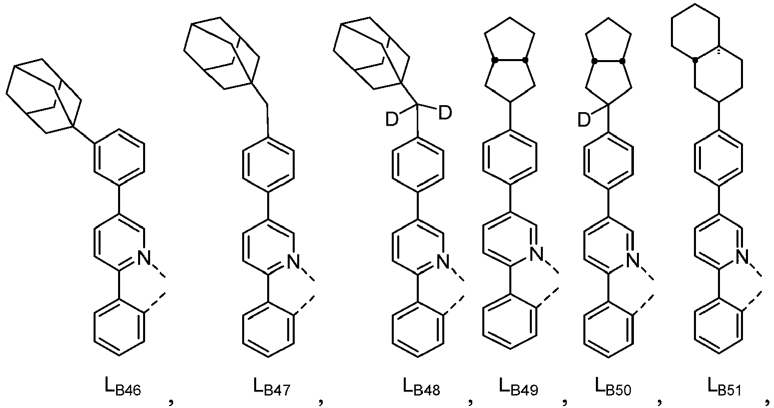 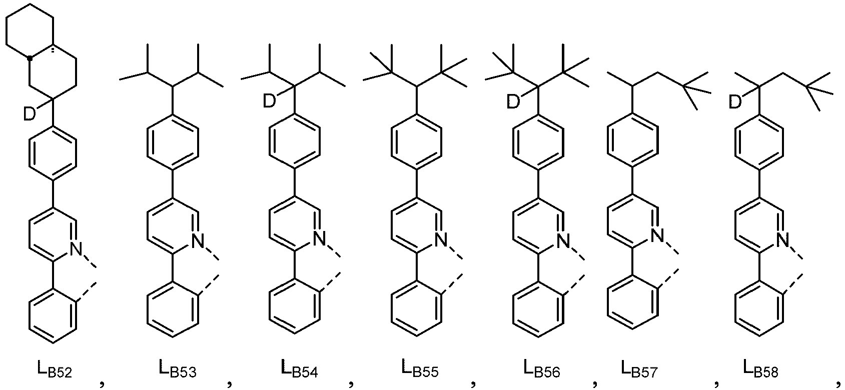 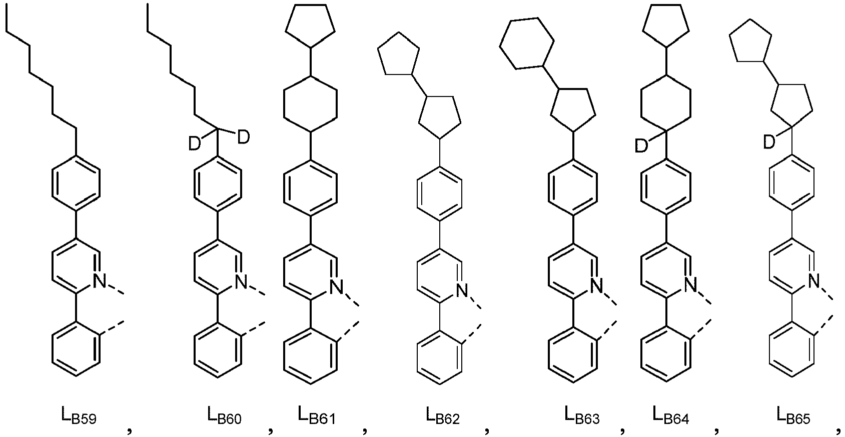 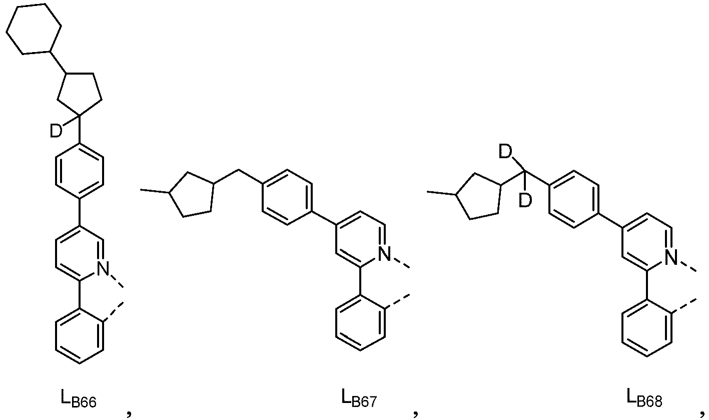 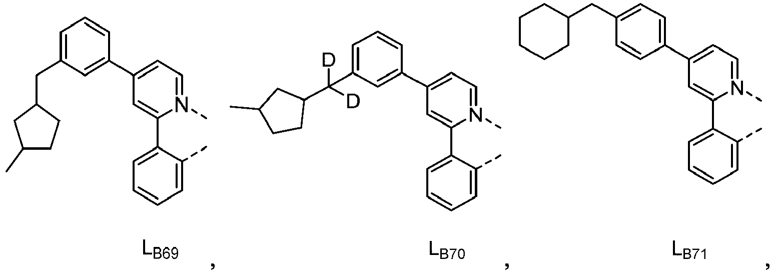 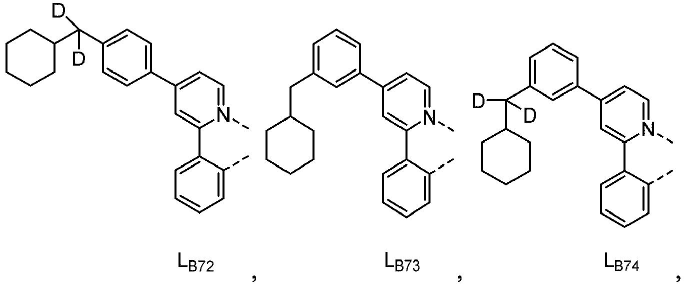 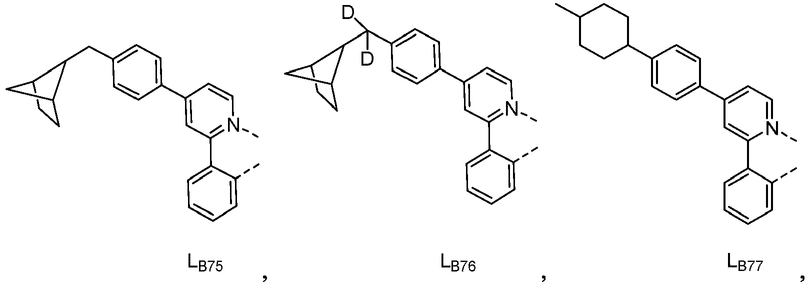 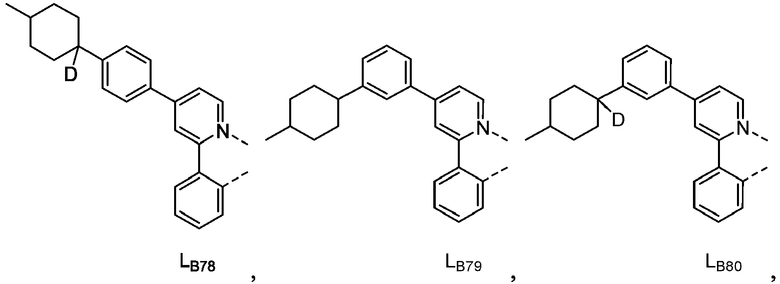 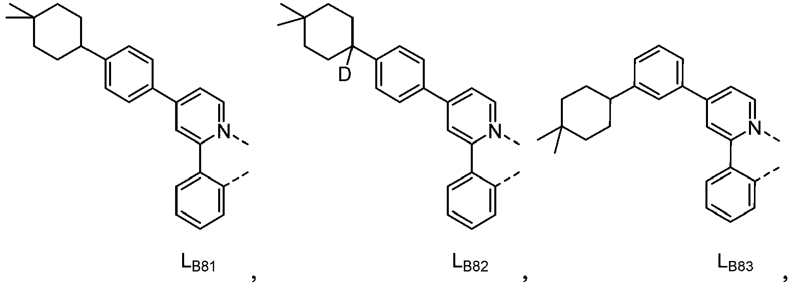 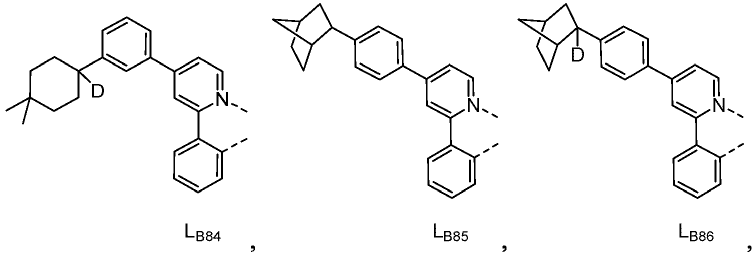 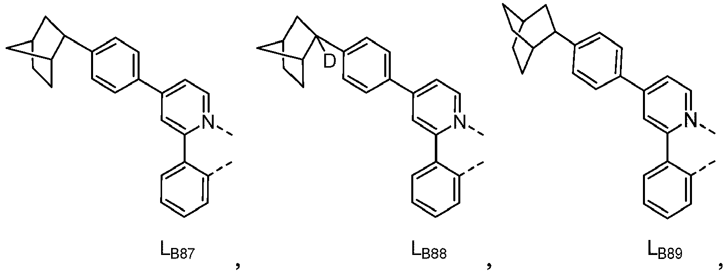 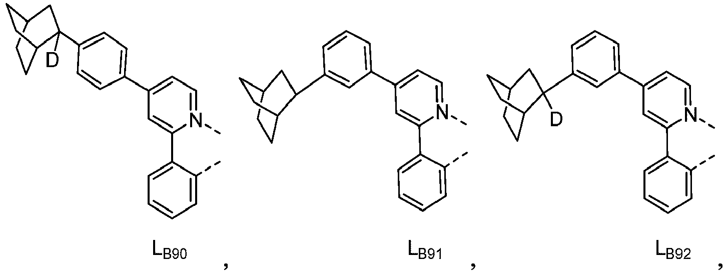 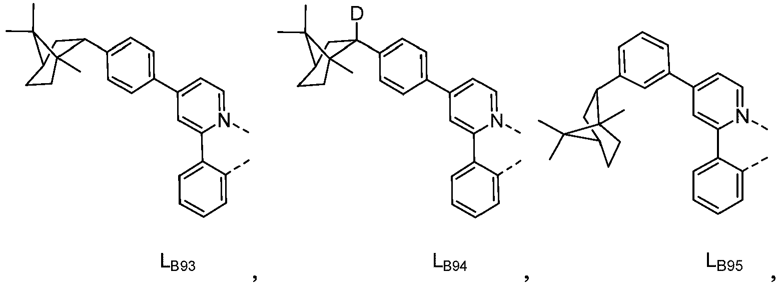 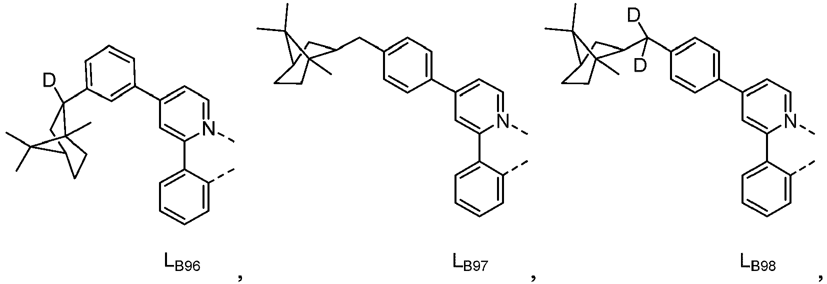 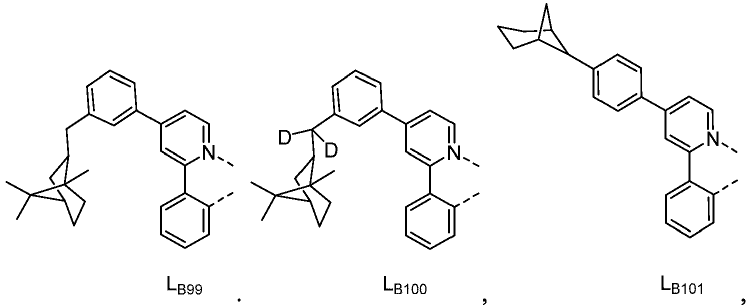 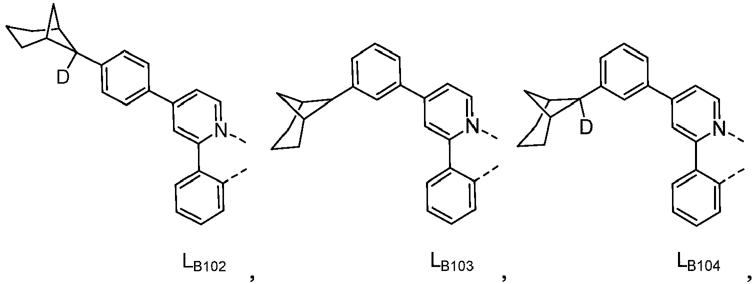 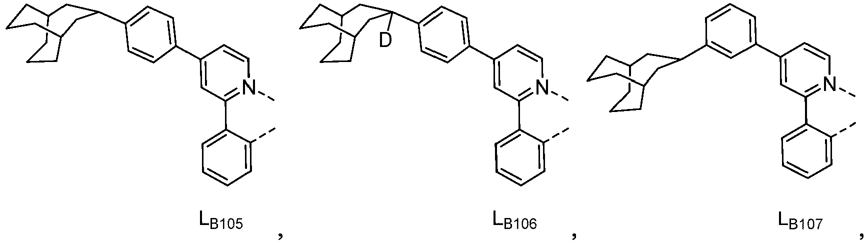 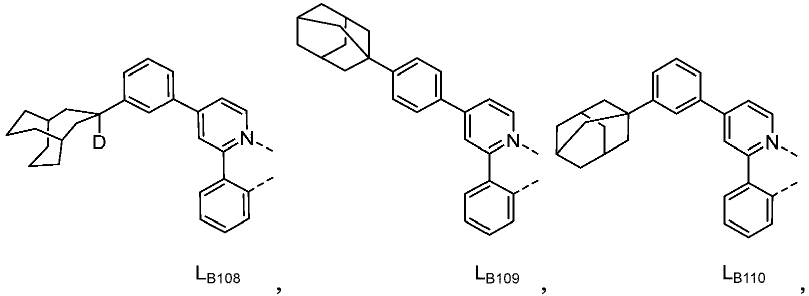 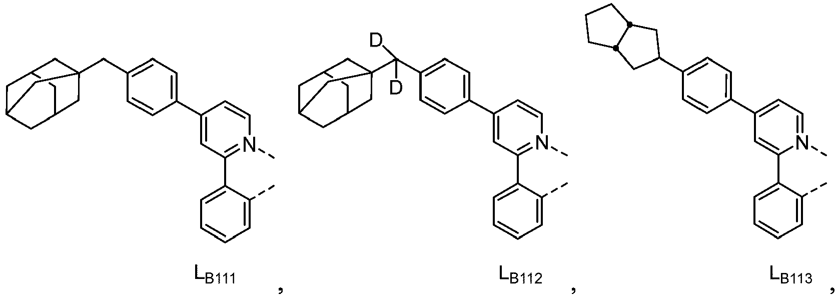 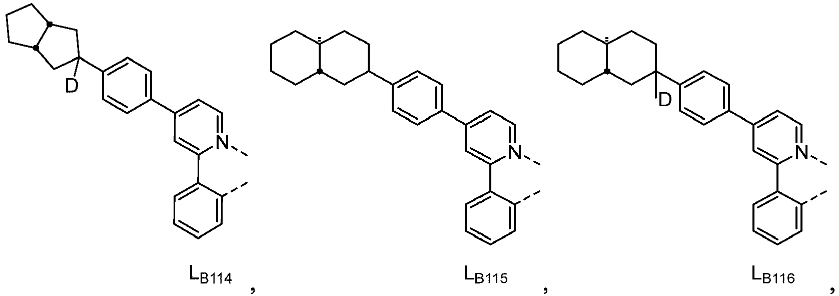 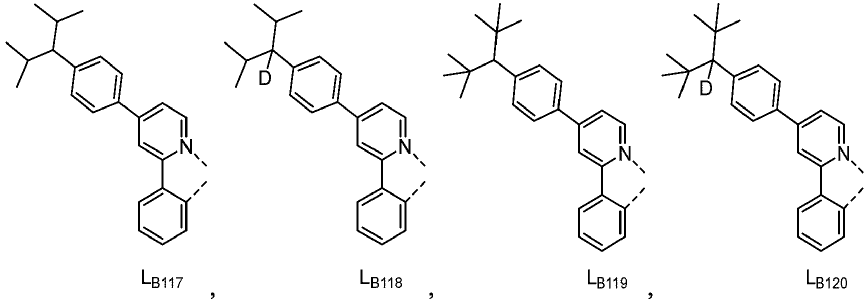 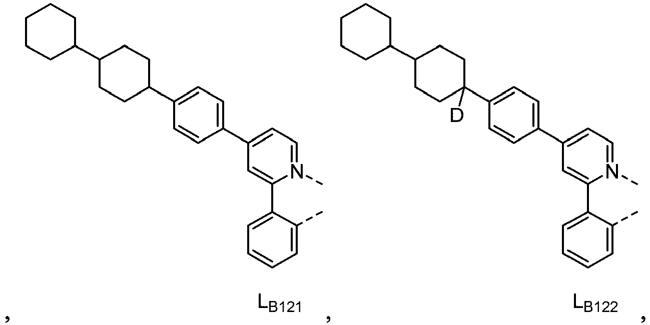 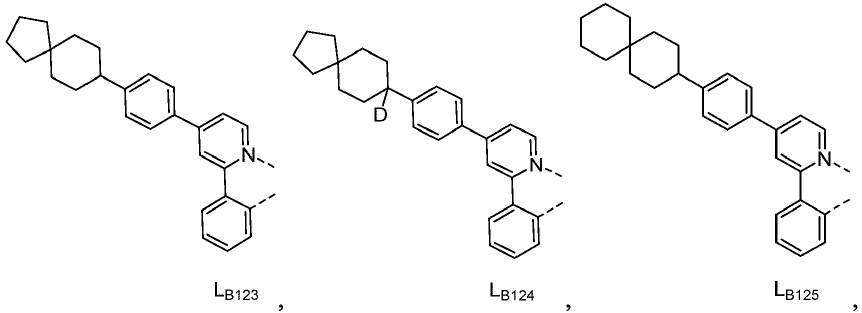 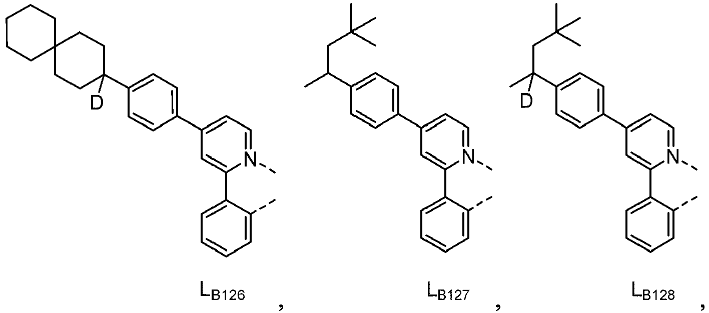 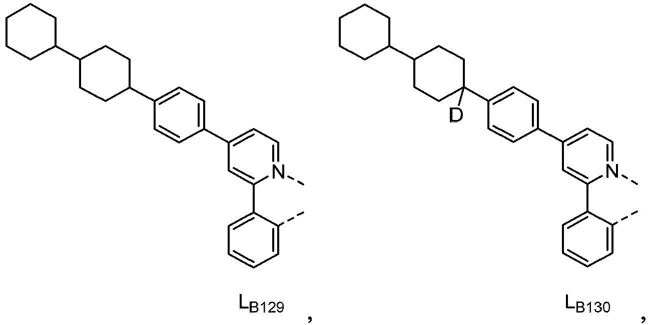 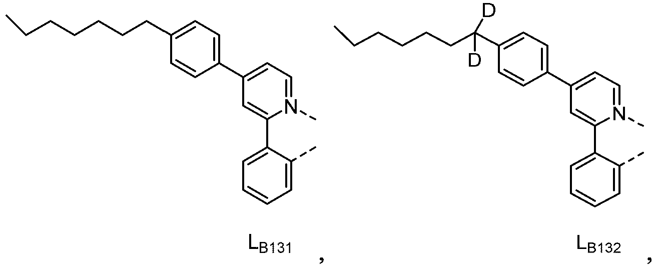 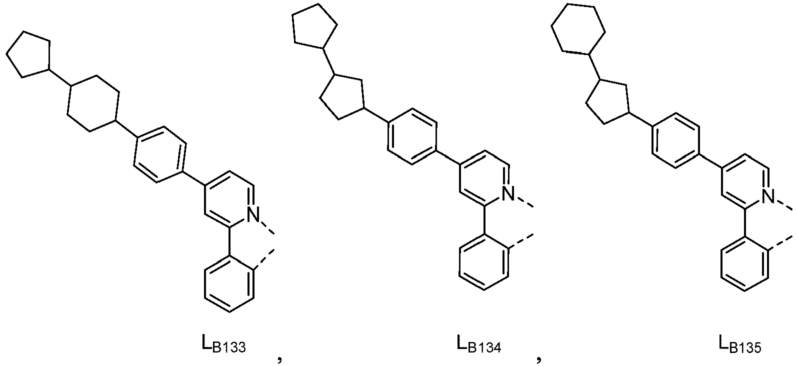 et

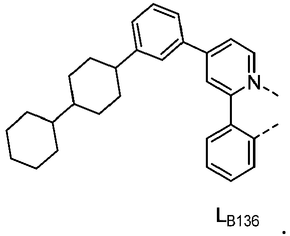

4. Dispositif électroluminescent organique (OLED) comprenant :
une anode ; une cathode ; et
une couche organique, disposée entre l'anode et la cathode, comprenant un composé ayant une formule selon l'une quelconque des revendications précédentes.
